# EUROPÄISCHE PATENTSCHRIFT

(11) **EP 3 894 928 B1**
(45) Veröffentlichungstag und Bekanntmachung des Hinweises auf die Patenterteilung: **15.10.2025**
(21) Anmeldenummer: 19831609.3
(22) Anmeldetag: 12.12.2019
(51) Int. Cl.: G02B 21/16, G02B 21/33, G02B 21/34, G02B 21/36, G03F 7/00, G03F 7/20

(54) **VORRICHTUNG UND VERFAHREN ZUR OPTISCHEN BEARBEITUNG EINES OBJEKTS**
APPARATUS AND METHOD FOR THE OPTICAL PROCESSING OF AN OBJECT
DISPOSITIF ET PROCÉDÉ POUR LE TRAITEMENT OPTIQUE D'UN OBJET

(30) Priorität: 13.12.2018 DE 102018221670
(43) Veröffentlichungstag der Anmeldung: 20.10.2021
(73) Patentinhaber: Karlsruher Institut für Technologie, 76131 Karlsruhe (DE); Vanguard Photonics GmbH, 76344 Eggenstein-Leopoldshafen (DE)
(72) Erfinder: LAUERMANN, Matthias, 76135 Karlsruhe (DE); KOOS, Christian, 74936 Siegelsbach (DE); DIETRICH, Philipp-Immanuel, 76744 Wörth (DE)
(74) Vertreter: Altmann Stößel Dick Patentanwälte PartG mbB
(86) Internationale Anmeldenummer: PCT/EP2019/084911
(87) Internationale Veröffentlichungsnummer: WO 2020/120685

(56) Entgegenhaltungen:
- EP-A1- 2 801 855
- WO-A1-2007/065711
- DE-A1- 102010 007 728
- DE-A1- 102014 101 172
- DE-A1- 102015 221 044
- US-A- 3 556 633
- US-A- 5 870 223
- US-A1- 2004 114 117
- US-A1- 2006 164 721
- US-A1- 2007 024 982
- US-A1- 2015 138 520
- US-A1- 2015 277 094
- US-B2- 7 570 343

## Beschreibung

### Gebiet der Erfindung

Die vorliegende Erfindung liegt auf dem Gebiet der optischen 3D-Lithographie und betrifft eine Vorrichtung und ein Verfahren zur optischen Bearbeitung eines Objekts. Die Vorrichtung und das Verfahren ermöglichen insbesondere eine Handhabung von Immersionsmedien und/oder Photoresisten in der dreidimensional-direktschreibenden Laserlithographie von Proben.

Bei direktschreibenden Laser-Lithographieverfahren kann durch Bewegung eines fokussierten Laserstrahls im Volumen eines flüssigen oder festen photosensitiven Materials, das als "Photoresist" bezeichnet wird, eine Struktur festgelegt werden, welche sich in einem nachfolgenden Entwicklungsschritt freilegen lässt. Um eine hohe Präzision und Auflösung zu erreichen, sollte das zur Strukturierung verwendete Licht durch eine äußere Grenzfläche derart in den Photoresist eingestrahlt werden, dass keine oder höchstens möglichst geringe Störungen des Strahlprofils des eingestrahlten Lichts auftreten. Dies erfordert im Allgemeinen eine wohldefinierte Grenzfläche mit optischer Qualität im Hinblick auf Glattheit und Ebenheit, insbesondere wenn hochaufgelöste, dreidimensionale Strukturen mittels Mehrphotonenpolymerisation erzeugt werden. Zur Belichtung können bevorzugt fokussierende Optiken, vorzugsweise linsenbasierte Objektive mit einer möglichst hohen numerischen Apertur (NA) verwendet werden, um ein sehr kleines Fokusvolumen zu erhalten. In Verbindung mit einem gepulsten Laserstrahl lassen sich in diesem Fokusvolumen kurzzeitig sehr hohe optische Intensitäten erreichen, welche in einem begrenzten Raumbereich zu Mehrphotonenabsorption und damit zur Initiierung einer Polymerisationsreaktion führen können. Zur Erhöhung der NA und damit der erreichbaren Spitzenintensitäten kommen oft sog. Immersions-Lithographieverfahren zum Einsatz, in welchen das zur Strukturierung verwendete Licht in ein einzelnes Immersionsmedium oder in eine Anordnung aus mehreren Immersionsmedien, welche jeweils einen Brechungsindex von n größer 1 aufweisen, eingestrahlt und fokussiert wird. Die hierbei verwendeten Objektive mit hoher NA haben üblicherweise einen geringen Arbeitsabstand, typischerweise höchstens 10 mm, bevorzugt höchstens 1mm, besonders bevorzugt höchstens 500 µm oder weniger.

Analog zur hochauflösenden Lithographie beruht auch die hochauflösende optische Charakterisierung von Objekten maßgeblich darauf, dass das zur Charakterisierung verwendete Licht ohne oder mit möglichst geringen Störungen durch eine wohldefinierte Grenzfläche in ein hochbrechendes, die abzubildende Struktur umgebendes Immersionsmedium eingekoppelt werden kann.

### Stand der Technik

J. Serbin et al., Fabrication of woodpile structures by two-photon polymerization and investigation of their optical properties, Optics Express 12 (21), S. 5221-5228, 2004, beschreibt eine Handhabung von Immersionsflüssigkeiten und Photoresisten in der 3D-direktschreibenden Laserlithographie unter Verwendung eines dünnen Deckglases. Hierbei wird der Photoresist zunächst auf ein das Objekt umfassende Substrat aufgebracht und mit dem Deckglas abgedeckt, welches unbeweglich in Bezug zum Substrat ist und in direktem Kontakt mit dem Photoresist steht. Danach wird das zur Lithographie und/der Bildgebung verwendete Objektiv mit hoher NA nah an die Oberseite des Deckglases herangebracht und der Spalt zwischen dem Deckglas und Objektiv mit brechungsindexangepasstem lmmersionsöl aufgefüllt. Nachteilig hieran ist, dass sich damit nicht beliebig hohe Strukturen schreiben lassen, da der Arbeitsabstand des Objektivs sowie die Dicke des Deckglases eine maximale Höhe der Strukturen vorgeben. Bei Objektiven mit hoher NA ist der Arbeitsabstand verhältnismäßig gering und bewegt sich oft in der Größenordnung von wenigen hundert Mikrometern. Gleichzeitig weisen die verwendeten Deckgläser eine Dicke von 100-200 µm auf, um eine für eine wohldefinierte Grenzfläche hoher optischer Qualität hinreichende Steifigkeit zu erreichen. Hierdurch werden mögliche Strukturhöhen auf wenige hundert Mikrometer begrenzt. Weiterhin kann es durch die festen Abstände zwischen dem Objekt und dem Deckglas zu geometrischen Aberrationen kommen, wenn nicht gleichmäßig in einer bestimmten Tiefe geschrieben wird, für die das Objektiv und die verwendete Immersionsflüssigkeit oder der Photoresist ausgelegt sind.

K. Obata et al., High-aspect 3D two-photon polymerization structuring with widened objective working range (WOW-2PP), Light: Science & Applications 2, Seite e116, 2013, beschreibt eine Anordnung, in welcher das Deckglas nicht am Objekt, sondern direkt am Objektiv befestigt wird. Dadurch kann das Objektiv zusammen mit dem Deckglas frei in Bezug auf das Objekt bewegt werden. Der Abstand zwischen dem Objektiv und dem Deckglas kann hierbei so eingerichtet werden, dass der Fokus des Lichtstrahls im Volumen des Photoresists direkt unterhalb des Deckglases liegt. Zwischen dem Deckglas und dem Objektiv kann weiterhin ein brechungsindexangepasstes lmmersionsöl eingebracht sein. Damit lassen sich Strukturen beliebiger Höhe schreiben. Nachteilig hieran ist jedoch, dass es bei einer Positionierung des Objektivs zu einer Bewegung des am Objektiv befestigten Deckglases relativ zu Objekt kommt. Dadurch können im Photoresist Kräfte erzeugt werden, die zu auf das Objektiv und/oder das Substrat wirkenden Gegenkräften führen und/oder zu einer Relativbewegung zwischen dem Substrat und an das Substrat angrenzenden Schichten des Immersionsmediums. Dies kann eine genaue Positionierung von Substrat und Objektiv zueinander erschweren und zusätzlich durch eine Einbringung von Scherkräften in den Photoresist zu Beschädigungen von bereits auf dem Substrat vorhandenen Strukturen führen, insbesondere dann, wenn diese Strukturen besonders klein sind und/oder hohe Aspektverhältnisse aufweisen. Ferner ist ein automatisches Wechseln des Objektivs während des Betriebs der Vorrichtung nur schwer durchzuführen: Da das Deckglas direkt am Objektiv befestigt ist, tritt bei einem Objektivwechsel unvermeidlich ein Abreißen eines physikalischen Kontaktes zwischen dem Deckglas und dem objektseitig anschließenden Photoresist auf. Auch hierdurch können Kräfte im Photoresist erzeugt werden, die zu einer Beschädigung bereits gefertigter optischer Strukturen führen kann oder es kann zu Problemen bei einer erneuten Bereitstellung eines optischen Kontaktes des Photoresists mit einem neu eingebrachten Objektiv kommen. Ein weiterer Nachteil besteht darin, dass dieses Vorgehen zur lithographischen Strukturierung von Objekten mit hoher Oberflächentopographie nicht geeignet ist: Der Abstand zwischen dem Objektiv und dem Deckglas wird so eingerichtet, dass der Fokuspunkt des Lichtstrahls im Volumen des Photoresists unmittelbar unterhalb des Deckglases liegt. Bei Objekten mit starker Oberflächentopographie kann es dabei während des Schreibvorganges zu einer Kollision des am Objektiv befestigten Deckglases mit Teilen des Objekts und damit zu einer Zerstörung von Teilbereichen des Objekts kommen. Darüber hinaus kann ein Zerfließen des Photoresists auftreten, wenn das Objektiv mit dem zugehörigen Deckglas zu weit vom Objekt wegbewegt wird. Ein weiterer Nachteil besteht darin, dass bei einem Wechsel des am Objektiv befestigten Deckglases Kräfte auf das Objektiv ausgeübt werden können, die eine Dejustage des optischen Systems bewirken können. Ein solcher Wechsel des Deckglases kann z.B. notwendig werden, um eine Kreuzkontamination bei nacheinander belichteten Substraten zu vermeiden.

US 2016/0299426 A1 beschreibt eine Vorrichtung, die zusätzlich ein transparentes Element umfasst, welches am Objektiv befestigt ist und welches dazu eingerichtet ist, das Objektiv vor Verschmutzung zu schützen. Diese Vorrichtung ist im Wesentlichen denselben Einschränkungen unterworfen wie der von K. Obata et al., s.o., beschriebene Ansatz. Darüber hinaus kann auch hier das verwendete Volumen an Photoresist nicht an die zu schreibende Struktur angepasst werden, da das transparente Element fest am Objektiv angebracht ist und immer den gesamten Raum zwischen dem axial beweglichen Objektiv und dem Objekt ausfüllen muss. Ferner ist eine präzise Anpassung des Brechungsindex des Photoresists an das verwendete Objektiv erforderlich, da keine weiteren Freiheitsgrade zur Kompensation monochromatischer Aberrationen vorgesehen sind. Dies schränkt das Spektrum verwendbarer Photoresists stark ein und führt zu Nachteilen bei der Umsetzung stabiler Lithographieverfahren in einem industriellen Umfeld, beispielsweise infolge einer Temperaturabhängigkeit oder Alterung des Photoresists oder aufgrund von Schwankungen der Zusammensetzung der zur Herstellung des Photoresists verwendeten Ausgangsmaterialien.

WO 2011/141521 A1 und US 2012/0218535 A1 beschreiben jeweils eine Vorrichtung und ein Verfahren zur 3D-Lithographie mittels Zweiphotonen-Polymerisation, in welcher das Objektiv direkt in den Photoresist eingetaucht wird; auf ein Deckglas oder ein anderes, zwischen dem Objektiv und dem Objekt befindliches Element wird hierbei verzichtet. Damit lassen sich ebenfalls Strukturen beliebiger Höhe erzeugen. Allerdings können auch hier bei einer Bewegung des Objektivs relativ zum Objekt Kräfte auf das Objektiv ausgeübt oder in den Photoresist eingebracht werden, die mit vorstehend beschriebenen Nachteile einhergehen. Ferner führt auch bei diesem Ansatz ein Wechseln des Objektivs während des Betriebs der Vorrichtung unvermeidlich zum Abreißen des physikalischen Kontaktes zwischen dem Objektiv und dem objektseitig anschließenden Photoresist. Darüber hinaus ist es auch hier nicht möglich, die Menge an Photoresist an die zu schreibende Struktur anzupassen, da immer das gesamte Volumen zwischen dem Objektiv und dem Objekt mit dem als homogenes Immersionsmedium dienenden Photoresist ausgefüllt werden muss. Weiterhin besteht auch hier die Gefahr, dass das Objektiv durch den Kontakt mit dem als Immersionsmedium dienenden und in direktem Kontakt mit dem Objekt stehenden Photoresist verschmutzt wird oder dass es zu einer Kreuzkontamination von Objekten über am Objektiv anhaftende Reste an Photoresist kommen kann. Ferner ist das Objektiv selbst der Einwirkung des Photoresists ausgesetzt, was bei entsprechenden Zusammensetzungen des Photoresists auf Dauer zu Beschädigungen beispielsweise an Dichtungen oder Verkittungen des Objektivs führen kann. Darüber hinaus hier kann eine ungewollte Polymerisation des flüssigen Photoresists auf dem Austrittsfenster des Objektivs eintreten, beispielsweise infolge von kurzwelligem Licht, das gewollt oder ungewollt in das Objektiv eingestrahlt wird, wodurch das Objektiv beschädigt oder zerstört werden kann. Diese Aspekte sind insbesondere nachteilig für einen industriellen Prozess, da eine regelmäßige Reinigung des Objektivs einen großen Zeitverlust in der Produktion bedeutet. Ein weiterer Nachteil besteht darin, dass auch hier der Brechungsindex exakt auf das Objektiv angepasst werden muss. Darüber ist erlauben aus diese Konzepte nicht, ein mit einem Photoresist bedecktes Objekt zu verschiedenen funktionalen Einheiten zu transferieren und dabei den Photoresist vor Verschmutzung, ungewollter Bestrahlung mit kurzwelligem Licht oder Kontakt mit Sauerstoff oder Luftfeuchtigkeit zu schützen.

US 2005/0158673 A1 offenbart eine Vorrichtung für die 2D-Immersionslithographie, in welcher die Immersionsflüssigkeit in einem aus einer dünnen Membran gebildeten Ballon gekapselt ist. Der mit Immersionsflüssigkeit gefüllte Ballon wird zwischen dem Objektiv und dem Objekt derart positioniert, dass er sowohl das Objektiv als auch das Objekt berührt. Hierdurch kann ein Immersionsobjektiv für die hochaufgelöste 2D-Lithographie benutzt und vor Verschmutzung geschützt werden. Das hier vorgeschlagene Verfahren ist ferner auf feste Photoresists beschränkt, da flüssige Photoresists durch den Druck des flüssigkeitsgefüllten Ballons vom Objekt verdrängt würden. Bei festen Photoresisten ist die Anwendung ferner auf Fälle beschränkt, in denen der Photoresist eine sehr ebene Oberfläche optischer Güte aufweist.

US 7570343 B2 offenbart eine Vorrichtung und ein Verfahren zur Projektionslithographie, mit welcher 2D-Strukturen auf im wesentlichen planaren Objekten erzeugt werden, die typischerweise maximale Unebenheiten in der Größenordnung einer oder weniger Lichtwellenlängen der Lithographie-Strahlung aufweisen. Hierin wird vorgeschlagen, ein für das Projektionslicht durchlässiges Abschlusselement im objektseitigen Lichtpfad des Systems einzufügen, wobei sich das Abschlusselement auch zur Trennung zweier Immersionsflüssigkeiten einsetzen lässt. Bei dem Abschlusselement kann es sich entweder um eine feste Platte mit makroskopischer Dicke handeln oder um eine dünne Membran. Hierbei kann die Position des Abschlusselements zwischen dem Objekt und dem Objektiv durch entsprechende Justage-Elemente beim Einrichten des Systems eingestellt werden. Als Justage-Elemente werden Mikrometerschrauben vorgeschlagen, die in einem Zwischenraum zwischen einer Endfläche des Objektivs und dem Objekt angeordnet sind. Alternativ kann die Position der Membran über den hydrostatischen Druck der angrenzenden Immersionsflüssigkeiten bewegt werden. Das Abschlusselement kann durch eine geeignete geometrische Formgebung ferner dazu dienen, Aberrationen der Lithographie-Einrichtung zu korrigieren. Im Falle einer flexiblen Membran kann die geometrische Formgebung auch durch eine Variation des hydrostatischen Drucks der auf beiden Seiten angrenzenden Immersionsflüssigkeiten erreicht werden.

Die Position des Abschlusselements zwischen dem Objektiv und dem Objekt wird einmalig bei der Einrichtung der Lithographie-Einrichtung, beispielsweise manuell mittels Mikrometerschrauben, eingestellt; eine Änderung dieser Position während des Schreibvorgangs ist nicht erwünscht. Darüber hinaus bezieht sich die Patentschrift US 7570343 B2 ausschließlich auf den Anwendungsfall der Projektionslithographie auf ebenen Substraten, bei der während des Belichtungsvorganges keine axiale Relativbewegung des Objektivs bezüglich des Objektes erforderlich ist. Dadurch können große Objektive mit großem Arbeitsabstand und dennoch hoher NA eingesetzt werden, die ein hohes Gewicht aufweisen. Weiterhin kann die Lithographie-Einrichtung mit einem kleinen Sicherheitsabstand zwischen dem Abschlusselement und dem Objekt betrieben werden. Durch den großen Arbeitsabstand des Objektivs und den kleinen Sicherheitsabstand wird es möglich, verhältnismäßig große optische oder mechanische Baugruppen in den Raumbereich zwischen der Endfläche des Objektivs und dem Objekt einzubringen, die den nutzbaren Arbeitsabstand der Anordnung auf einen Bruchteil des Arbeitsabstandes des Objektivs reduzieren. So sind die von hierin vorgeschlagenen Abschlusselemente teilweise als massive Platten makroskopischer Dicke ausgelegt, die selbst einen Großteil des Bauraumes zwischen der Endfläche des Objektivs und dem Objekt ausfüllen, oder aber sie weisen mechanische Positionierelemente auf, die ebenfalls zwischen die Endfläche des Objektivs und das Objekt eingebracht sind. Als alternative Möglichkeit zur Positionierung eines als dünne Membran ausgelegten transparenten Abschlusselements wird eine Variation des hydrostatischen Drucks der Immersionsflüssigkeit auf mindestens einer Seit der Membran beschrieben. Allerdings verändert sich bei einer flexiblen Membran durch eine Druckänderung nicht nur ihr Position, sondern auch ihre Krümmung, d.h. Position und Brechkraft der Membran lassen sich durch eine Variation des Drucks nicht unabhängig voneinander einstellen. Ferner erfordert die Einstellung des Drucks ein größeres Volumen an Immersionsflüssigkeit, was im Falle eines als Immersionsflüssigkeit dienenden Photoresists nachteilig in Bezug auf eine Minimierung des Volumens an Photoresist ist. Ferner benötigt eine Einstellung der Position durch hydrostatischen Druck mindestens einen hermetisch abgedichteten Bereich, der entweder einen Teil des Objektivs, das komplette Objektiv oder die Probe umfasst, was in vielen Anwendungssituationen nicht praktikabel ist.

WO 2004/077123 A2 offenbart ein mikroskopisches System, umfassend eine Mehrzahl an austauschbaren Objektivlinsen; ein Wechselelement für die Objektivlinsen zum Halten jeder Objektivlinse, wobei das Wechselelement dazu eingerichtet ist, eine ausgewählte Objektivlinse in eine optische Achse des mikroskopischen Systems zu platzieren, wobei jede Objektivlinse durch das Wechselelement derart gehalten wird, dass jede Objektivlinse koaxial gegenüber der optischen Achse und in Bezug auf das Wechselsystem beweglich ist; und ein Aktuator-Element zum Bewegen der ausgewählten Objektivlinse koaxial gegenüber der optischen Achse und in Bezug auf das Wechselsystem, um die ausgewählte Objektivlinse in Bezug auf eine Probe zu fokussieren.

US 2007/0024982 A1 offenbart ein Abbildungssystem einer mikrolithographischen Projektionsbelichtungseinrichtung zur Erzielung von Verbesserungen in der Projektion von äußeren optischen Oberflächen gegenüber Kontamination. In einem Abbildungssystem, das ein Projektionsobjektiv aufweist, das dazu eingerichtet ist, ein Abbild einer Maske zu projizieren, die in eine Position in einer Objektebene auf eine lichtsensitive Beschichtung platziert werden kann, welche in eine Position in einer Bildebene platziert werden kann, ist eine Membran, die im Wesentlichen transparent für eine Betriebswellenlänge des Projektionsobjektivs ist, derart in Bezug auf die äußere optische Oberfläche des Projektionsobjektivs angeordnet, dass zwischen der optischen Oberfläche und der Membran ein Zwischenraum ausgebildet ist, der zur Aufnahme eines flüssigen oder gasförmigen Mediums eingerichtet ist. T. Bückmann, N. Stenger, M. Kadic, J. Kaschke, A. Frölich, T. Kennerknecht, C. Eberl, M. Thiel und M. Wegener, Tailored 3D Mechanical Metamaterials Made by Dip-in Direct-Laser-Writing Optical Lithography, Adv. Mater. 24, S. 2710-14, 2012, beschreiben die Herstellung von dreidimensionalen Metamaterialien unter Einsatz von direktem Laserschreiben.

### Aufgabe der Erfindung

Ausgehend hiervon, besteht die Aufgabe der vorliegenden Erfindung darin, eine Vorrichtung und ein Verfahren zur optischen Bearbeitung eines Objekts bereitzustellen, welche die Nachteile und Einschränkungen des Standes der Technik zumindest teilweise überwinden.

Die Vorrichtung und das Verfahren sollen insbesondere eine Handhabung von Immersionsmedien und/oder Photoresisten in der 3D-direktschreibenden Laserlithographie ermöglichen, welche insbesondere den Anforderungen industrieller Anwendungen im Bereich durchsatzstarker Lithographieverfahren gerecht wird. Hierbei tritt häufig das Problem auf, dass das zur Lithographie oder zur Bildgebung verwendete Immersionsmedium in physikalischem Kontakt mit dem Objektiv und dem Substrat steht. Dazu wird oftmals ein flüssiges Immersionsmedium verwendet, das auf das Substrat aufgebracht wird und das gleichzeitig in direktem Kontakt mit einem Austrittsfenster des Objektivs steht. Der Begriff "Substrat" beschreibt im Folgenden einen oder mehrere miteinander verbundene Festkörper, auf denen eine Zielstruktur lithographisch erzeugt und/oder eine vorhandene Struktur optisch charakterisiert werden soll. Er wird im nachfolgenden Text synonym zum Begriff "Objekt" gebraucht. Unter einem "Austrittsfenster" wird im Folgenden ein in das Objektiv integrierte oder ein durch direkten physikalischen Kontakt mit diesem verbundenes optisch transparentes Fenster bezeichnet, durch das Licht in ein an das Objektiv angrenzendes Immersionsmedium eintritt bzw. aus diesem empfangen wird. Bei einem Austrittsfenster kann es sich insbesondere auch um die Abschlusslinse des Objektivs oder um eine diese Abschlusslinse schützende Glasplatte, Beschichtung oder Folie handeln. Während in Laboranwendungen die Verwendung eines durchgängigen flüssigen Immersionsmediums zwischen dem Austrittsfenster und dem Substrat ein einfaches und zuverlässiges Vorgehen zur Erzielung hoher optischer Auflösungen darstellt, ist sie insbesondere aus folgenden Gründen für den Einsatz in industriellen optischen Charakterisierungs- oder 3D-Lithographie-verfahren weniger geeignet und geht mit verschiedenen Einschränkungen bei der praktischen Handhabung einher. Diese Einschränkungen des vorstehend beschriebenen Standes der Technik betrifft insbesondere die folgenden Punkte:
- Übertragung von Kontaminationen zwischen Objektiv und Substrat: Bei durchsatzstarken Charakterisierungs- oder 3D-Lithographieverfahren werden mittels eines einzelnen Objektivs innerhalb kurzer Zeit eine Vielzahl von Substraten verarbeitet, die jeweils in direktem physikalischen Kontakt mit dem Immersionsmedium des Objektivs kommen. Eine Reinigung des Objektivs durch vollständiges Entfernen von am Objektiv anhaftenden Resten des Immersionsmediums ist zwischen dem Wechsel der Substrate nicht möglich oder nicht praktikabel. Hierdurch kann es zu Kreuzkontaminationen, d.h. zur Übertragung von Verunreinigungen von einem Substrat auf ein oder mehrere andere Substrate kommen.
- Beschädigung des Objektivs: Bei 3D-direktschreibenden Laserlithographie-Verfahren kann der Photoresist gleichzeitig als lmmersionsmedium dienen, das in direktem physikalischen Kontakt mit dem Austrittsfenster des Objektivs steht. Hierbei besteht die Gefahr, dass es zu einer ungewollten Polymerisation des flüssigen Photoresists auf dem Austrittsfenster des Objektivs kommt, vor allem infolge von kurzwelligem Licht, das gewollt oder ungewollt in das Objektiv eingestrahlt wird. Dies kann eine Zerstörung des Objektivs zur Folge haben. Weiterhin besteht die Gefahr, dass der Photoresist Bestandteile des Objektivs, wie z.B. Dichtungen oder Verkittungen, chemisch angreift und zerstört bzw. altern lässt. Dieselbe Gefahr besteht bei Photoresists, die sich nur durch aggressive Lösungsmittel vom Objektiv entfernen lassen, welche sich schädlich auf Teile des Objektivs auswirken.
- Verwendung von Objektiven, die einen geringen Arbeitsabstand aufweisen: Bei der 3D-direktschreibenden Laserlithographie kommen oft Objektive zum Einsatz, die einen sehr geringen Arbeitsabstand von wenigen hundert Mikrometern aufweisen. Ein derart geringer Arbeitsabstand hat den Vorteil, dass das Objektiv auch bei hoher NA kompakt mit kleinem Durchmesser und geringen Gewicht ausgestaltet werden kann und damit eine schnelle Bewegung des Objektivs während des Schreibvorganges ermöglicht. Durch Objektive mit geringem Arbeitsabstand wird jedoch der zwischen Objektiv und Substrat verfügbare Bauraum stark eingeschränkt. Vorrichtungen und Verfahren zur Handhabung von Immersionsmedien und/oder Photoresisten in der 3D-Lithographie und Bildgebung sollten daher so ausgelegt sein, dass sie den nutzbaren Arbeitsabstand des Objektivs, d.h. einen Abstand zwischen der Fokusebene des Objektivs und dem der Fokusebene in Richtung des Objektivs am nächsten liegenden optischen oder mechanischen Bauelement, möglichst wenig einschränken.
- Lithographische Herstellung von hohen Strukturen mit Objektiven mit geringem Arbeitsabstand: Zur lithographischen Herstellung funktionaler Bauteile ist es oftmals vorteilhaft, Strukturen erzeugen zu können, deren Höhe den Arbeitsabstand des Objektivs übersteigt.
- Einbringen von Kräften in das Immersionsmedium und/oder das Objektiv: Bei durchsatzstarken Charakterisierungs- oder 3D-Lithographieverfahren wird das Objektiv oftmals lateral oder axial relativ zum Substrat bewegt. Hierbei dient eine axiale Relativbewegung meist dazu, die Fokusebene einzustellen und damit insbesondere verschiedene Tiefen einer zu erzeugenden oder zu charakterisierenden 3D-Struktur zu adressieren. Eine laterale Bewegung kann insbesondere dazu dienen, um Strukturen zu erzeugen oder zu erfassen, deren laterale Abmessungen das Sichtfeld oder das mittels eines Strahlscanners adressierbare Schreibfeld des Objektivs überschreiten. In beiden Fällen können durch eine Relativbewegung des Objektivs zum Substrat Kräfte in das Immersionsmedium eingebracht werden, die zu auf das Objektiv und/oder das Substrat wirkenden Gegenkräften führen und/oder zu einer Relativbewegung zwischen dem Substrat und an das Substrat angrenzenden Schichten des Immersionsmediums führen können. Hierbei können die auf das Objektiv und/oder das Substrat wirkende Gegenkräfte eine genaue Positionierung von Substrat und Objektiv zueinander erschweren. Darüber hinaus kann durch eine Relativbewegung zwischen dem Substrat und den an das Substrat angrenzenden Schichten des Immersionsmediums eine Beschädigung von Strukturen auf dem Substrat auftreten, insbesondere dann, wenn die Strukturen besonders klein sind und/oder hohe Aspektverhältnisse aufweisen und damit besonders anfällig bezüglich einer Bewegung des sie umgebenden Photoresists sind.
- Automatischer Objektivwechsel, Stabilität der Justage des optischen Systems und schnelle Bewegung des Objektivs: Um vor allem zur Steigerung des Durchsatzes eine schnelle Bewegung des Objektivs in axialer und/oder lateraler Richtung zu ermöglichen, ist es vorteilhaft, die Masse des Objektivs und daran befestigter Baugruppen so gering wie möglich zu halten. Damit wird es möglich, die während des Betriebs der Vorrichtung und/oder der Durchführung des Verfahrens auf das Objektiv wirkenden Kräfte zu minimieren, welche möglicherweise zu einer allmählichen oder plötzlichen Dejustage des Objektivs führen können. Darüber hinaus soll es möglich sein, das Objektiv während des Betriebes möglichst automatisch zu wechseln, beispielsweise mittels eines Objektivrevolvers, ohne dabei die Position des Substrats zu verändern oder Störungen im Immersionsmedium oder im Photoresist nahe des Substrats zu verursachen. Derartige Störungen können etwa durch ein Abreißen eines Kontaktes zwischen dem Austrittfenster des Objektivs und dem objektseitig anschließenden Immersionsmedium oder dem Photoresist verursacht werden.
- Automatisiertes Aufbringen des Immersionsmedium sowie Transfer innerhalb von Produktionsketten: In automatisierten Vorgängen kann es häufig vorteilhaft sein, das Aufbringen des Immersionsmediums, insbesondere der Immersionsflüssigkeit, auf das Substrat einerseits und die lithographische Bearbeitung oder die optische Charakterisierung des Substrats andererseits räumlich voneinander getrennt in verschiedenen Funktionseinheiten durchzuführen. Hierbei wäre es vorteilhaft, die mit dem Immersionsmedium bedeckten Substrate unter normalen Umgebungsbedingen, möglichst ohne Beeinträchtigung, insbesondere ohne Auftreten einer Verschmutzung oder unerwünschten Belichtung, zwischen zwei verschiedenen Funktionseinheiten zu transferieren, ohne dass in einem während des Transfers durchquerten Raumbereich besondere Anforderungen in Bezug auf Sauberkeit (z.B. Reinraumgüte), Belichtung (z.B. Gelblichtumgebung) und/oder Atmosphäre (z.B. sauerstoff- oder feuchtigkeitsarme Umgebung) beachtet werden müssen. Damit könnte es bei der lithographischen Strukturierung möglich sein, das Substrat nach erfolgtem lokalen Aufbringen eines als Immersionsmedium dienenden flüssigen Photoresists in einer ersten Funktionseinheit ("Dispenser") in eine zur Strukturierung dienende zweite Funktionseinheit ("Lithographie-Einheit") zu transferieren, ohne dass während des Transfers durchgehend Reinraumbedingungen einzuhalten und ohne hierbei zu gewährleisten, das es zu keiner Bestrahlung mit Tageslicht oder anderen UV-haltigen Strahlungsspektren kommt. Darüber hinaus wäre es in vielen Fällen vorteilhaft, wenn ein Kontakt des Photoresists mit bestimmten Substanzen, wie z.B. Sauerstoff oder Luftfeuchtigkeit, zumindest weitgehend vermieden werden könnte. Weiterhin wünschenswert wäre eine hohe mechanische Stabilität eines Tropfens, der vom Photoresist nach dem Aufbringen auf das Substrat gebildet wird und der bei entsprechenden Oberflächenenergien zwischen dem Substrat und dem Photoresist zu einem Zerfließen neigen kann.
- Lithographische Strukturierung mittels Trockenobjektiven: Zur Vermeidung von vorstehend beschriebenen Nachteilen könnte es sinnvoll sein, auf die Verwendung eines Immersionsobjektivs zu verzichten und stattdessen ein so genanntes "Trockenobjektiv" zu verwenden, das nicht in direktem physikalischem Kontakt mit dem Immersionsmedium steht. Dies ist immer dann möglich, wenn die für die jeweilige Anwendung erforderliche NA kleiner als 1 ist und damit auch ohne Immersionsobjektiv erreicht werden kann. In diesem Fall kann sich jedoch bei flüssigen Immersionsmedien oder Photoresisten die Herausforderung ergeben, eine wohldefinierte Grenzfläche mit optischer Qualität zu schaffen, durch welche Licht ohne unkalkulierbare Störungen in das Immersionsmedium oder den Photoresist eingekoppelt und wieder ausgekoppelt werden kann. Die Verwendung eines Glasplättchens, durch welches Licht aus dem Freiraum in ein flüssiges Medium eingestrahlt und wieder ausgekoppelt werden kann, scheidet jedoch in vielen Fällen aus, da hierdurch der objektseitig nutzbare, durch einen oftmals geringen Arbeitsabstand ohnehin beschränkte Arbeitsbereich des Objektivs weiter verringert wird. Die Schaffung einer wohldefinierten optischen Grenzfläche kann auch dann ein Problem darstellen, wenn feste Immersionsmedien oder Photoresists auf Substraten mit hohen Oberflächentopographien oder beträchtlichen Höhenvariationen zur Anwendung kommen, welche sich bei Aufbringen eines festen Photoresists auf entsprechende Höhenvariationen der Oberfläche des Photoresists übertragen. Eine störungsfreie Einkopplung eines Lichtstrahls zur hochaufgelösten lithographischen Strukturierung im Volumen eines festen Photoresists mit starker Oberflächentopographie ist mit einem Luftobjektiv nicht möglich. Ein Beispiel für ein lithographisch zu bearbeitendes Objekt mit einer starken Oberflächentopographie sind sogenannte optische "Multi-Chip-Module", d.h. mehrere, auf einem gemeinsamen Objektträger montierte Einzelchips unterschiedliche Dicke, welche beispielsweise durch direktschreibende Lithographieverfahren um optische Elemente, z.B. Mikrolinsen oder Freiformwellenleiter (sog. "photonische Wirebonds") ergänzt werden können. Wünschenswert wäre daher die Möglichkeit, Trockenobjektive auch zur Strukturierung von oder zur Bildgebung in flüssigen Photoresist oder in festen Photoresists mit sehr unebener Oberflächentopographie verwenden zu können, und dabei den objektseitig nutzbaren Arbeitsabstand des Objektives möglichst wenig einzuschränken.
- Verbrauch an Photoresist in der 3D-direktschreibenden Immersionslithographie: Bei der dreidimensional-direktschreibenden Immersionslithographie wird in vielen Fällen der Photoresist selbst als einziges Immersionsmedium verwendet. Dies kann zu einem hohen Verbrauch an Photoresist führen, da dieser in der Regel den gesamten Raumbereich zwischen Objektiv und Substrat ausfüllt, während tatsächlich nur ein Bruchteil davon zur Herstellung einer Zielstruktur benötigt wird. Dies kann insbesondere bei der Herstellung kleiner Strukturen oder bei Objektiven mit großem Arbeitsabstand nachteilig sein, da hier das auszufüllende Volumen besonders groß ist. Daher wäre es vorteilhaft, den Verbrauch an Photoresist zu minimieren und dabei eine Prozessmenge möglichst optimal einzustellen, idealerweise auch während des Betriebs der Vorrichtung und/oder der Durchführung des Verfahrens.
- Anpassung des Immersionsmediums zur Vermeidung von Aberrationen: Zur Erzielung hoher Auflösungen ist es vorteilhaft, den Brechungsindex des Immersionsmediums möglichst genau an den Brechungsindex des Objektivs anzupassen, um Aberrationen zu vermeiden oder zu minimieren. Mit dem Begriff "Aberrationen" werden im folgenden Abweichungen von der idealen optischen Abbildung bezeichnet, welche zu einer idealen fehlerfreien Bildgebung bzw. zu einem kleinstmöglichen Fokusvolumen des zur optischen Charakterisierung bzw. lithographischen Bearbeitung verwendeten Lichtstrahles führen würde. Dies beinhaltet sowohl geometrische bzw. monochromatische Aberrationen, die sich aus den geometrisch-optischen Strahlverläufen und den entlang dieser auftretenden Brechzahlen ergeben und die bereits bei monochromatischem Lithographie- bzw. Bildgebungslicht auftreten, als auch chromatische Aberrationen, die aus einer Wellenlängenabhängigkeit der Brechungsindizes der im Strahlpfad vorhandenen Materialien resultieren. Bei direktschreibenden Lithographieverfahren mit einem als Immersionsmedium dienenden Photoresist kann die Kompensation von Aberrationen eine präzise Anpassung des Brechungsindex des Photoresists erfordern, insbesondere durch spezielle, präzise eingestellte Mischungen aus verschiedenen Ausgangsstoffen. Dies geht mit einer Verengung an nutzbaren Prozessparametern und möglichen Materialien einher. Vorteilhaft wäre es, verschiedene Photoresists mit zumindest kleinen Variationen im Brechungsindex verarbeiten und dabei auftretenden Aberrationen während des Betriebs kompensieren zu können. Hierbei sollte es möglich sein, mittels einer einmal erreichten Aberrationskompensation ein möglichst großer Bereich an Tiefen zur Bildgebung oder zur lithographischen Strukturierung adressieren zu können.

### Offenbarung der Erfindung

Diese Aufgabe wird durch eine Vorrichtung und ein Verfahren zur optischen Bearbeitung eines Objekts mit den Merkmalen der unabhängigen Patentansprüche gelöst. Vorteilhafte Weiterbildungen, welche einzeln oder in beliebiger Kombination realisierbar sind, sind in den abhängigen Ansprüchen dargestellt.

Im Folgenden werden die Begriffe "haben", "aufweisen", "umfassen" oder "einschließen" oder beliebige grammatikalische Abweichungen davon in nicht-ausschließlicher Weise verwendet. Dementsprechend können sich diese Begriffe sowohl auf Situationen beziehen, in welchen, neben den durch diese Begriffe eingeführten Merkmalen, keine weiteren Merkmale vorhanden sind, oder auf Situationen, in welchen ein oder mehrere weitere Merkmale vorhanden sind. Beispielsweise kann sich der Ausdruck "A hat B", "A weist B auf", "A umfasst B" oder "A schließt B ein" sowohl auf die Situation beziehen, in welcher, abgesehen von B, kein weiteres Element in A vorhanden ist (d.h. auf eine Situation, in welcher A ausschließlich aus B besteht), als auch auf die Situation, in welcher, zusätzlich zu B, ein oder mehrere weitere Elemente in A vorhanden sind, beispielsweise Element C, Elemente C und D oder sogar weitere Elemente.

Weiterhin wird darauf hingewiesen, dass die Begriffe "mindestens ein" und "ein oder mehrere" sowie grammatikalische Abwandlungen dieser Begriffe, wenn diese in Zusammenhang mit einem oder mehreren Elementen oder Merkmalen verwendet werden und ausdrücken sollen, dass das Element oder Merkmal einfach oder mehrfach vorgesehen sein kann, in der Regel lediglich einmalig verwendet werden, beispielsweise bei der erstmaligen Einführung des Merkmals oder Elementes. Bei einer nachfolgenden erneuten Erwähnung des Merkmals oder Elementes wird der entsprechende Begriff "mindestens ein" oder "ein oder mehrere" in der Regel nicht mehr verwendet, ohne Einschränkung der Möglichkeit, dass das Merkmal oder Element einfach oder mehrfach vorgesehen sein kann.

Weiterhin werden im Folgenden die Begriffe "bevorzugt", "vorzugsweise", "insbesondere", "beispielsweise" oder ähnliche Begriffe in Verbindung mit optionalen Merkmalen verwendet, ohne dass alternative Ausführungsformen hierdurch beschränkt werden. So sind Merkmale, welche durch diese Begriffe eingeleitet werden, optionale Merkmale, und es ist nicht beabsichtigt, durch diese Merkmale den Schutzumfang der Ansprüche und insbesondere der unabhängigen Ansprüche einzuschränken. So kann die Erfindung, wie der Fachmann erkennen wird, auch unter Verwendung anderer Ausgestaltungen durchgeführt werden. In ähnlicher Weise werden Merkmale, welche durch "in einer Ausführungsform der Erfindung" oder durch "in einem Ausführungsbeispiel der Erfindung" eingeleitet werden, als optionale Merkmale verstanden, ohne dass hierdurch alternative Ausgestaltungen oder der Schutzumfang der unabhängigen Ansprüche eingeschränkt werden sollen. Weiterhin sollen durch diese einleitenden Ausdrücke sämtliche Möglichkeiten, die hierdurch eingeleiteten Merkmale mit anderen Merkmalen zu kombinieren, seien es optionale oder nicht-optionale Merkmale, unangetastet bleiben.

In einem ersten Aspekt betrifft die vorliegende Erfindung eine Vorrichtung zur optischen Bearbeitung eines Objekts. Der Begriff des "Objekts" oder des "Substrats" bezeichnet hierbei einen einzelnen Festkörper oder mindestens zwei miteinander verbundene Festkörper, wobei auf dem mindestens einen Festkörper lithographisch eine Zielstruktur erzeugt werden soll. Hierbei kann das Objekt einen einzelnen Festkörper oder eine Anordnung aus Einzelobjekten umfassen, welche auf einer gemeinsamen Trägerplatte aufgebracht und beispielsweise sogenannte "Multi-Chip-Module" ausbilden können. Das Objekt ist hierbei auf einem Objektträger aufgebracht, welcher vorzugsweise auf einem, den Objektträger tragenden Objekttisch aufgebracht sein kann. Der Begriff "Objektträger" bezeichnet hierbei eine Anordnung, welche zur Aufnahme des Objekts eingerichtet ist. Der Begriff "Objekttisch" wird hierbei als Bezeichnung für einen Positioniertisch verwendet, welcher zur Aufnahme des Objekts oder des Objektträgers eingerichtet ist, und welcher eine räumlich möglichst genaue Positionierung des Objekts und des Objektträgers im Arbeitsraum einer unten näher beschriebenen optischen Charakterisierungs- oder Bearbeitungs-Einheit erlaubt. Der Objektträger kann als eine das Objekt schützende Objekttransporteinheit ausgestaltet sein oder in eine Objekttransporteinheit integriert sein.

Der Begriff "optische Charakterisierung oder optische Bearbeitung" beschreibt im Folgenden Verfahren, welche zur dreidimensional (3D) ortsaufgelösten Manipulation von Materialeigenschaften eines Objekts oder zur dreidimensional ortsaufgelösten Erfassung von Informationen in Bezug auf ein Objekt verwendet werden. Hierbei kann eine für die Manipulation oder Erfassung relevante Auflösung in allen drei Raumrichtungen bevorzugt besser als 20 µm, besonders bevorzugt besser als 5 µm, insbesondere besser als 1 µm sein. Bei den hier eingesetzten Verfahren kann es sich vorzugsweise um sogenannte "direktschreibende Verfahren" handeln, in welchen die ortsaufgelöste Manipulation oder Erfassung des Objekts im einfachsten Fall in mindestens einem in allen Raumrichtungen lokalisierten Volumenbereich erfolgt, welcher sich mittels Scanverfahren durch den gesamten zu strukturierenden oder zu erfassenden Bereich bewegen lassen kann. Der Volumenbereich kann beispielsweise in Form mindestens eines räumlich stark lokalisierten Fokuspunkts von Lichtstrahlen mit hoher numerischer Apertur (NA) erzeugt werden, insbesondere bei Zweiphotonenlithographie, in der stark fokussierte Laserstrahlen zum Einsatz kommen, oder bei Laser-Rastermikroskopie (engl. *laser scanning microscopy,* LSM; Punktscanner). In der Zweiphotonenlithographie wird vorzugsweise ein Femtosekunden-Laser zur Erzeugung von ultrakurzen Pulsen an Laserstrahlen eingesetzt, wobei die ultrakurzen Pulse eine hohe Spitzenintensität und damit eine hohe Wahrscheinlichkeit für Zweiphotonenprozesse bewirken. Die Pulsdauer ist hierbei bevorzugt höchstens 5 ps, besonders bevorzugt höchstens 1 ps, insbesondere höchstens 250 fs. Die Wellenlänge der Laserstrahlen ist bevorzugt von 200 nm bis 2000 nm, besonders bevorzugt von 400 nm bis 1700 nm, insbesondere von 500 nm bis 1070 nm. Weitere Anwendungen können in der Manipulation oder der Erfassung des Objekts durch Erzeugung eines im Wesentlichen linienförmig (1D) oder flächig (2D) ausgedehnten Volumenbereichs liegen, innerhalb dessen durch optische Bestrahlung oder Detektion eine 1D- oder 2D-ortsaufgelöste Manipulation oder Erfassung des Objekts möglich ist und der zusätzlich durch ein geeignetes Scanverfahren in einer Raumrichtung oder in zwei Raumrichtungen durch den zu strukturierenden oder zu erfassenden dreidimensionalen Bereich bewegt wird (Linien- bzw. Flächenscanner). Beispiele hierfür sind die 3D-ortsaufgelöste Erfassung von Objekten durch die Aufnahme eines Stapels von Bildern in verschiedenen Tiefen (engl. *z-stack*)*,* bevorzugt verbunden mit einer numerischen Rekonstruktion des dreidimensionalen Objekts. Bei diesen Verfahren ist eine möglichst gute räumliche Auflösung in z-Richtung untrennbar verbunden mit einer möglichst präzisen axialen Bewegung des Objektivs relativ zum Objekt während des Schreibvorgangs oder des Aufnahmevorgangs, sowie mit einer geringen Schärfentiefe, welche durch eine hohe NA erreicht wird. Diese Verfahren unterscheiden sich damit insbesondere von Verfahren zur 2D-Lithographie (z.B. Projektions-Lithographie) und zur 2D-Bildgebung, in welchen keine in axialer Richtung ortsaufgelöste Strukturierung oder Informationserfassung verwendet wird, und die daher ohne eine axiale Bewegung des Objektivs relativ zum Objekt auskommen können und nicht zwingend eine geringe Schärfentiefe erfordern.

Es wird ausdrücklich darauf hingewiesen, dass in der direktschreibenden Lithographie auftretende Problemstellungen in gleicher oder ähnlicher Weise auch für bildgebende Verfahren, welche sich eines Immersionsmediums bedienen, gelten. Diese sind jedoch nicht Teil der vorliegenden Erfindung. Alle vorstehend und im Folgenden für Lithographieverfahren beschriebenen Aufgaben und Lösungen sind daher auf analoge Aufgaben und Lösungen in Bezug auf die optische Charakterisierung übertragbar, auch wenn dies im Einzelfall nicht ausdrücklich angegeben ist.

Die vorgeschlagene Vorrichtung zur optischen beitung eines Objekts umfasst wenigstens
- einen Objektträger zur Aufnahme eines Objekts;
- eine optische Bearbeitungseinheit, umfassend zumindest eine Einrichtung zur Erzeugung oder zum Empfang von Licht und ein Objektiv zur Belichtung des Objekts mittels des Lichts oder zur Erfassung des Lichts von dem Objekt, wobei das Objektiv eine dem Objektträger zugewandte Endfläche aufweist, wobei die Endfläche über eine Berandung verfügt, wobei das Objektiv ferner eine optische Achse festlegt;
- mindestens eine zwischen dem Objektiv und dem Objektträger eingebrachte Membran, wobei die Membran einen zur Durchdringung durch das Licht eingerichteten Teilbereich aufweist, wobei zumindest der Teilbereich der Membran beweglich in axialer Richtung in Bezug auf die optische Achse ist,
- mindestens eine Membranhalterung zur Halterung der mindestens einen Membran, und
- mindestens ein Immersionsmedium, welches zumindest zwischen der Membran und dem Objektträger eingebracht ist,
wobei die Membran und die Membranhalterung an einer Stelle außerhalb des Objektivs befestigt sind, und wobei die Membran derart an der Membranhalterung angeordnet ist, dass erste Kontaktstellen zwischen der Membran und der Membranhalterung auf oder außerhalb einer Mantelfläche liegen, welche durch eine geometrische Extrusion der Berandung der Endfläche des Objektivs parallel zur optischen Achse ausgebildet ist,
dadurch gekennzeichnet, dass das Immersionsmedium, welches zwischen Membran und Objektträger eingebracht ist, in Form eines flüssigen Photoresists vorliegt.

Die vorgeschlagene Vorrichtung umfasst somit eine in axialer Richtung bewegliche Membran oder zumindest einen in die axiale Richtung beweglichen Teilbereich der Membran sowie ein Immersionsmedium, in Form eines flüssigen Photoresists, welches derart zwischen das Objektiv und dem lithographisch zu bearbeitenden oder optisch zu charakterisierenden Objekt eingebracht ist, dass es zwar in direktem physikalischem Kontakt mit dem

Objekt steht, jedoch durch die Membran zum Objektiv hin abgegrenzt ist. Der Begriff "Membran" bezeichnet hierbei einen Gegenstand, welcher durch einen flexiblen Festkörper gebildet wird, welcher im Wesentlichen eine zweidimensionale Ausdehnung und eine Dicke aufweist, wobei die Ausdehnung die Dicke um einen Faktor von mindestens 10, bevorzugt von mindestens 50, insbesondere von mindestens 100, übersteigt. In einer bevorzugten Ausführungsform liegt die Membran in Form einer dünnen flexiblen Folie vor, welche bevorzugt eine Dicke von 10 µm bis 250 µm, besonders bevorzugt von 15 µm bis 100 µm, insbesondere von 25 µm bis 50 µm, aufweisen kann. Die dünne flexible Folie kann vorzugsweise über eine Anordnung aus Rollen oder Gleitflächen automatisch zu- und abgeführt werden. Damit ist es möglich, bei einem Wechsel des Objekts auch einen objektseitig etwa durch anhaftende Reste einer ersten Immersionsflüssigkeit oder eines Photoresists kontaminierten Bereich der Membran aus einem Wechselwirkungsbereich des Objekts zu entfernen und durch eine neue Membran oder einen neuen Bereich der Membran ohne anhaftende Substanzen zu ersetzen. Alternative Ausführungsformen für die Membran umfassen beispielsweise ultra-dünnes Glas (engl. *ultra-thin glass*) oder dünne Platten aus anderen optisch transparenten und mechanisch flexiblen Substanzen. Die Membran kann insbesondere eine Abgrenzung des in direktem physikalischem Kontakt mit dem Objekt stehenden ersten Immersionsmediums in Richtung des Objektivs bewirken. Damit wird es möglich, dass der flüssige Photoresist das Objekt bedeckt, während sich ein Austrittsfenster oder eine Endfläche des Objektivs in Luft befindet oder in ein zweites Immersionsmedium, insbesondere eine zweite Immersionsflüssigkeit, eingebracht ist. Hierdurch kann insbesondere vermieden werden, dass es bei der direktschreibenden Laserlithographie zu einer ungewollten Vernetzung des Photoresists auf dem Austrittsfenster des Objektivs kommen kann oder sich Verschmutzungen aus dem Photoresist auf dem Objektiv ablagern können. Ferner lässt sich so eine Kontamination des Objektivs oder das mit ihm in Kontakt stehende zweite Immersionsmedium über das Objekt vermeiden. Ferner kann so bei einem Wechsel des Objekts die Gefahr einer Kreuzkontamination vermieden werden.

In einer bevorzugten Ausführungsform kann die Membran so gewählt werden, dass sie für die mit ihr in Kontakt stehenden Medien oder Bestandteilen dieser Medien undurchlässig ist und dass sie von diesen Substanzen auch bei längerer oder dauernder Einwirkung chemisch nicht angegriffen wird.

Der Begriff der "axialen Beweglichkeit" des vom Licht durchdrungenen Teilbereichs der Membran beschreibt dabei eine Ausgestaltung der Vorrichtung, in welcher sich die axiale Position des Teilbereichs in Bezug auf das Objektiv und/oder das Objekts einstellen lässt. In einer besonderen Ausgestaltung lässt sich die axiale Position des von dem Licht durchdrungenen Teilbereiches der Membran relativ zum Objekt über einen Bereich variieren, der bevorzugt mehr als 20 %, besonders bevorzugt mehr als 40 %, ganz besonders bevorzugt mehr als 60 %, des nominellen Arbeitsabstandes des Objektivs beträgt. In einer weiteren Ausgestaltung lässt sich die axiale Position des von dem Licht durchdrungenen Teilbereichs der Membran relativ zum Objektiv über einen Bereich variieren, der bevorzugt mehr als 20 %, besonders bevorzugt mehr als 40 %, ganz besonders bevorzugt mehr als 60 %, des nominellen Arbeitsabstandes des Objektivs beträgt.

Insbesondere im Zusammenhang mit der optischen Bearbeitung des Objekts, bevorzugt in einem Lithographieverfahren, bezeichnet der Begriff "Immersionsmedium" eine feste oder flüssige Substanz oder eine gelartige Mischung, welche von dem Lichtstrahl durchdrungen wird, bevor es zur Initiierung eine Polymerisationsreaktion bevorzugt in der Nähe des Fokuspunktes des Lichtstrahls kommt. Hierbei kann entsprechend der vorliegenden Erfindung, ein flüssiger Photoresist selbst als Immersionsmedium dienen, oder es können geschichtete Anordnungen zum Einsatz kommen, die einen festen, auf einem Substrat aufgebrachten Photoresist und eine oder mehrerer Schichten von Immersionsölen oder transparenten Plättchen umfassen können, welche jedoch nicht Teil der vorliegenden Erfindung sind.

Analog dazu wird insbesondere im Zusammenhang mit der optischen Charakterisierung eines Objekts unter einem "Immersionsmedium" eine feste oder flüssige Substanz verstanden, die von dem zur Bildgebung verwendeten Lichtstrahl auf dem Weg zwischen dem Objektiv und dem Objekt durchdrungen wird. Hierbei kann es sich um eine flüssige Substanz, wie z.B. ein lmmersionsöl oder ein Photoresist, oder um eine feste Substanz, wie z.B. ein Glas, ein Polymer oder eine Mischung oder Kombination von Polymeren handeln. Diese Materialien können beispielsweise in Form einer planparallelen Schicht vorliegen oder das zu untersuchende Objekt objektivseitig umgeben. Bei einer Kombination von optischer Bearbeitung und optischer Charakterisierung des Objekts kann auch der für die lithographische Strukturierung verwendete Photoresist als Immersionsmedium für die Bildgebung dienen. Der Begriff "Photoresist" bezeichnet ein photosensitives, lichtempfindliches Material, vorzugsweise ein Polymer, das beispielweise der Gruppe der Acrylate, der Methylmethacrylate, der Epoxide oder der Ormocere angehört. Zur Belichtung wird eine an die Absorptionseigenschaften des ausgewählten lichtempfindlichen Materials angepasste Wellenlänge des elektromagnetischen Spektrums gewählt, vorzugsweise im sichtbaren, infraroten oder ultravioletten optischen Spektralbereich. Die Belichtung des Photoresists mit dem Lichtstrahl kann hierbei eine Veränderung einer Eigenschaft des lichtempfindlichen Materials hervorrufen, insbesondere eine Veränderung einer Löslichkeit von belichteten Teilbereichen des lichtempfindlichen Materials, wobei sich, je nach ausgewähltem Material, die Löslichkeit verringern (sog. "Negativ-Ton Photoresist", engl. *negative-tone photoresist)* oder erhöhen kann (sog. "Positiv-Ton Photoresist", engl. *positive-tone photoresist*)*.* Je nach Art der Änderung lassen sich somit in einem an den mindestens einen Belichtungsschritt anschließenden Entwicklungsschritt die belichteten Teilbereiche des lichtempfindlichen Materials im Positiv-Ton Photoresist bzw. die unbelichteten Teilbereiche des lichtempfindlichen Materials im Negativ-Ton Photoresist herauslösen, wodurch die gewünschte Struktur am Objekt erhalten werden kann.

Da die Membran zwischen dem Objektiv und dem Objekt eingebracht ist, verringert sie einen objektseitig nutzbaren Arbeitsabstand, was insbesondere bei der lithographischen Bearbeitung oder der optischen Charakterisierung von Objekten mit starker Oberflächentopographie wie z.B. optischen Multi-Chip-Module nachteilig ist. Unter dem Begriff des "objektseitig nutzbaren Arbeitsabstands" oder einfach des "nutzbaren Arbeitsabstands" d" wird im Folgenden der Abstand zwischen der Fokusebene des Objektivs und dem der Fokusebene in Richtung des Objektivs am nächsten liegenden optischen oder mechanischen Bauelement, wie z.B. der Membran, verstanden. Die Verringerung des objektseitig nutzbaren Arbeitsabstandes kann bevorzugt durch die Wahl einer dünnen Membran minimiert werden. In einer bevorzugten Ausführung kann die Dicke der Membran dünner als ein Drittel des Arbeitsabstands, besonders bevorzugt dünner als ein Sechstel des Arbeitsabstands, insbesondere dünner als ein Zehntel des Arbeitsabstands, gewählt werden. Für ein beispielhaftes Objektiv, welches einen Arbeitsabstand von 300 µm aufweist, kann die Dicke der Membran damit bevorzugt höchstens 100 µm, besonders bevorzugt höchstens 50 µm, insbesondere höchstens 30 µm, gewählt werden. Ein mit einer dünneren Membran einhergehende Verlust an Steifigkeit kann sich durch ein Einbringen von in lateraler Richtung wirkenden Zugkräften in die Membran kompensieren lassen, vorzugsweise mittels eines Spannringes oder mittels Spannrollen, die in die Membranhalterung integriert sind oder die die Membranhalterung bilden. Damit lassen sich auch mit sehr dünnen Membranen sehr ebene optische Grenzflächen bereitstellen, deren Wirkung auf die Phasenfronten des sie durchdringenden Lichts sehr genau bekannt ist.

Das zur lithographischen Bearbeitung oder zur optischen Charakterisierung des Objekts verwendete Licht, bei welchem es sich insbesondere um einen Laserstrahl handeln kann, lässt sich zumindest durch den transparenten Teilbereich der Membran in das objektseitig anstehende Immersionsmedium einkoppeln oder aus dieser auskoppeln. Der Begriff "transparent" bezeichnet hierbei eine Eigenschaft zumindest des Teilbereichs der Membran, welche in einer geringen Transmissionsdämpfung über einen Wellenlängenbereich des zur Bearbeitung oder zur Charakterisierung verwendeten Lichts besteht, wobei die Transmissionsdämpfung bevorzugt weniger als 1 dB, besonders bevorzugt weniger als 0,25 dB, insbesondere weniger als 0,1 dB beträgt. Der transparente Teilbereich der Membran kann hierbei entweder eine wohldefinierte optische Grenzfläche ausbilden, deren Wirkung auf Phasenfronten des sie durchdringenden Lichts sehr genau bekannt ist und die damit durch entsprechende Aberrationen angrenzender Raumbereiche kompensiert werden kann, oder er sich "optisch neutral" verhält. Der Begriff "Aberrationen" bezeichnet Abweichungen von einer idealen optischen Abbildung, welche zu einer idealen fehlerfreien Bildgebung bzw. zu einem kleinstmöglichen Fokusvolumen des zur optischen Charakterisierung oder zur lithographischen Bearbeitung verwendeten Lichtstahls führen würden. Hierbei kann es sich einerseits um geometrische oder monochromatische Aberrationen handeln, die sich aus den geometrisch-optischen Strahlverläufen und den entlang dieser Strahlverläufe auftretenden Brechzahlen ergeben und die bereits bei monochromatischem Lithographie- bzw. Bildgebungslicht auftreten, und andererseits um chromatische Aberrationen, die aus einer Wellenlängenabhängigkeit der Brechungsindizes der im Strahlpfad vorhandenen Materialien resultieren. Der Begriff "optisch neutral" beschreibt, dass die vom transparenten Teilbereich der Membran verursachten geometrischen Aberrationen vernachlässigbar sind. Optische Neutralität kann vorzugsweise dadurch erreicht werden, dass eine zumindest im transparenten Teilbereich sehr dünne Membran verwendet wird, welche beidseitig mit einem Immersionsmedium in Kontakt steht, oder durch eine Membran, die sich im transparenten Teilbereich in Bezug auf den Brechungsindex in dem für die optische Strukturierung oder Charakterisierung relevanten Wellenlängenbereich nicht oder nur geringfügig von beiderseitig angrenzenden Immersionsmedien unterscheidet. Bei einem in diesem Sinne optisch neutralen transparenten Teilbereich der Membran kann die Störung der den Teilbereich durchdringenden Phasenfronten bevorzugt gleichviel oder weniger als λ/4, besonders bevorzugt weniger als λ /10, insbesondere weniger als λ /20 betragen, wobei die Störungen der Phasenfront als äquivalenter Wegunterschied in Bruchteilen einer Wellenlänge λ angegeben sind.

Die Membran ist an einer Membranhalterung angebracht und weist einen Teilbereich auf, der für das zur Charakterisierung oder Bearbeitung des Objekts verwendete Licht transparent ist, wobei sich dessen axiale Position in einer bevorzugten Ausführungsform relativ zum Objektiv insbesondere während des Schreibvorganges mittels mindestens eines Positionierelements einstellen lässt. Hierbei sind sowohl die Membran als auch die Membranhalterung an einer Stelle außerhalb des Objektivs befestigt, worunter verstanden wird, dass weder die Membran noch die Membranhalterung sind am Objektiv selbst befestigt, wobei der Begriff "nicht am Objektiv befestigt" bedeutet, dass keine direkte, in alle Raumrichtungen kraft-, form-, und/oder stoffschlüssigen mechanischen Verbindung zwischen der Membran oder der Membranhalterung und einem Bestandteil des Objektivs, insbesondere einer Fassung, einem Gehäuse oder einem transparenten Element des Objektivs, vorliegt, über welche auf die Membran einwirkende Kräfte vollständig oder vornehmlich auf das Objektiv übertragen werden. Durch die vorgeschlagene Ausführung der Membran und der Membranhalterung wird vermieden, dass die bei einer Relativbewegung von Membran und Objekt Kräfte, welche von dem Immersionsmedium oder dem Photoresist auf die bevorzugt großflächige Membran ausgeübt werden, direkt und ohne Abschwächung auf das Objektiv übertragen werden und damit eine hochgenaue dynamische Positionierung des Objektivs erschweren können. Stattdessen kann die Membranhalterung an einem weiteren Teil der optischen Charakterisierungs- oder Bearbeitungseinheit befestigt sein, wobei der weitere Teil im Gegensatz zu dem Objektiv nicht Bestandteil des optischen Strahlenganges ist, in welchem die Anforderungen an Präzision und Dynamik der Positionierung geringer sind, und wobei der weitere Teil zumindest einen Teil der auf die Membran wirkenden Kräfte aufnehmen kann. Ein zeitlich gemittelter Betrag der von der Membran auf das Objektiv übertragenen Kräfte kann dabei bevorzugt weniger als 60%, besonders bevorzugt weniger als 40 %, ganz besonders bevorzugt weniger als 30 % der entsprechenden gemittelten Beträge der insgesamt auf die Membran wirkenden Kräfte betragen. Bei dem weiteren Teil der optischen Charakterisierungs- oder Bearbeitungseinheit kann es sich vorzugsweise um einen Positioniertisch handeln, mit welchem sich das Objektiv axial und/oder lateral verschieben lässt und welcher im Folgenden auch als "Objektivtisch" bezeichnet wird. So können die Membran und die Membranhalterung unbeweglich bezüglich des Objektivs angebracht werden, ohne dass die Membran oder die Membranhalterung Kräfte auf das Objektiv selbst ausübe. Alternativ kann die Membranhalterung auch an einem anderen Teil der optischen Charakterisierungs- oder Bearbeitungs-Einheit befestigt sein, welcher nicht mit dem Objektiv in axialer Richtung bewegt werden kann. Hierbei kann es sich insbesondere um den Objektträger oder einen den Objektträger tragenden Objekttisch handeln. Darüber hinaus ist es auch möglich, die Membranhalterung an einer zum Schutz und Transport des Objekts geeigneten, beispielsweise als geschlossener Container ausgelegten Objekttransporteinheit zu befestigen. Diese Objekttransporteinheit kann vorzugsweise den Objektträger, die Membranhalterung und die Membran umfassen.

Ein weiterer Vorteil einer nicht am Objektiv befestigten Membran besteht darin, dass sie es erlaubt, das Objektiv zu entfernen oder gegen ein anderes auszutauschen, ohne dass die Membran oder die Membranhalterung abgenommen oder verändert wird. Dies ist vorzugsweise bei einer optischen Charakterisierungs- oder Bearbeitungs-Einheit vorteilhaft, die eine Möglichkeit zum automatischen Objektivwechsel aufweist oder die derart ausgelegt ist, dass verschiedenartige Objektive, auch Objektive unterschiedlicher Hersteller, eingesetzt werden können. In diesem Fall ist es wünschenswert, eine von der mechanischen Ausgestaltung des Objektivs unabhängige Einrichtung zur Befestigung der Membranhalterung bereitzustellen. Ein weiterer Vorteil einer nicht am Objektiv befestigten Membran besteht darin, dass sich die Membran einfach und automatisch wechseln lässt, vorzugsweise durch laterales Einschwenken oder Einfahren, ohne dass Kräfte auf das Objektiv ausgeübt werden, die sich nachteilig auf die Strahlausrichtung auswirken können. Dabei ist es insbesondere möglich, einen Wechsel der Membran zu vollziehen, ohne dass die Membran oder die zugehörige Membranhalterung signifikant in axialer Richtung zum Objekt hinbewegt werden und damit die Gefahr einer Beschädigung des Objekts eingegangen werden muss. Weiterhin wird durch die vorgeschlagene Anbringung der Membran verhindert, dass zusätzliche Massen am Objektiv befestigt werden, die bei einer schnellen Bewegung des Objektivs in axialer oder lateraler Richtung Kräfte und/oder Schwingungen hervorrufen und damit die Qualität der optischen Abbildung oder der lithographischen Strukturierung beeinträchtigen können.

Objektive mit kleinem Arbeitsabstand weisen hierbei jedoch den Nachteil auf, dass durch die Verwendung der Membran und der zugehörigen Membranhalterung der zwischen dem Objektiv und dem Objekt verfügbare Bauraum stark eingeschränkt werden kann. Die vorliegende Vorrichtung wird daher so ausgelegt, dass sie den nutzbaren Arbeitsabstand des Objektivs möglichst wenig einschränkt. Sie lässt sich daher auch auf Objektive mit hoher numerischer Apertur (NA) und kleinem nominellen Arbeitsabstand anwenden, die sich kompakt mit vergleichsweise kleinem Durchmesser und geringen Gewicht realisieren lassen, bei denen aber der zwischen Objektiv und Objekt verfügbare Bauraum stark eingeschränkt ist. Gleichzeitig soll es die vorliegende Vorrichtung ermöglichen, den objektseitig nutzbaren Arbeitsabstand so groß wie möglich zu halten. Der "objektseitig nutzbare Arbeitsabstand", der "nutzbare Arbeitsabstand" oder einfach der "Arbeitsabstand" bezeichnen hierbei einen Abstand zwischen der Fokusebene des Objektives und dem in Richtung des Objektives am nächsten liegenden optischen oder mechanischen Bauelements; der nominelle Arbeitsabstand bezeichnet den Abstand zwischen der Fokusebene und dem dieser am nächsten liegende Bestandteil des Objektives, beispielsweise dem Austrittsfenster. Die NA eines in vorgeschlagenen Vorrichtung verwendeten Objektivs kann bevorzugt mehr als 0,5, besonders bevorzugt mehr als 0,7, mehr bevorzugt mehr als 0,9, insbesondere mehr als 1,1 betragen. Der nominelle Arbeitsabstand des Objektivs kann hierbei in einem Bereich von 50 µm bis 10 mm, bevorzugt von 80 µm bis 2 mm, insbesondere von 100 µm bis 1 mm liegen.

Die Vorrichtung ist dabei so ausgestaltet, dass außer der Membran selbst keine weiteren mechanischen Elemente in den Zwischenraum zwischen einer Endfläche des Objektivs und dem Objekt eingebracht sind. Der Begriff des "Objektivs" bezeichnet ein fokussierendes Element oder eine Anordnung aus mindestens zwei fokussierenden Elementen, welche dazu eingerichtet sind, einen Licht in den Objektraum einzustrahlen bzw. aus diesem zu empfangen. Im Allgemeinen kann das Objektiv zumindest eine Endfläche, eine Berandung der Endfläche, ein Austrittsfenster und eine Fassung aufweisen, wobei darüber hinaus weitere Komponenten vorgesehen sein können. Gemäß der vorliegenden Erfindung umfasst der Begriff "Objektiv" zusätzlich zu dem mindestens einen fokussierenden Element insbesondere ein Gehäuse, welche beispielsweise zur mechanischen Halterung des mindestens einen fokussierenden Elements eingerichtet ist. Das Objektiv und das zugehörige optische System verfügt ferner über eine optische Achse, die sich beispielsweise aus der Rotationssymmetrie der im Objektiv auftretenden optischen Flächen ergibt. Die Ausgestaltung des Gehäuses des Objektivs bleibt bei der Festlegung der optischen Achse außer Betracht. Der Begriff der "Endfläche" bezeichnet eine dem Objekt zugewandte Fläche des Objektivs, welche ein "Austrittsfenster" des Objektivs in Form eines transparenten Teilbereichs umfasst, wobei durch das Austrittsfenster das Licht in die Richtung des Objekts abstrahlbar oder aus dieser Richtung empfangbar ist. Unter einem "Austrittsfenster" wird ein in das Objektiv integriertes oder ein durch direkten physikalischen Kontakt mit diesem verbundenes optisch transparentes Fenster bezeichnet, durch das Licht in ein an das Objektiv angrenzendes Immersionsmedium eintreten oder aus diesem empfangen werden kann. Die Endfläche kann eine ebene oder gekrümmte Oberfläche des Austrittsfensters und eine das Austrittsfenster umgebende Oberfläche einer nicht-transparenten mechanischen Fassung, welche eine Gratlinie aufweist, umfassen. Der Begriff der "Fassung" bezeichnet hierbei ein die äußere geometrische Form des Objektivs bestimmendes mechanisches Element, welches sich direkt an das Austrittsfenster anschließt und welches das gesamte Gehäuse des Objektivs umfassen kann. Für die vorliegende Erfindung ist hierbei jedoch nur der dem Objekt zugewandte Teil der Fassung relevant. Der objektseitige Teil der Fassung umfasst hierbei alle Oberflächenelement der Fassung, deren Normalenvektor eine in Richtung des Objekts zeigende axiale Komponente aufweist. Unter einer "Gratlinie" der Fassung wird eine die optische Achse umschließende Kontur verstanden, welche von den parallel zur optischen Achse am weitesten in Richtung des Objekts vorstehenden Punkten gebildet wird. Mittels der Gratlinie der Fassung lässt sich somit der Begriff der "Endfläche" wie folgt definieren: Die Endfläche umfasst mindestens das Austrittsfenster des Objektivs, wobei die Endfläche im Falle einer an das Austrittsfenster anschließenden Fassung zusätzlich den von der Gratlinie umschlossenen Bereich der Fassung sowie alle Punkte außerhalb der Gratlinie umfasst, die im Falle einer ebenen und senkrecht zur optischen Achse ausgerichteten Oberfläche des Objekts einen Abstand *d*' zum Objekt aufweisen, der bevorzugt um weniger als 5 mm, besonders bevorzugt um weniger als 1 mm, insbesondere um weniger als 300 µm größer ist als der maximale Abstand deines Punktes der Gratlinie zur Oberfläche des Objekts. Die Endfläche des Objektivs bildet somit ein einfach zusammenhängendes Gebiet, das eine Berandung aufweist. Die dem Objekt am nächsten liegenden Punkte der Endfläche müssen dabei nicht notwendigerweise auf der Gratlinie der Fassung liegen. So können im Falle eines konvex gekrümmten Austrittsfensters des Objektivs die dem Objekt am nächsten liegenden Punkte beispielsweise auf dem Austrittsfenster selbst liegen.

Um auch ohne mechanische Elemente zwischen der Endfläche des Objektivs und dem Objekt eine stabile Halterung und axiale Positionierung des vom Licht durchdrungenen Teilbereichs der Membran zu ermöglichen, umfasst die vorgeschlagene Vorrichtung eine mit der Membran verbundene Membranhalterung, wobei die Kontaktpunkte zwischen der Membran und der Membranhalterung erfindungsgemäß auf oder außerhalb einer Mantelfläche liegen, welche durch eine geometrische Extrusion der Berandung parallel zur optischen Achse beschrieben wird, und wobei eine Anordnung der Kontaktpunkte zwischen der Membran und der Membranhalterung innerhalb dieser Mantelfläche ausgeschlossen ist. Der Begriff "Mantelfläche" beschreibt hierbei die durch die geometrische Extrusion der Berandung der Endfläche parallel zur optischen Achse gebildete Fläche. Sie kann auch als Hüllfläche eines zylindrischen Körpers verstanden werden, der sich aus einer geometrischen Extrusion der Endfläche entlang der optischen Achse des Systems ergibt, und der, abhängig vom einem Verlauf der Berandung, einen beliebigen Querschnitt, insbesondere in Form eines Kreises, einer Ellipse oder eines Ovals, annehmen kann. Andere Formen des Querschnitts sind jedoch möglich. Der Begriff "geometrische Extrusion" bezeichnet hierbei grundsätzlich eine Dimensionserhöhung eines Elements, hier der Berandung bzw. der Endfläche, durch Parallelverschiebung im Raum, hier parallel zur optischen Achse. Wird die eine Linie oder Kurve darstellende Berandung der Endfläche des Objektivs extrudiert, indem die Linie oder die Kurve entlang einer Richtung parallel zur optischen Achse gezogen wird, kann hierdurch die gewünschte Mantelfläche erhalten werden. Durch diese Ausgestaltung der vorliegenden Vorrichtung wird es somit möglich, den auf oder außerhalb der Mantelfläche in axialer Richtung verfügbaren Bauraum zur Ausgestaltung der Membranhalterung in vorteilhafter Weise zu nutzen, ohne dass hierbei der nutzbare Arbeitsabstand der Vorrichtung durch mechanische Elemente, welche gemäß dem Stand der Technik zwischen die Endfläche des Objektivs und dem Objekt eingebracht würden, eingeschränkt wird.

In einer bevorzugten Ausgestaltung kann die Membran sehr nahe am Objektiv positioniert werden, so dass die Verringerung des nutzbaren Arbeitsabstandes der Vorrichtung gegenüber dem nominellen Arbeitsabstand des Objektivs im Wesentlichen durch die Dicke der Membran bestimmt ist. In einer weiteren bevorzugten Ausgestaltung können durch die Membranhalterung Zugkräfte in die Membran eingebracht werden, die in einer senkrecht zur optischen Achse liegenden Ebene wirken und die es ermöglichen, die Membran zu straffen und damit auch im Falle einer sehr dünnen Membran eine möglichst ebene Form der Membran zu erreichen. Dabei kann die Membranhalterung ringförmig ausgestaltet sein und Zugkräfte in die Membran einbringen, die in radialer Richtung von der optischen Achse weg gerichtet sind, oder es können Anordnungen zum Einsatz kommen, die im Wesentlichen parallel gerichtete Zugkräfte in die Membran einbringen. Unter dem Begriff "radial" wird eine Richtung verstanden, die senkrecht zur optischen Achse steht; eine Richtung parallel zur optischen Achse wird mit dem Begriff "axial" beschrieben. Die Membranhalterung kann über Rollen und/oder Gleitflächen verfügen und damit eine laterale Bewegung der Membran zwischen der Endfläche des Objektivs und dem Objekt ermöglichen. Dies kann vorteilhaft sein für einen einfacheren Wechsel des mit dem Immersionsmedium in Kontakt stehenden Teilbereichs der Oberfläche der Membran.

In einer besonders bevorzugten Ausgestaltung verfügt die vorgeschlagene Vorrichtung über eine Einrichtung, die axiale Position des von dem Licht durchdrungenen Teilbereichs der Membran bzgl. des Objekts während des Charakterisierungs- oder Bearbeitungsvorgangs einzustellen. Hierzu wird ein- oder mehrteiliges Positionierelement eingesetzt, welches mit der Membran in Kontakt gebracht werden kann. Der Begriff "während des Charakterisierungs- oder Bearbeitungsvorgangs" bezeichnet hierbei eine Änderung der axialen Positionierung des von dem Lichtstrahl durchdrungenen Teilbereichs der Membran relativ zum Objekt, welche automatisiert während der lithographischen Strukturierung oder der dreidimensionalen optischen Charakterisierung oder während einer kurzen Unterbrechung dieser Vorgänge erfolgt, ohne dass es hierzu erforderlich ist, das Objekt aus dem Arbeitsraum des Objektivs zu entfernen, um beispielsweise eine Kalibration vorzunehmen. Aus der axialen Beweglichkeit des von dem Lichtstrahl durchdrungenen Teilbereichs der Membran bzgl. des Objekts ergibt sich bei direktschreibenden Laserlithographie-Verfahren ein Vorteil, dass auch Objektive mit begrenztem nominellem Arbeitsabstand oder Vorrichtungen mit begrenztem nutzbaren Arbeitsabstand dazu eingesetzt werden können, um Strukturen beliebiger Höhe zu erzeugen, indem während des schichtweisen Aufbaus der Struktur das Objektiv und die Membran gemeinsam vom Objekt wegbewegt werden. Weiterhin kann sich durch eine axiale Positionierbarkeit des von dem Lichtstrahl durchdrungenen Teilbereichs der Membran ein weiterer Vorteil eines zusätzlichen Freiheitsgrades zur Kompensation von optischen Aberrationen im Vergleich zu Lithographieverfahren ergeben, in welchen sich das Objektiv in direktem Kontakt mit einem homogenen zu strukturierenden Photoresist befindet. Zu diesem Zweck lassen sich vorzugsweise Immersionsmedien verschiedener Photosensitivität und/oder Brechungsindizes und/oder Viskositäten verwenden, die in Raumbereiche eingebracht werden, welche sich objektseitig und/oder objektivseitig an die von dem Licht durchdrungenen Teilbereiche der Membran anschließen. In diesem Fall wird es durch eine axiale Verschiebung des von dem Lichtstrahl durchdrungenen Teilbereichs der Membran möglich, Aberrationen gezielt zu erzeugen oder zu kompensieren. Als Anhaltspunkt für ein Vorliegen einer günstigen axialen Position der Membran kann hierbei MehrphotonenLumineszenz-Strahlung dienen, die von dem zur Charakterisierung oder Bearbeitung des Objekts verwendeten Lichtstrahls im Volumen des Immersionsmediums erzeugt wird und die sich durch eine in der Lithographie-Einheit vorhandene Detektionseinrichtung erfassen lässt. Im Falle von Mehrphotonenlumineszenz hängt die Intensität der erzeugten Lumineszenz-Strahlung nichtlinear von der anregenden Intensität ab und lässt sich durch eine Kennlinie positiver Krümmung beschreiben. Da bei kleinen Aberrationen eine hohe Maximalintensität im Objektraum erreicht wird, ist auch die Lumineszenz bei minimaler Aberration maximal. Durch Maximierung der erfassten Lumineszenz-Leistung kann so die Aberration minimiert werden. Durch Verschieben der Membran und gleichzeitiges Beobachten der Lumineszenz kann somit eine optimale Position für die Membran gefunden werden, indem die Lumineszenz maximiert wird. Zur Erfassung der Lumineszenz-Strahlung kann die Lithographie-Einheit um eine Nachweiseinrichtung für Lumineszenz ergänzt werden. In einer bevorzugten Ausführungsform wird die Leistung des zur Anregung der Mehrphotonen-Lumineszenz verwendeten Lichtes so gewählt, dass bei der Anregung keine Vernetzungsreaktionen oder nur sehr schwache Vernetzungsreaktionen ausgelöst werden. Unter einer "Vernetzungsreaktion" wird in diesem Zusammenhang eine chemische Reaktion verstanden, in der dauerstabile kovalente Bindungen zwischen im Immersionsmedium enthaltenen Reaktionspartnern erzeugt werden. Von den entstehenden Reaktionsprodukten weist vorzugsweise mindestens eine höhere molare Masse auf als jedes der an der Reaktion beteiligten Edukte. Damit bleibt der Photoresist während des Einstellvorganges der Membranposition unverändert oder der Photoresist ändert sich nur in einem im Vergleich zur späteren Strukturierung zu vernachlässigendem Umfang.

In einer weiteren bevorzugten Ausgestaltung der Vorrichtung kann über einen Sensor, beispielsweise einen Kraftsensor oder einen auf elektrischen Strömen basierenden Kontaktsensor, eine Kollision zwischen zwei Elementen der Vorrichtung detektiert werden. Die Detektion einer solchen Kollision, die insbesondere zwischen Membranhalterung oder Membran und Objekt, Objektträger oder Objekttisch erfolgen kann, erlaubt es, durch entsprechende Schutzmechanismen eine Kollision und eine daraus resultierende Beschädigung des Objektivs oder anderer empfindlicher Baugruppen zu vermeiden.

Ein weiterer Vorteil der Verwendung eines in axialer Richtung relativ zum Objekt beweglichen von dem Lichtstrahl durchdrungenen Teilbereichs der Membran liegt in einer Verringerung eines Verbrauchs an Photoresist-Material in der 3D-direktschreibenden ImmersionsLithographie. So lässt sich durch eine axiale Positionierung des von dem Licht durchdrungenen Teilbereichs möglichst nahe am Objekt das Volumen des zwischen der Membran und dem Objekt als Immersionsmedium dienenden Photoresists auf ein Minimum reduzieren, während auf der dem Objektiv zugewandten Seite der Membran ein weiteres Immersionsmedium, z.B. ein Indexöl, eingesetzt werden kann, das sich mehrfach verwenden lässt. Durch eine Einstellung der axialen Position des von dem Lichtstrahl durchdrungenen Teilbereichs der Membran während des Betriebs kann das Volumen an Photoresist flexibel an die jeweils zu erzeugende Struktur angepasst werden. Zusätzlich oder unabhängig davon kann durch eine Wechselwirkung zwischen der Membran und dem als Immersionsmedium dienenden Photoresist eine laterale Lokalisierung des Photoresists erreicht werden. So ist es z.B. möglich, durch eine Membran mit angepassten Benetzungseigenschaften, insbesondere bei kleinen Volumina an Photoresist, ein sogenanntes "Zerfließen" eines Tropfens aus Photoresist in lateraler Richtung zu verhindern, indem der Photoresist durch Oberflächenkräfte zwischen der Membran und dem Objekt gehalten wird. Dazu können insbesondere auch laterale Strukturierungen auf der Membran beitragen, welche insbesondere ortsaufgelöst die Benetzungseigenschaften der Membran ändern können. Die laterale Strukturierungen können sowohl auf der dem Objekt als auch auf dem Objektiv zugewandten Seite der Membran eingesetzt und zum ortsaufgelösten Aufbringen von Immersionsmedien verwendet werden. Zusätzlich oder alternativ dazu können bei Objektiven mit großem nominellem Arbeitsabstand zusätzliche Führungselemente zum Einsatz kommen, die ein Abfließen von Immersionsflüssigkeiten in lateraler Richtung verhindern. In einer besonderen Ausgestaltung können diese Führungselemente auch durch die Positionierungselemente gebildet werden.

Durch die Verwendung von zwei, durch den axial beweglichen, transparenten Teilbereich der Membran voneinander getrennt angeordneten Immersionsmedien können sich außerdem zusätzliche Freiheitsgrade bzgl. der Photosensitivität und/oder des Brechungsindex' und/ oder der Viskosität der direkt mit dem Objekt in Kontakt stehenden Immersionsflüssigkeit ergeben. Typischerweise sind Immersionsobjektive auf einen bestimmten Brechungsindex optimiert, der den objektseitigen Strahlpfad entweder homogen ausfüllt oder ein Deckglas mit festgelegten Dicken und optischen Eigenschaften umgibt, um minimale geometrische Aberrationen und damit eine größtmögliche räumliche Konzentration der optischen Leistung im Fokuspunkt zu erreichen. Bei der Verwendung derartiger Objektive in der direktschreibenden hochauflösenden Laserlithographie ist es daher wichtig, den Brechungsindex des als Immersionsflüssigkeit dienenden Photoresists genau auf das verwendete Objektiv anzupassen. Hierzu ist es erforderlich, den Brechungsindex typischerweise mit einer Genauigkeit von 10⁻³ oder besser einzustellen. Hierdurch wird nicht nur das Spektrum verwendbarer Photoresists stark einschränkt, sondern es können Probleme bei einer Umsetzung stabiler Lithographie-Verfahren in einem industriellen Umfeld auftreten. So können Schwankungen des Brechungsindex" in der genannten Größenordnung bereits durch eine Temperaturabhängigkeit oder Alterung des Photoresists oder aufgrund von Schwankungen der Zusammensetzung von zur Herstellung des Photoresists verwendeten Ausgangsprodukten verursacht werden. Weiterhin können auch Objektive herstellerseitig Toleranzen aufweisen, die eine Verwendung von objektivspezifischen Immersionsmedien, insbesondere von Photoresisten, notwendig macht, was in einem industriellen Kontext nur schwer umsetzbar ist. Diese Probleme können durch die hier vorgeschlagene lokal axial bewegliche, transparente Membran gelöst werden. Durch die Trennung der Volumina der Immersionsmedien zwischen dem Objektiv und dem Objekt kann der dem Objekt zugewandte Bereich mit einem als erste Immersionsflüssigkeit dienenden Photoresist benetzt werden, dessen Brechungsindex nicht optimal auf das Objektiv angepasst ist. Die dabei auftretenden Aberrationen lassen sich durch die eine geeignete Wahl des zweiten Immersionsmediums kompensieren, die auf der dem Objektiv zugewandten Seite der Membran verwendet wird und deren Brechungsindex für diesen Zweck gewählt wird. Zusätzlich zur Wahl des Brechungsindex' des zweiten Immersionsmediums, der sich vom Brechungsindex des ersten Immersionsmediums insbesondere um eine Differenz von mindestens 0,005, bevorzugt von mindestens 0,01, unterscheiden kann, kann auch die vorgeschlagene Möglichkeit der axialen Positionierung des von dem Lichtstrahl durchdrungenen Teilbereichs der Membran zwischen dem Objektiv und dem Objekt dazu verwendet werden, um die gesamten, entlang des Strahlwegs auftretenden Aberrationen möglichst genau einzustellen. Hierdurch können nicht nur geometrische Aberrationen, sondern auch chromatische Aberrationen kompensiert werden, indem ein zweites Immersionsmedium mit einer passenden Wellenlängenabhängigkeit des Brechungsindex bzw. passender Abbe-Zahl gewählt wird. In ähnlicher Weise lässt sich durch die geeignete Wahl des zweiten Immersionsmediums eine Temperaturabhängigkeit des Brechungsindex des ersten Immersionsmediums und damit der daraus resultierenden geometrischen Aberrationen kompensieren. Alternativ oder zusätzlich können sich vorzugsweise die Viskositäten des ersten Immersionsmediums und des zweiten Immersionsmediums voneinander unterscheiden. Um zusätzliche Freiheitsgrade bei der Kompensation von Aberrationen oder Temperaturabhängigkeiten zu schaffen, ist es möglich, mindestens eine weitere, in der axialen Position verstellbare Membran zwischen dem Objekt und dem Objektiv vorzusehen, zwischen denen sich weitere Immersionsmedien verschiedener Brechungsindizes und Abbe-Zahlen einfügen lassen.

Das mindestens eine zur axialen Positionierung des vom Licht durchdrungenen Teilbereiches der Membran verwendete Positionierelement kann entweder auf die gesamte Membran oder nur auf den von dem Licht durchdrungenen Teilbereich einwirken. Das mindestens eine Positionierelement kann hierzu in permanentem mechanischem Kontakt mit der Membran stehen. Alternativ kann dieser Kontakt vor Beginn des optischen Strukturierungs- oder Charakterisierungsvorganges hergestellt werden, beispielsweise während eines gegenseitigen Annäherns von Objektiv und Objekt. Für den Fall, dass das mindestens eine Positionierelement nur auf den von dem Lichtstrahl durchdrungenen Teilbereich wirkt, können die zweiten Kontaktstellen zwischen dem mindestens einen Positionierelement und der Membran vorzugsweise innerhalb einer Kontur liegen, welche durch die vorstehend beschriebenen ersten Kontaktstellen der Membran mit der Membranhalterung oder durch ein von den ersten Kontaktstellen gebildetes Polygon mit sich nicht überschneidenden Seitenlinien beschrieben werden kann. Das mindestens eine Positionierelement kann ferner so ausgelegt sein, dass es den zur Strukturierung oder Charakterisierung des Objekts verwendeten Lichtstrahl möglichst nicht stört. Zu diesem Zweck könne die zweiten Kontaktstellen zwischen der Membran und dem mindestens einen Positionierelement bevorzugt außerhalb des von dem Lichtstrahl durchdrungenen Teilbereichs liegen. In einer bevorzugten Ausgestaltung ist das mindestens eine Positionierelement so ausgelegt, dass die zweiten Kontaktstellen zwischen der Membran und dem Positionierungselement auf oder außerhalb der Mantelfläche liegen, welche durch die geometrische Extrusion der Berandung der Endfläche des Objektivs parallel zur optischen Achse des Systems beschrieben wird. Dadurch wird es auch hier möglich, den auf oder außerhalb der Mantelfläche in axialer Richtung verfügbaren Bauraum zur Ausgestaltung des mindestens einen Positionierelements zu nutzen, ohne dabei den nutzbaren Arbeitsabstand der Anordnung durch mechanische Elemente zwischen der Endfläche des Objektivs und dem Objekt einzuschränken. Bei den Kontaktstellen zwischen der Membran und dem mindestens einen Positionierelement kann es sich um diskrete Einzelpunkte handeln oder aber um eine Punktemenge, die vorzugsweise eine ein- oder mehrteilige, die optische Achse umschließende Kontur ausbilden kann. In einer bevorzugten Ausgestaltung ist es möglich, mittels des mindestens einen Positionierelements die axiale Position des von dem Lichtstrahl durchdrungenen Teilbereichs der Membran über weiten weiteren Bereich zu verstellen, so dass die Membran sowohl beliebig nahe an die Endfläche des Objektivs als auch beliebig nahe an die Oberfläche des Objekts herangeführt werden kann.

In einer besonderen Ausgestaltung kann das mindestens eine Positionierelement so ausgestaltet sein, dass es an den Kontaktstellen in lateraler Richtung keine form-, kraft-, und/oder stoffschlüssige Verbindung zur Membran aufweist und damit überwiegend axial wirkende Kräfte von der Membran aufnehmen kann. Das mindestens eine Positionierelement kann hierzu insbesondere so ausgestaltet sein, dass es lateral über die Membran bewegt werden kann, wobei zumindest zeitweise, bevorzugt fortwährend, eine optimale axiale Position des von dem Lichtstrahl durchdrungenen Teilbereichs der Membran bzgl. des Objektivs oder des Objekts erreicht werden kann. Zu diesem Zweck kann das mindestens eine Positionierelement so ausgelegt sein, dass es ohne große Krafteinwirkung infolge von Reibung und ohne großen Verschleiß an der Membran oder an dem mindestens einen Positionierelement selbst lateral über die Membran gleiten oder rollen kann. Alternativ oder zusätzlich können die Rollen und/oder Gleitflächen des Mindestens einen Positionierelements auch dazu dienen, eine laterale Bewegung der Membran und damit ein einfacher Wechsel des mit dem Immersionsmedium in Kontakt stehenden Teilbereichs der Oberfläche der Membran zu ermöglichen, beispielsweise um eine Kontamination zu verhindern.

Zur Positionierung des vom Licht durchdrungenen Teilbereichs ist eine Bewegung der Kontaktstellen oder des mindestens einen Positionierelements in axialer Richtung relativ zum Objekt möglich, die entweder durch dafür speziell vorgesehene Aktuatoren bewirkt wird oder durch eine Anordnung, in der das mindestens eine Positionierelement an einem weiteren Teil der Lithographie-Einheit angebracht ist und gemeinsam mit dieser von bereits vorhandenen Aktuatoren bewegt werden kann. Um eine axiale Bewegung des von dem Lichtstrahl durchdrungenen Teilbereichs der Membran mittels der durch das mindestens eine Positionierelement eingebrachten Kräfte zu ermöglichen, kann die Membranhalterung über mechanische Freiheitsgrade verfügen, die vorzugsweise ein axiales Gleiten eines fest mit der Membran verbundenen Elementes relativ zu einem Anschlagpunkt der Membranhalterung zulassen. Alternativ oder zusätzlich kann die axiale Beweglichkeit des von dem Lichtstrahl durchdrungenen Teilbereichs der Membran auch auf einer elastischen oder teilelastischen Verformung der Membran und/oder der Membranhalterung beruhen.

Das zur axialen Positionierung des von dem Lichtstrahl durchdrungenen Teilbereichs verwendete mindestens eine Positionierelement oder ein zugehöriger Aktuator kann an einem Teil der Lithographie-Einheit angebracht sein oder auch in die zum Schutz und Transport des Objekts vorgesehene, vorzugsweise als geschlossener Container ausgelegte Objekttransporteinheit integriert sein. In einer besonderen Ausgestaltung kann das mindestens eine Positionierelement am Objektiv oder am Objektivtisch angebracht sein. Das mindestens eine Positionierelement kann in diesem Fall über Aktuatoren verfügen, welche zu einer Verschiebung des von dem Lichtstrahl durchdrungenen Teilbereichs der Membran in axialer Richtung relativ zum Objektiv oder zum Objektivtisch eingerichtet ist. Alternativ kann das mindestens eine Positionierelement starr mit dem Objektiv oder mit dem Objektivtisch verbunden sein und in einer synchronisierten und vom selben Aktuator bewirkten Bewegung gemeinsam mit dem Objektiv oder mit dem Objektivtisch in axialer Richtung positioniert werden. In diesem Fall kann eine Einstellung einer für die Charakterisierung oder Bearbeitung des Objekts günstigen axialen Position des von dem Lichtstrahl durchdrungenen Teilbereichs der Membran zwischen dem Objektiv und dem Objekt während einer gegenseitigen Annäherung und einer hochgenauen relativen Positionierung von Objektiv und Objekt erfolgen. In einer einfachen Ausgestaltung kann auch ein Teil des Objektivs selbst die Rolle des mindestens einen Positionierelements übernehmen, indem beispielsweise ein Objektiv mit einer ebenen oder konkaven Endfläche auf eine lateral gespannte Membran gedrückt wird, um diese in axialer Richtung leicht zu deformierten und/oder zu verschieben. Bei dem als Positionierelement fungierenden Teil des Objektivs kann es sich z. B. um die Gratlinie oder um die Berandung der Endfläche des Objektivs oder um einen zwischen der Gratlinie und der Berandung des Objektivs liegenden Teilbereichs der Endfläche des Objektivs handeln. Darüber hinaus kann auch ein Objektiv mit einem ebenen oder in Richtung des Objekts konvex gewölbten Austrittsfenster zur Positionierung des vom Licht durchdrungenen Teilbereichs der Membran verwendet werden, bei dem das Austrittsfenster einen geringeren Abstand zum Objekt aufweist als die Fassung des Objektivs. Im Falle einer flexiblen Membran kann sich die Membran hierbei an das Austrittsfenster anschmiegen, was im Falle einer dünnen optisch neutralen Membran zu keinen relevanten zusätzlichen Aberrationen führt. Wird das mindestens eine Positionierelement wie vorstehend beschrieben am Objektiv angebracht, so ist es vorteilhaft, wenn die von einer großflächigen Membran auf das Objektiv wirkende Kräfte zumindest teilweise über eine nicht am Objektiv angebrachte Membranhalterung abgeleitet werden können anstatt vollständig von den Positionierelementen auf das Objektiv übertragen zu werden. Dies kann einerseits dadurch ermöglicht werden, dass die Positionierelemente keine in lateraler Richtung form-, kraft- und/oder stoffschlüssige Verbindung zu der Membran aufweisen und damit in erster Linie axial wirkende Kräfte von der Membran aufnehmen können. Diese axial wirkenden Kräfte können sich dadurch minimieren lassen, dass die Membran durch mittels einer lateralen, stabil ausgelegten Membranhalterung eingebrachte Kräfte gestrafft wird und dass die am Objektiv angebrachten Positionierelemente mit kleinen Kräften in axialer Richtung auf die Membran aufgedrückt werden. Dadurch wird es insbesondere möglich, das mindestens eine Positionierelement kompakt auszulegen und damit die zusätzlich am Objektiv befestigten Massen im Hinblick auf eine schnelle und präzise Bewegung des Objektivs so gering wie möglich zu halten. In einer alternativen Ausgestaltung kann das mindestens eine Positionierelement am Objektträger, am Objekttisch oder an anderen Teilen der Lithographie-Einheit befestigt sein. Sie können hierbei bevorzugt über Aktuatoren verfügen, mit denen sich der von dem Licht durchdrungene Teilbereich der Membran in axialer Richtung relativ zum Objektiv verschieben lässt.

In einer besonderen Ausgestaltung lässt sich erreichen, dass keine Kräfte von der Membran auf das Objektiv übertragen werden, indem ein direkter Kontakt des Objektivs mit der Membran vermieden wird und indem das mindestens eine Positionierelement nicht am Objektiv angebracht ist. Diese Verwendung einer nicht am Objektiv angebrachten Membranhalterung in Kombination mit einem oder mehreren baulich von der Membranhalterung getrennten Positionierelementen zur axialen Bewegung des vom Licht durchdrungenen Teilbereichs der Membran erlaubt es insbesondere, auf das Objektiv wirkenden Kräfte zu vermeiden oder zumindest zu verringern, indem ein Teil dieser Kräfte über die Membranhalterung in einen anderen, bzgl. Krafteinwirkung weniger empfindlichen Teil des optischen Bearbeitungs- oder Charakterisierungs-Einheit abgeführt wird. Diese Ausgestaltung ist insofern vorteilhaft, da sie es ermöglicht, die Membranhalterung massiv zum Einbringen großer Spannkräfte in eine großflächige Membran auszulegen, ohne dabei die direkt am Objektiv angehängten Massen und Trägheitskräfte zu erhöhen. Die Positionierelemente können dagegen nur eine geringe Auslenkung der Membran in axialer Richtung ermöglichen; dafür werden nur geringe in axialer Richtung wirkende Kräfte benötigt, die vom Objektiv aufgebracht und durch verhältnismäßig kleine Positionierelemente auf die Membran übertragen werden können. Auch wenn die Positionierelemente nicht am Objektiv selbst angebracht sind, ist die Trennung von Membranhalterung oder Positionierelementen dennoch vorteilhaft, insbesondere im Hinblick auf die Möglichkeit, die Membran einfach auszutauschen oder das Objektiv zu wechseln, ohne dass die Membran oder die Membranhalterung abgenommen oder verändert wird. Dennoch sind auch Ausgestaltungen denkbar, in welchen die Membranhalterung selbst als Positionierelement dient und vorzugsweise am Objektivtisch, am Objektträger, an einem anderen Teil der optischen Bearbeitungs- oder Charakterisierungs-Einheit oder auch an der zum Schutz und Transport des Objekts geeigneten, vorzugsweise als geschlossener Container ausgelegten Objekttransporteinheit angebracht ist.

Wie bereits erwähnt, kann es sich bei der Membran in einer bevorzugten Ausgestaltung um eine dünne flexible Folie handeln, die durch laterale Kräfte gestrafft werden kann und sich zur axialen Positionierung des von dem Lichtstrahl durchdrungenen Teilbereichs der Membran elastisch deformieren lässt. Die zu einer Deformation erforderlichen axial wirkenden Kräfte können, wie vorstehend beschrieben, durch entsprechende Positionierelemente eingebracht werden. Die Verwendung einer durch laterale Kräfte gestrafften und durch axiale Kräfte lokal positionierten Membran ist insbesondere dann von Vorteil, wenn sehr großflächige Objekte bearbeitet werden sollen, deren laterale Ausdehnung über dem 100- oder 1000-fachen des Arbeitsabstande des Objektivs liegen können und bei denen es nur mit großem mechanischen Aufwand möglich wäre, eine großflächige Membran in der richtigen Höhe und mit ausreichender Parallelität zur Fokusebene des Objektivs zu positionieren. In einer bevorzugten Ausgestaltung sind die zur lokalen axialen Positionierung des von dem Lichtstrahl durchdrungenen Teilbereichs der Membran dienenden Positionierelemente daher so ausgestaltet, dass diese lateral über die Membran bewegt werden können, wobei fortwährend eine optimale axiale Position des von dem Lichtstrahl durchdrungenen Teilbereichs der Membran zu dem Objektiv erreicht wird. Zu diesem Zweck können die Positionierelemente so ausgelegt sein, dass sie ohne große Krafteinwirkung infolge von Reibung und ohne großen Verschleiß an der Membran oder an den Positionierelementen lateral über die Membran gleiten oder rollen können.

In einer besonders bevorzugten Ausgestaltung kann die großflächige flexible Membran eine elastische Folie umfassen, die aus einem bzgl. dem verwendeten Immersionsmedien oder den verwendeten Photoresisten beständigem Material besteht und die eine Dehnung ermöglicht. Als Materialien eignen sich hierbei ein Polymer, insbesondere Polyethylen (PE) oder Polyimid (PI), Nylon (Polyamid) oder sehr dünne, flexible Glasfolien (engl. *Ultra Thin Glass),* wie z.B. von F. He et al., Towards Flexible Glass: Ultra-Thin Glass with Tight Dimensional Tolerance and High Strength Achieved by Ion Exchange, SID Symposium Digest of Technical Papers, 2017, Seite 48, beschrieben. Die Membranhalterung kann vorzugsweise als Spannring ausgelegt sein, mit dem sich ein faltenfreier Verlauf der Membran erreichen lässt. Alternativ kann eine Anordnung aus Rollen und/oder Gleitflächen insbesondere zur automatischen Abführung kontaminierter und zur Zuführung sauberer Bereiche der Membran vorgesehen sein.

In einer bevorzugten Ausgestaltung für den Anwendungsfall der Mehrphotonenlithographie kann die Membran ein Material aufweisen, das transparent ist im Wellenlängenbereich eines zur lithographischen Bearbeitung eingesetzten Kurzpuls-Lasers, aber intransparent im Wellenlängenbereich, gegenüber dem das photosensitive Material bzw. der Photoresist in Folge linearer (Einphotonen-)Absorption empfindlich ist. Die Membran kann damit Schutz vor ungewollter Belichtung des Photoresists durch Umgebungslicht bieten, erlaubt aber eine Bearbeitung durch Mehrphotonenpolymerisation mit dem Kurzpulslaser. Bei einer Integration der Membran in eine Objekttransporteinheit wird es möglich, diese erlaubt es die Objekttransporteinheit durch Bereiche zu transportieren, in dem kein sog. Gelblicht vorliegt; in dem also die UV-Anteile des Umgebungslichtes nicht ausgefiltert werden. Eine entsprechende spektral selektive Transmission der Membran kann beispielsweise durch die inhärenten Materialeigenschaften der Membran gegeben sein, oder aber sie lässt sich beispielsweise durch Zugabe entsprechender Materialien oder durch geeignete, beispielsweise aufgedampfte oder in der Flüssighase aufgebrachten Beschichtungen erreichen, welche UV-Anteile des Lichts zumindest teilweise reflektieren und/oder zumindest teilweise absorbieren können.

In einer bevorzugten Ausgestaltung kann die Membran lateral unbeweglich bzgl. des Objekts angebracht sein, während die axiale Beweglichkeit der Membran oder zumindest des von dem Lichtstrahl durchdrungenen Teilbereichs der Membran nicht beeinträchtigt wird.

Diese Ausgestaltung ist insbesondere dann von Vorteil, wenn Strukturen lithographisch erzeugt oder optisch charakterisiert werden sollen, deren laterale Abmessungen größer sind als ein Sichtfeld oder ein mittels eines Strahlscanners adressierbares Schreibfeld des Objektivs, was eine laterale Bewegung des Objektivs relativ zum Objekt erfordert. Eine feste laterale Position der Membran relativ zum Objekt verhindert, dass bei einer lateralen Bewegung Scherkräfte in das mit dem Objekt in Kontakt stehende Immersionsmedium oder den Photoresist eingebracht werden, die zu einer Relativbewegung des Objekts und der an das Objekt angrenzenden Schichten des Immersionsmediums und damit zu einer Beschädigung von Strukturen auf dem Objekt führen könnten. Die Scherkräfte können stattdessen in das zwischen der Membran und dem Objektiv befindliche Immersionsmedium eingebracht werden, welches nicht in Kontakt mit dem Objekt steht und damit keine Beschädigungen des Objekts oder sich darauf befindlicher Strukturen verursachen kann. Das Immersionsmedium kann zudem eine geringe Viskosität aufweisen, um damit die bei einer lateralen Bewegung auf das Objektiv wirkenden Kräfte klein zu halten. Alternativ kann kein Immersionsmedium vorgesehen sein für den Fall, dass es sich bei dem Objektiv um ein Trockenobjektiv handelt. In diesem Fall kann die Membran dazu beitragen, eine wohldefinierte Grenzfläche mit optischer Qualität zu schaffen, durch die der Lichtstrahl ohne Störungen in das Immersionsmedium oder den Photoresist eingekoppelt oder aus diesem ausgekoppelt werden kann. In vorteilhafter Weise lässt sich eine in lateraler Richtung relativ zum Objekt unbewegliche Montage der Membran vorzugsweise dadurch erreichen, dass die Membranhalterung an dem Objektträger oder dem Objekttisch fixiert oder in eine Objekttransporteinheit integriert wird. Die axiale Beweglichkeit des von dem Lichtstrahl durchdrungenen Teilbereichs der Membran kann dabei vorzugsweise durch eine elastische Verformbarkeit der Membran selbst oder der Membranhalterung erreicht werden.

In einer weiteren Ausgestaltung, die nicht Teil der vorliegenden Erfindung ist, kann mit einem Luftobjektiv eine lithographische Strukturierung in einem festen Photoresist, vorgenommen werden, dessen Oberfläche eine starke Topographie aufweisen kann und daher nicht als eine definierte optische Grenzfläche dienen kann. Bei dem festen Photoresist kann es sich um Materialien wir Polymethylmethacrylat (PMMA), SU-8, Ormocere oder um mit diesen Materialien verwandte Substanzen handeln. Für weitere Details in Bezug auf das Material "SU-8" wird beispielsweise auf die Beschreibung in http://www.microchem.com/pdf/SU8 50-100.pdf (abgerufen am 07.12.2018) verwiesen. Zu diesem Zweck kann auf den festen Photoresist eine bzgl. des Brechungsindex' an den Photoresist angepasste erste Immersionsflüssigkeit aufgebracht sein, die in Richtung des Objektivs durch die Membran mit einer definierten optischen Fläche abgegrenzt wird, so dass eine störungsarme Einkopplung des zur lithographischen Strukturierung verwendeten und von dem Trockenobjektiv emittierten Lichts in den festen Photoresist ermöglicht wird - auch für den Fall, dass der Photoresist eine starke Oberflächentopographie aufweist.

In ähnlicher Weise lassen sich mit dieser Anordnung auch im Photoresist vergrabene Strukturen mit hoher Auflösung bildgebend erfassen. Alternativ kann zwischen der Membran und dem Objektiv eine weitere Immersionsflüssigkeit eingesetzt werden, die einen von der ersten Immersionsflüssigkeit und damit auch von dem festen Photoresist abweichenden Brechungsindex und/oder Viskosität aufweisen kann. Für diesen Fall können der Brechungsindex und/oder die Viskosität der zweiten Immersionsflüssigkeit sowie die Position der durch die Membran definierten Grenzfläche bevorzugt so gewählt werden, dass der Strahlpfad zwischen dem Objektiv und dem Objekt minimale geometrische Aberrationen aufweist, um damit eine größtmögliche räumliche Konzentration der optischen Leistung im Fokuspunkt zu erreichen.

Für weitere Einzelheiten in Bezug auf die vorgeschlagene Vorrichtung wird auf die untenstehenden Ausführungsbeispiele verweisen.

In einem weiteren Aspekt betrifft die vorliegende Erfindung ein Verfahren zur optischen Bearbeitung eines Objekts, welche insbesondere mittels der hierin ebenfalls beschriebenen Vorrichtung zur optischen Bearbeitung eines Objekts durchgeführt werden kann. Das Verfahren umfasst die im Folgenden näher beschriebenen Schritte a) bis f), wobei jeder einzelne Schritt auch mehrfach durchgeführt und zumindest aufeinanderfolgende Schritte auch zumindest teilweise gleichzeitig ausgeführt werden können:
a) Positionieren mindestens eines Objekts auf einem Objektträger;
b) Aufbringen eines Immersionsmediums auf zumindest einen Teil des Objekts, wobei das Immersionsmedium in Form eines flüssigen Photoresists vorliegt;
c) Annähern einer Membran auf den mit dem Immersionsmedium bedeckten Teil des Objekts, wobei die Membran einen zur Durchdringung mit Licht vorgesehenen transparenten Teilbereich aufweist;
d) Positionieren eines Objektivs, welches eine optische Achse festlegt, relativ zum mit dem Immersionsmedium bedeckten Teil des Objekts;
e) Einstellen einer in Bezug auf die optische Achse axialen Position für den Teilbereich der Membran; und
f) Optische Bearbeitung des Objekts mittels des Lichts.

Gemäß Schritt a) wird zunächst mindestens ein Objekt auf einem Objektträger aufgebracht.

Wie oben oder unten beschrieben, kann es sich bei dem Objekt um ein einzelnes Objekt oder um ein Objekt handeln, welches mehrere Teilobjekte umfasst.

Gemäß Schritt b) erfolgt ein Aufbringen eines Immersionsmediums auf einen Teilbereich des optisch zu charakterisierenden oder zu bearbeitenden Objekts. Dies kann manuell oder mittels einer technischen Vorrichtung, insbesondere einer Dispenseinheit durchgeführt werden. Die Dispenseinheit kann sich hierbei direkt in der optischen Charakterisierungs- oder Bearbeitungs-Einheit befinden oder in Form einer eigenständigen Einrichtung vorgesehen sein, von welcher das mit der Immersionsflüssigkeit versehene Objekt in die optische Charakterisierungs- oder Bearbeitungs-Einheit transferiert werden kann. Bei dem Immersionsmedium handelt es sich um einen flüssigen Photoresist.

Gemäß Schritt c) erfolgt ein Annähern einer Membran an den mit dem Immersionsmedium bedeckten Teil des Objekts. Die Membran kann dazu insbesondere an einer Membranhalterung befestigt sein. Hierbei weist die Membran einen Teilbereich auf, der für das zur Charakterisierung oder Bearbeitung des Objekts eingesetzten Licht transparent ist, und dient der Abgrenzung der mit dem Objekt in Kontakt stehenden Immersionsflüssigkeit in Richtung des Objektivs. Der vom Licht durchdrungene Teilbereich der Membran ist in axialer Richtung relativ zu dem Objekt bewegbar ausgestaltet. Wie weiter beschrieben, sind hierbei sowohl die Membran als auch die Membranhalterung an einer Stelle außerhalb des Objektivs befestigt; so dass weder die Membran noch die Membranhalterung am Objektiv selbst befestigt sind. Ferner liegen erste Kontaktstellen zwischen der Membran und der Membranhalterung auf oder außerhalb einer Mantelfläche, welche durch eine geometrische Extrusion der Berandung der Endfläche des Objektivs parallel zur optischen Achse ausgebildet ist. Abhängig von der Ausführungsform kann die Annäherung der Membran an den mit der Immersionsflüssigkeit bedeckten Teilbereich des Objekts entweder in der optischen Charakterisierungs- oder Bearbeitungs-Einheit selbst, in einer zum Aufbringen des Photoresists geeigneten Dispenser-Einheit oder in einer weiteren, zum Aufbringen der Membran geeigneten Funktionseinheit erfolgen. Bei einem Transfer des mit der Immersionsflüssigkeit versehenen Objekts in die optische Bearbeitungs-Einheit kann die Membran in Verbindung mit einer entsprechend gestalteten Objekttransporteinheit somit die oben und unten beschriebene Schutzfunktion zur Vermeidung von Verschmutzungen oder einem Kontakt mit Sauerstoff oder Luftfeuchtigkeit übernehmen.

Gemäß Schritt d) erfolgt eine Positionierung eines Objektivs, welches eine optische Achse im vorliegenden optischen System festlegt, relativ zum mit dem Immersionsmedium bedeckten Teil des Objekts.

Gemäß Schritt e) wird eine axiale Position für den Teilbereich der Membran möglichst günstig eingestellt, wobei sich der der Begriff "axial" auf die durch das Objektiv festgelegte optische Achse bezieht. Hierzu können insbesondere Positionierelemente, wie sie oben oder unten beschrieben werden, eingesetzt werden. Hierbei wird die Membran im Arbeitsraum des Objektivs positioniert und der vom Licht durchdrungene Teilbereich der axial beweglichen Membran in eine gewünschte axiale Position zwischen dem Objektiv und dem Objekt gebracht. In einer besonderen Ausgestaltung ist es möglich, die axiale Positionierung des von dem Lichtstrahl durchdrungenen Teilbereichs der Membran gemeinsam mit der Positionierung des Objektivs relativ zum Objekt in einer synchronisierten und vom gleichen Aktuator bewirkten Bewegung durchzuführen, wobei zusätzlich gleichzeitig die gemäß Schritt c) durchzuführende axiale Annäherung der Membran an den mit der Immersionsflüssigkeit bedeckten Teil des Objekts erfolgen kann. Zu diesem Zweck können die Membran und die Membranhalterung vorzugsweise am Objektivtisch angebracht sein und gemeinsam mit dem Objektiv an das Objekt herangeführt werden.

Schließlich erfolgt gemäß Schritt f) die optische Bearbeitung des Objekts mittels des Lichtstrahls.

In einer bevorzugten Ausgestaltung des vorliegenden Verfahrens können die Schritte a) bis c) in einer Dispenser-Einheit ausgeführt werden, welcher zur Aufbringung des zwischen der Membran und dem Objekt verwendeten Immersionsmediums eingerichtet ist. Hieran anschließend kann eine Objekttransporteinheit, welche neben der Membran und der Membranhalterung zumindest den Objektträger umfasst oder als Objektträger ausgestaltet ist, zu einer optischen Charakterisierungs- oder Bearbeitungseinheit transferiert werden. Danach können die Schritte d) bis f) in der im Folgenden auch als "Lithographie-Einheit" bezeichneten optischen Bearbeitungseinheit ausgeführt werden. Auf diese Weise können das automatisierte Aufbringen des Immersionsmediums auf das Objekt, der Transfer des mit dem Immersionsmedium versehenen Objekts und die optische Bearbeitung innerhalb einer Produktionskette in gesonderten, für die jeweilige Funktion besonders ausgestalteten Funktionseinheiten erfolgen. Damit werden hier in vorteilhafter Weise ein Aufbringen eines flüssigen Photoresists in einer separaten Funktionseinheit und ein nachfolgender Transfer innerhalb einer Produktionskette, insbesondere zum Transport zwischen unterschiedlichen Funktionseinheiten, unter Nutzung der Membran als Teil eines das Objekt umschließenden Containers möglich. Insbesondere für den Transport zwischen den Funktionseinheiten kann es besonders vorteilhaft sein, wenn die Membran transparent ist für Licht bei der für die Bearbeitung und/oder Charakterisierung verwendeten Wellenlänge, jedoch nicht bei kürzeren Wellenlängen, so dass, wie oben beschrieben, insbesondere bei einem Einsatz von Mehrphotonen-Lithographie keine unbeabsichtigte Polymerisation des Photoresists durch Umgebungslicht ausgelöst werden kann.

Ein weiterer Aspekt, der nicht Teil der vorliegenden Erfindung ist, betrifft eine Objekttransporteinheit, umfassend
- einen Objektträger zur Aufnahme eines Objekts,
- mindestens eine zwischen einem Objektiv und dem Objektträger eingebrachte Membran, wobei die Membran einen zur Durchdringung durch Licht eingerichteten Teilbereich aufweist, wobei zumindest der Teilbereich der Membran beweglich in axialer Richtung in Bezug auf die optische Achse ist, und
- mindestens eine Membranhalterung zur Halterung der mindestens einen Membran,
wobei die Objekttransporteinheit zumindest zwischen einer Handhabungseinheit für Immersionsmedien und einer Vorrichtung zur optischen Charakterisierung oder Bearbeitung eines Objekts, insbesondere eine hierin beschriebene Vorrichtung zur optischen Bearbeitung eines Objekts, transferierbar ist, wobei die Handhabungseinheit zumindest zur Aufbringung eines zwischen der Membran und einem zu charakterisierenden oder zu bearbeitenden Objekt verwendeten Immersionsmediums eingerichtet ist, und wobei die optische Charakterisierungs- oder Bearbeitungs-Einheit zumindest eine Einrichtung zur Erzeugung oder zum Empfang des Lichts und das Objektiv zur Belichtung des Objekts mittels des Lichts oder zur Erfassung des Lichts von dem Objekt umfasst.

Hierbei bezeichnet der Begriff der "Handhabungseinheit" eine Einrichtung, die zu einer Bereitstellung, einer Aufbewahrung, einem Transport und einer Abgabe mindestens eines Immersionsmediums eingerichtet ist. Hierzu kann die Handhabungseinheit insbesondere über eine Dispenseinheit verfügen, mit welcher das Immersionsmedium auf das Objekt aufgebracht werden. Die Handhabungseinheit kann ferner dazu eingerichtet sein, das mit der einem Immersionsmedium versehene Objekt mit der bevorzugt flüssigkeitsdicht, insbesondere als geschlossener Container, ausgestalteten Objekttransporteinheit zu umgeben. Ein Transport des Objekts oder der Objekttransporteinheit von der Handhabungseinheit zu der optischen Charakterisierungs- oder Bearbeitungs-Einheit kann vorzugsweise mittels eines Fördersystem unter normalen Umgebungsbedingungen erfolgen. Der Begriff der "normalen Umgebungsbedingungen" bedeutet, dass im durchquerten Raumbereich keine Anforderungen im Hinblick auf Sauberkeit, insbesondere keine Reinraumklasse; auf Belichtung, insbesondere keine Gelblichtumgebung; auf atmosphärische Randbedingungen, insbesondere keine regulierte Luftfeuchtigkeit und/oder auf elektrostatische Entladung, insbesondere kein Schutz vor elektrostatischer Entladung (engl. *electrostatic discharge,* ESD), erforderlich sind.

Für weitere Einzelheiten in Bezug auf das vorliegende Verfahren und die Objekttransporteinheit wird auf die Beschreibung der Vorrichtung sowie auf die Ausführungsbeispiele verweisen.

Die vorliegende Vorrichtung und das vorliegende Verfahren weisen gegenüber US 2005/0158673 A1, welche eine Vorrichtung für die 2D-Immersionslithographie offenbart, in welcher die Immersionsflüssigkeit in einem aus einer dünnen Membran gebildeten Ballon gekapselt ist, eine Reihe von vorteilhaften Unterschieden auf. Der mit Immersionsflüssigkeit gefüllte Ballon wird dort zwischen dem Objektiv und dem Objekt derart positioniert, dass er sowohl das Objektiv als auch das Objekt berührt. Hierdurch kann ein Immersionsobjektiv für die hochaufgelöste 2D-Lithographie benutzt und vor Verschmutzung geschützt werden. Eine Übertragung dieser Offenbarung auf die direktschreibende 3D-Lithographie wäre jedoch mit weitreichenden Einschränkungen verbunden. Die Verwendung eines flüssigen Photoresists scheidet aus, da dieser durch den Druck des flüssigkeitsgefüllten Ballons vom Objekt verdrängt würde, und auch bei einem festen Photoresist ist die Anwendung auf Fälle beschränkt, in denen der Photoresist eine sehr ebene Oberfläche optischer Güte aufweist, so dass ein störungsfreier Übergang von Licht aus dem Ballon in den Photoresist möglich ist. Dadurch ist die Höhe der herstellbaren Strukturen inhärent beschränkt. Ferner werden durch den gefüllten Ballon Kräfte auf das Objektiv ausgeübt, die eine schnelle und präzise Relativpositionierung zwischen dem Objekt und dem Objektiv erschweren und damit zu einer Einschränkung der Präzision und/oder der Schreibgeschwindigkeit führen können. Außerdem lassen sich damit Aberrationen bei der Strukturierung in verschiedenen Tiefen nicht kompensieren.

Weiterhin weisen die vorliegende Vorrichtung und das vorliegende Verfahren gegenüber US 7570343 B2 vorteilhafte Unterschiede auf. US 7570343 B2 offenbart eine Vorrichtung und ein Verfahren zur Projektionslithographie, in der 2D-Strukturen auf im wesentlichen planaren Objekten erzeugt werden, die typischerweise maximale Unebenheiten in der Größenordnung einer oder weniger Lichtwellenlängen der Lithographie-Strahlung aufweisen. Dort wird vorgeschlagen, ein für das Projektionslicht durchlässiges Abschlusselement im objektseitigen Lichtpfad des Systems einzufügen, wobei das Abschlusselement auch zur Trennung zweier Immersionsflüssigkeiten dienen kann. Bei dem Abschlusselement kann es sich entweder um eine feste Platte mit makroskopischer Dicke handeln oder um eine dünne Membran handeln, wobei die Position des Abschlusselements zwischen dem Objekt und dem Projektionsobjektiv durch entsprechende Justage-Elemente beim Einrichten des Systems eingestellt werden kann. Als Justage-Elemente werden lediglich Mikrometerschrauben erwähnt, die sich in einem Zwischenraum zwischen einer Endfläche des Objektivs und dem Objekt befinden können. Alternativ kann die Position der Membran über den hydrostatischen Druck der angrenzenden Immersionsflüssigkeiten bewegt werden. Das Abschlusselement kann durch eine geeignete geometrische Formgebung ferner dazu dienen, Aberrationen der Lithographie-Einrichtung zu korrigieren. Im Falle einer flexiblen Membran kann die geometrische Formgebung auch durch eine Variation des hydrostatischen Drucks der auf beiden Seiten angrenzenden Immersionsflüssigkeiten erreicht werden. Allerdings ist dort während des Schreibvorgangs keine axiale Relativbewegung des Objektivs zu dem Objekt vorgesehen, wie sie bei der optischen 3D-Bearbeitung und Charakterisierung erforderlich ist, um eine 3D-Struktur in Richtung der optischen Achse schichtweise aufzubauen oder zu erfassen. Damit genügt es dort, die axiale Position des Abschlusselements zwischen dem Objektiv und dem Objekt einmalig bei der Einrichtung der Lithographie-Einrichtung, bevorzugt manuell mittels Mikrometerschrauben, einzustellen; eine Änderung dieser Position während des Schreibvorgangs durch Verschieben des Abschlusselements in axialer Richtung bezüglich der durch das Objektiv definierten optischen Achse ist nicht gewünscht, während dies für die direktschreibende 3D-Lithographie unbedingt erforderlich ist. Dadurch könne große Objektive mit großem Arbeitsabstand und dennoch hoher NA eingesetzt werden, die eine große Masse aufweisen, und die sich in der direktschreibenden 3D-Lithographie daher nur schwer schnell und präzise in axiale Richtung bewegen ließen. Da dort weder die Objekte noch die Substrate oder die darauf lithographisch erzeugten Strukturen eine dreidimensionale Topographie aufweisen, ist es dort möglich, die Lithographie-Einrichtung mit einem sehr kleinen Sicherheitsabstand zwischen transparentem Abschlusselement und Objekt zu betreiben, d.h. den Abstand zwischen dem Abschlusselement und der Oberfläche des planaren, mit einem festen Photoresist beschichteten Substrates auf einen sehr kleinen, zur Vermeidung von mechanischen Kollisionen gerade ausreichenden Wert zu reduzieren. Durch den sehr großen Arbeitsabstand des Objektivs und den sehr kleinen zur 2D lithographischen Strukturierung notwendigen Sicherheitsabstand ist es dort möglich, vergleichsweise große optische und/oder mechanische Baugruppen in den Raumbereich zwischen der Endfläche des Objektivs und dem Objekt einzubringen, die den nutzbaren Arbeitsabstand der Anordnung auf einen Bruchteil des nominellen Arbeitsabstandes des Objektivs reduzieren können. Als weitere Möglichkeit zur Positionierung eines als dünne Membran ausgelegten transparenten Abschlusselements wird dort eine Variation des hydrostatischen Drucks der Immersionsflüssigkeit auf mindestens einer Seite der Membran beschrieben. Allerdings wäre eine Anwendung dieser Möglichkeit auf 3D-direktschreibende Lithographieverfahren mit starken Einschränkungen verbunden: Einerseits wäre es dazu notwendig, das Volumen der Immersionsflüssigkeit so abzuschließen, dass sich ein kontrollierter Druck aufbauen und beibehalten ließe, was sehr aufwendig und in einem industriellen Fertigungsprozess mit kurzen Taktzeiten nur schwer realisierbar wäre. Weiterhin würde sich durch die Druckänderung in der flexiblen Membran nicht nur deren Position, sondern auch deren Krümmung ändern, so dass sich Position und Brechkraft der Membran durch eine Variation des Drucks in nachteiliger Weise nicht unabhängig voneinander einstellen ließen. Ferner müsste zur Einstellung des Drucks ein größeres Volumen der Immersionsflüssigkeit zum Ausgleich vorgehalten werden, was im Falle eines als Immersionsflüssigkeit dienenden Photoresists nachteilig im Hinblick auf eine Minimierung des Volumens an Photoresist ist. Als Photoresist dient dort eine feste, auf dem Objekt aufgebrachte dünne Schicht, deren maximale Dicke in der Größenordnung einer oder weniger Lichtwellenlängen der Lithographie-Strahlung liegt und damit zur Herstellung funktionaler 3D-Strukturen nicht ausreichen würde. Die Verwendung eines flüssigen Photoresists als Immersionsmedium ist dort nicht vorgesehen. Dementsprechend besteht dort auch keine Gefahr, dass auf dem Austrittsfenster des Objektivs eine ungewollte Polymerisation des flüssigen Photoresists auftreten oder dass es durch Relativbewegung zwischen dem Objekt und der an das Objekt angrenzenden Schichten des flüssigen Immersionsmediums zu einer Beschädigung des Objekts oder darauf erzeugter Strukturen kommen kann.

### Kurze Beschreibung der Figuren

Weitere Einzelheiten und Merkmale der vorliegenden Erfindung ergeben sich aus der nachfolgenden Beschreibung bevorzugter Ausführungsbeispiele, insbesondere in Verbindung mit den abhängigen Ansprüchen. Hierbei können die jeweiligen Merkmale für sich alleine oder zu mehreren in Kombination miteinander verwirklicht sein. Die Erfindung ist nicht auf die Ausführungsbeispiele beschränkt.

Die Ausführungsbeispiele sind schematisch in den nachfolgenden Figuren dargestellt. Hierbei bezeichnen gleiche Bezugsziffern in den Figuren gleiche oder funktionsgleiche Elemente bzw. hinsichtlich ihrer Funktionen einander entsprechende Elemente.

Im Einzelnen zeigen:
- Figur 1: eine schematische Darstellung eines bevorzugten Ausführungsbeispiels der erfindungsgemäßen Vorrichtung;
- Figur 2: eine schematische Darstellung von besonders bevorzugten Ausführungsbeispielen eines Objektivs für die erfindungsgemäße Vorrichtung;
- Figur 3: eine schematische Darstellung eines Objekts, das mehrere Teilobjekte umfasst;
- Figur 4: eine schematische Darstellung mehrerer Ausführungsbeispiele für Membranhalterung und Positionierelementen;
- Figur 5: eine schematische Darstellung einer Einrichtung umfassend mehrere Vorrichtungen mit getrennter Funktion und eine Objekttransporteinheit;
- Figur 6: Ergebnisse einer Simulation der Abbildungsqualität der erfindungsgemäßen Vorrichtung;
- Figur 7: eine schematische Darstellung eines weiteren, bevorzugten Ausführungsbeispiels der erfindungsgemäßen Vorrichtung, das eine zweite Membran aufweist;
- Figur 8: eine schematische Darstellung eines weiteren, bevorzugten Ausführungsbeispiels der erfindungsgemäßen Vorrichtung, worin Kräfte zur Verformung und axialen Positionierung der Membran oder ihres transparenten Teilbereichs durch ein am Objektivtisch oder am Objektiv befestigtes Positionierelement eingebracht werden;
- Figur 9: eine schematische Darstellung eines weiteren, bevorzugten Ausführungsbeispiels der erfindungsgemäßen Vorrichtung, worin die Membranhalterung an dem Objektivtisch befestigt ist;
- Figur 10: eine schematische Darstellung eines weiteren, bevorzugten Ausführungsbeispiels der erfindungsgemäßen Vorrichtung, worin die Membranhalterung ebenfalls mit dem Objektivtisch verbunden ist;
- Figur 11: eine schematische Darstellung eines Ausführungsbeispiels, das nicht Teil der vorliegenden Erfindung ist, umfassend einen festen Photoresist, der das Objekt überdeckt;
- Figur 12: eine schematische Darstellung eines weiteren, bevorzugten Ausführungsbeispiels der erfindungsgemäßen Vorrichtung, worin die Membran eine laterale Strukturierung aufweist;
- Figur 13: eine schematische Darstellung eines bevorzugten Ausführungsbeispiels einer Anordnung für Membranhalterung und Positionierung; und
- Figur 14: eine schematische Darstellung eines Ausführungsbeispiels, das nicht Teil der vorliegenden Erfindung ist, in Form einer Objekttransporteinheit vor einem Zusammenbau in Aufsicht (Fig. 14a) sowie nach dem Zusammenbau in Aufsicht (Fig. 14b) und als Querschnitt (Fig. 14c).

### Beschreibung der Ausführungsbeispiele

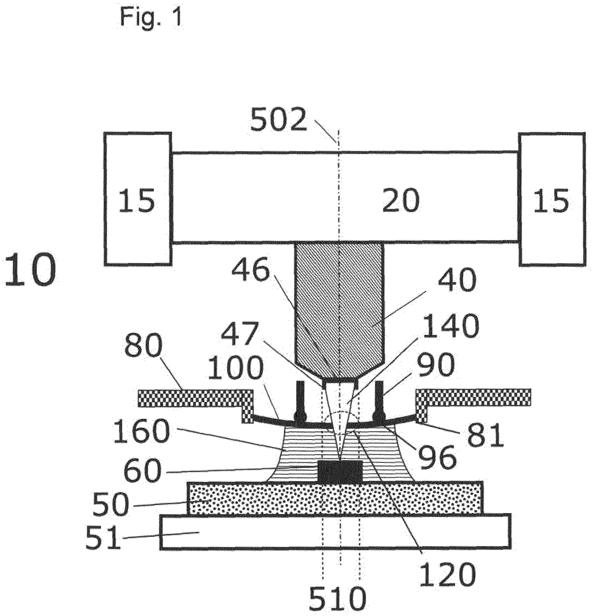

Figur 1 zeigt eine schematische Darstellung eines bevorzugten Ausführungsbeispiels der erfindungsgemäßen Vorrichtung 10 zur optischen Bearbeitung eines Objekts 60. Die beispielhaft in Figur 1 dargestellte Vorrichtung 10 umfasst einen Objektträger 50 zur Aufnahme des Objekts 60, eine optische Einheit 15, die eine Einrichtung zur Erzeugung von Licht, welches hier beispielhaft in Form mindestens eines Lichtstrahls 140 bereitgestellt wird und daher auch als "Lithographie-Einheit" bezeichnet werden kann, und ein Objektiv 40 zur Belichtung des Objekts 60 mittels des Lichtstrahls 140 aufweist, eine zwischen dem Objektiv 40 und dem Objekt 60 eingebrachte Membran 100, eine Membranhalterung 80 zur Halterung der Membran 100, und ein Immersionsmedium 160, das zwischen der Membran 100 und dem Objekt 60 eingebracht ist. Die Membran 100 verfügt über einen zur Durchdringung durch den zur Bildgebung oder Bearbeitung verwendeten Lichtstrahl 140 eingerichteten Teilbereich 120, wobei zumindest der Teilbereich 120 der Membran 100 beweglich in axialer Richtung in Bezug auf eine optische Achse 502 angeordnet ist, welche durch das Objektiv 40 festgelegt wird. Hierzu kann vorzugsweise mindestens ein Positionierelement 90 eingesetzt werden, um den Teilbereich 120 der Membran 100 während des Bearbeitungsvorganges in axialer Richtung bewegen zu können. Das Objektiv 40 weist eine dem Objektträger 50 zugewandte Endfläche 46 auf, wobei die Endfläche 46 über eine Berandung 47 verfügt. Erfindungsgemäß wird vorgeschlagen, die Membran 100 derart an der Membranhalterung 80 anzubringen, dass erste Kontaktstellen 81 zwischen der Membran 100 und der Membranhalterung 80 auf oder außerhalb einer Mantelfläche 510 liegen, welche durch eine geometrische Extrusion der Berandung 47 der Endfläche 46 des Objektivs 40 parallel zur optischen Achse 502 ausgebildet ist. Die geometrische Extrusion der Berandung 47 der Endfläche 46 des Objektivs 40 parallel zur optischen Achse 502 bezeichnet hierbei eine Dimensionserhöhung der Berandung 47 der Endfläche 46 des Objektivs 40 durch Parallelverschiebung im Raum parallel zur optischen Achse 502. Auf diese Weise wird die eine Linie oder Kurve darstellende Berandung 47 der Endfläche 46 des Objektivs 40 derart entlang einer Richtung parallel zur optischen Achse 502 gezogen wird, dass hierdurch die gewünschte Mantelfläche 510 erhalten wird. Die Mantelfläche 510 beschreibt somit die durch die geometrische Extrusion der Berandung 47 der Endfläche 46 des Objektivs 40 parallel zur optischen Achse 502 ausgebildete Fläche. Diese Mantelfläche 510 kann auch als Hüllfläche eines zylindrischen Körpers verstanden werden, der sich aus einer geometrischen Extrusion der Endfläche 46 entlang der optische Achse 502 ergibt, und der, abhängig von vom einem Verlauf der Berandung 47, einen beliebigen Querschnitt, insbesondere in Form eines Kreises, einer Ellipse oder eines Ovals, annehmen kann. Andere Formen des Querschnitts sind jedoch möglich.

Diese erfindungsgemäße Ausgestaltung der vorliegenden Vorrichtung 10 ermöglicht es somit, den auf oder außerhalb der Mantelfläche 510 in axialer Richtung verfügbaren Bauraum zur Ausgestaltung der Membranhalterung 80 zu nutzen, ohne dass hierbei in vorteilhafter Weise der nutzbare Arbeitsabstand der Vorrichtung 10 durch mechanische Elemente, welche gemäß dem Stand der Technik zwischen die Endfläche 46 des Objektivs 40 und dem Objekt 60 eingebracht würden, eingeschränkt wird.

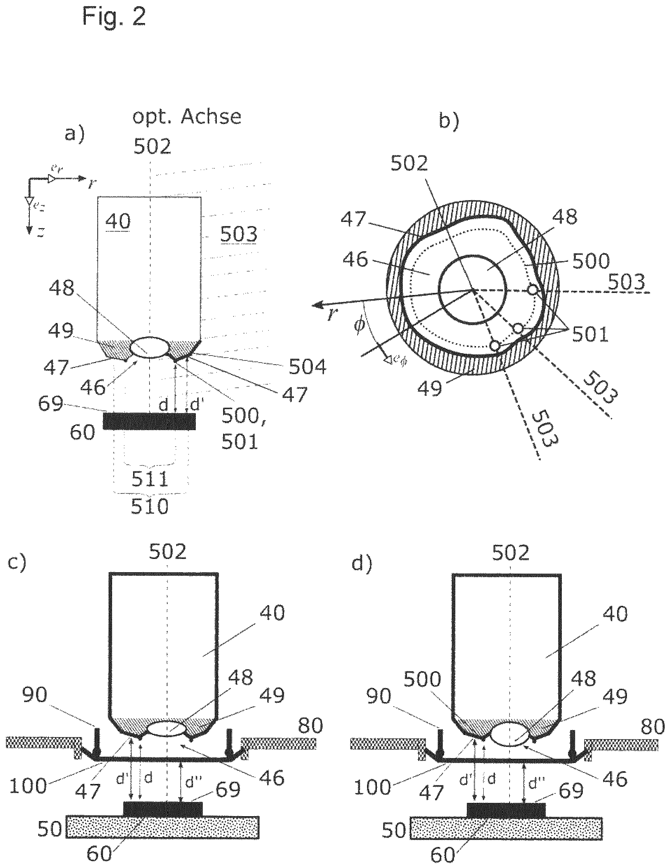

Figur 2 zeigt jeweils eine schematische Darstellung von besonders bevorzugten Ausführungsbeispielen des Objektivs 40, welches für eine Verwendung in der erfindungsgemäßen Vorrichtung 10 vorgesehen ist.

In Figur 2a ist hierzu ein Querschnitt durch das Objektiv 40 dargestellt, welcher die Endfläche 46, die Berandung 47 der Endfläche 46, ein Austrittsfenster 48 und eine Fassung 49 des Objektivs 40 zeigt. Hierbei bildet der dem Objekt 60 zugewandte Teil der Fassung 49 des Objektivs 40 eine Gratlinie 500 aus, welche eine die optische Achse 502 umschließende Kontur definiert, die von den parallel zur optischen Achse 502 am weitesten in Richtung des Objekts 60 vorstehenden Punkten gebildet wird. Vorzugsweise lässt sich die Gratlinie 500 der Fassung 49 des Objektivs 40 wie folgt konstruieren: Zunächst werden Schnittflächen der Fassung 49 mit einer Mannigfaltigkeit von Halbebenen 503 bestimmt, welche an der optischen Achse 502 beginnen und sich in radialer Richtung erstrecken. Unter dem Begriff "radial" wird hierbei eine Richtung verstanden, die senkrecht zur optischen Achse 502 steht und die in Fig. 2b mit der Koordinate r bzw. dem lokalen Einheitsvektor *eᵣ* bezeichnet wird; die axiale Richtung verläuft parallel zur optischen Achse 502 und wird durch die Koordinate z und den lokalen Einheitsvektor *e_{z}* bezeichnet. Der Begriff "azimutal", der zugehörige Parameter *φ* und der zugehörige lokale Einheitsvektor *e_{φ}* werden entsprechend der bekannten Definitionen von Polarkoordinaten verwendet, um eine lokal senkrecht zur radialen und zur azimutalen Achse orientierte Richtung zu bezeichnen, wobei sich die Richtung aus der Rechtshändigkeit des Koordinatensystems (*eᵣ, e_{φ}, e_{z}*) ergibt. Kombinationen aus radialen und azimutalen Richtungen werden auch als "laterale" Richtungen bezeichnet. Jede der Schnittflächen der Fassung 49 mit einer Halbebene 503 weist eine Kontur 504 auf, aus welcher sich der zur jeweiligen radialen Richtung gehörende Gratpunkt 501 ermitteln lässt. Zu diesem Zweck wird unter der Annahme eines Objekts 60 mit einer ebenen, senkrecht zur optischen Achse 502 stehenden Oberfläche 69 derjenige Punkt 501 der Kontur 504 bestimmt, der am nächsten an der Oberfläche 69 des Objekts 60 liegt. Eine Menge der zu den verschiedenen radialen Richtungen gehörenden Gratpunkte 501 bildet schließlich die Gratlinie 500. Mittels der Gratlinie 500 der Fassung lässt sich zudem der Begriff der Endfläche 46 definieren: Die Endfläche 46 umfasst zumindest das Austrittsfenster 48 des Objektivs 40. Im Falle einer an dieses Austrittsfenster 48 anschließenden Fassung 49 umfasst die Endfläche 46 zusätzlich den von der Gratlinie 500 umschlossenen Bereich der Fassung 49 sowie alle Punkte außerhalb der Gratlinie 500, die im Falle einer ebenen und senkrecht zur optischen Achse 502 ausgerichteten Oberfläche 69 des Objekts 60 einen Abstand d' zum Objekt aufweisen, der bevorzugt weniger als 5 mm, besonders bevorzugt weniger als 1 mm, insbesondere weniger als 300 µm, größer ist als der maximale Abstand d eines Punktes der Gratlinie 500 zur der Oberfläche 69 des Objekts 60. Die Endfläche 46 des Objektivs 40 bildet dabei ein einfach zusammenhängendes Gebiet, das durch die Berandung 47 begrenzt wird. Gemäß dieser Definition liegen die dem Objekt 60 am nächsten liegenden Punkte der Endfläche 46 daher nicht notwendigerweise auf der Gratlinie 500 der Fassung 49. Ein entsprechender Fall ist in Figur 2d skizziert. Figur 2d zeigt eine schematische Darstellung eines besonders bevorzugten Ausführungsbeispiels der Vorrichtung 10, in welcher das Objektiv 40 ein konvex gekrümmtes Austrittsfenster 48 aufweist, während das Austrittsfenster 48 in Fig. 2a bis 2c plan ist. Im Falle des konvex gekrümmten Austrittsfensters 48 des Objektivs 40 können die dem Objekt 60 am nächsten liegenden Punkte auf dem Austrittsfenster 48 selbst liegen. Die vorstehend beschriebene Definition der Endfläche 46 des Objektivs 48 bleibt jedoch von dieser Ausgestaltung unberührt.

In Figur 2b ist eine Aufsicht auf die Endfläche 46 des Objektivs 40 parallel zur optischen Achse 502 dargestellt. Hierbei sind die Gratlinie 500, die Endfläche 46, die Berandung 47, das Austrittsfenster 48 und die Fassung 49 des Objektivs 40 erkennbar.

Figur 2c zeigt eine schematische Darstellung eines besonders bevorzugten Ausführungsbeispiels der Vorrichtung 10, welche das Objektiv 40 aus den Figuren 2a und 2b aufweist. Hierbei wird ein Arbeitsabstand d zwischen der Austrittsfläche 48 des Objektivs 40 und der Oberfläche des Objekts 60 durch die Membran 100 abgeteilt in einen nutzbaren Arbeitsabstand *d*" zwischen der dem Objekt 60 zugewandten Seite der Membran 100 und dem Objekt 60.

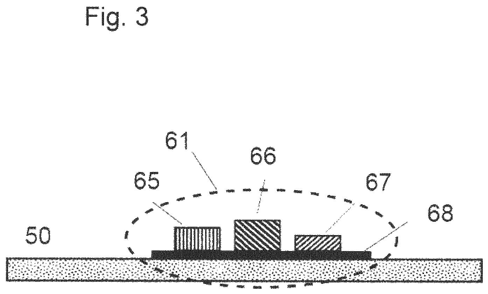

Figur 3 zeigt eine schematische Darstellung eines Objekts in Form eines Multi-Chip-Moduls 61, welches mehrere Teilobjekte 65, 66, 67 umfasst, wobei die Teilobjekte 65, 66, 67 auf einer gemeinsamen Trägerplatte 68 aufgebracht sind, wobei, wie in Figur 3 dargestellt, die Trägerplatte 68 auf dem Objektträger 50 platziert sein kann. Alternativ kann die Trägerplatte 68 selbst den Objektträger 50 bilden (nicht dargestellt).

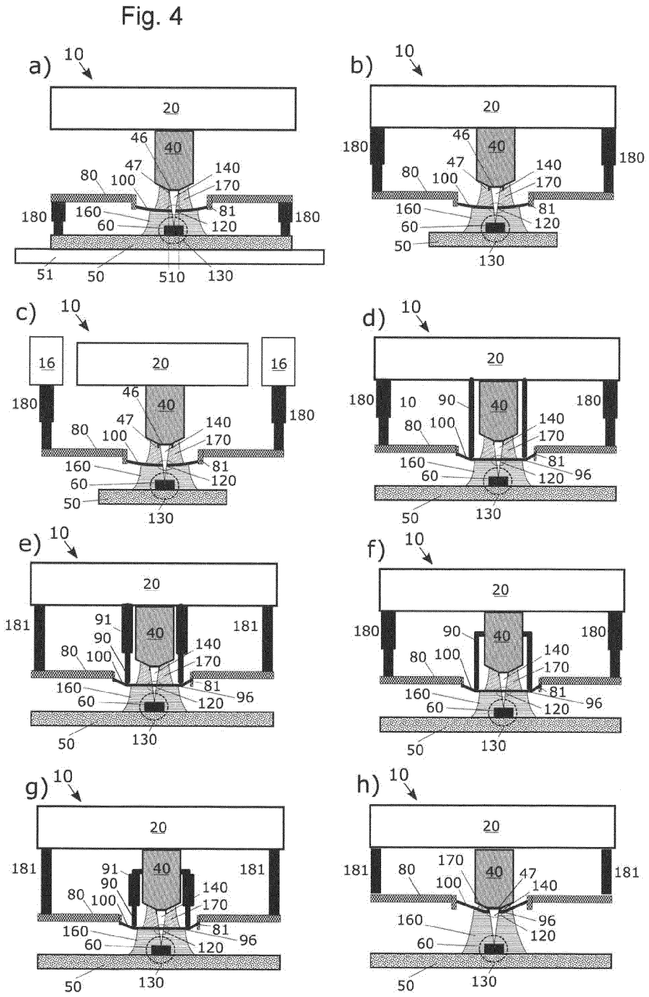

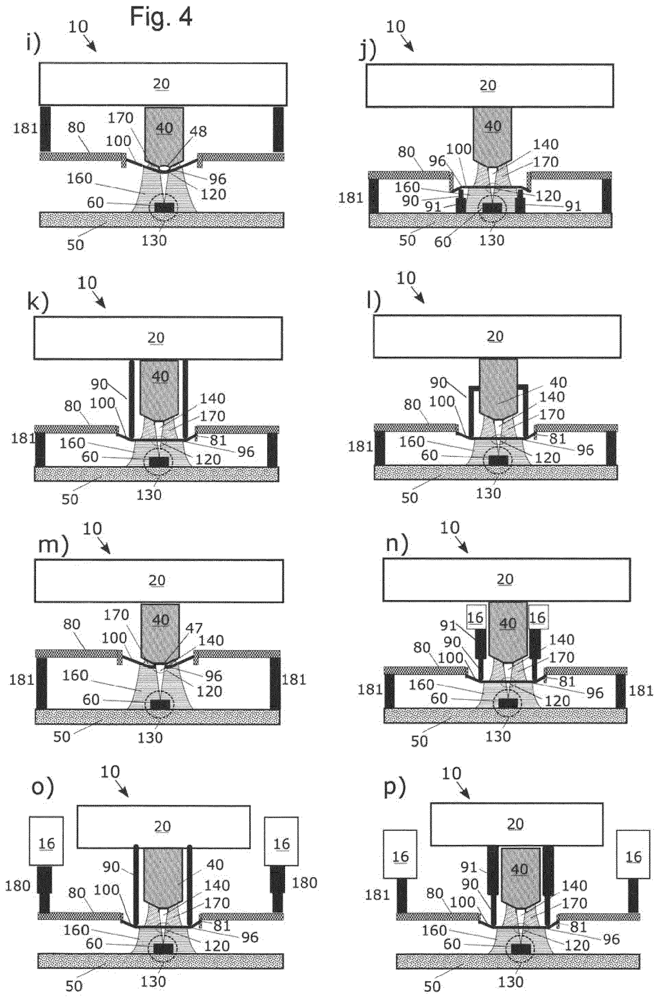

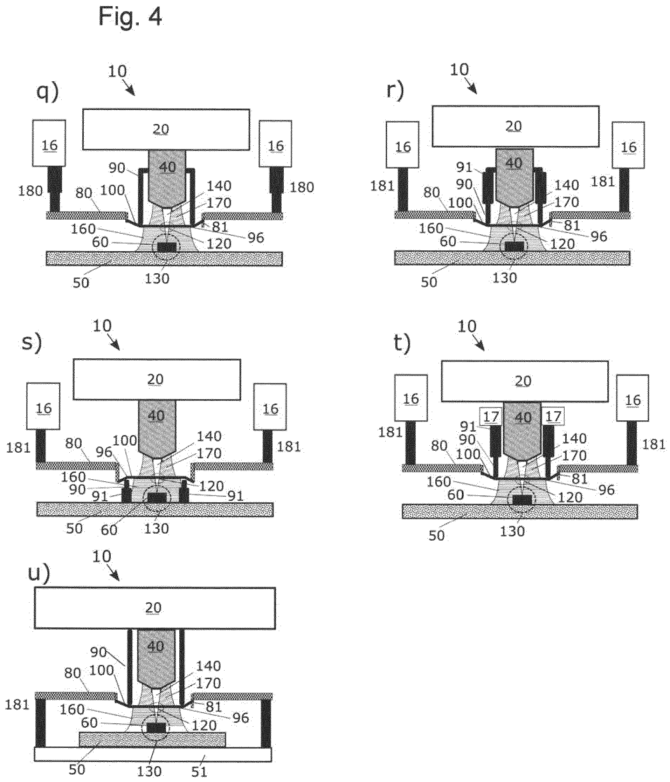

Figur 4 eine schematische Darstellung einer Vielzahl von Ausführungsbeispielen für die Membranhalterung 80 und die Positionierelemente 90. Darüber hinaus sind weitere erfindungsgemäße Ausführungsbeispiele denkbar, die weitere mögliche Kombinationen von Membranhalterungen 80, Membranbefestigungen und Positionierelementen 90 umfassen.

In der Ausführungsform gemäß Figur 4a ist die Membranhalterung 80 am Objektträger 50 befestigt. Hierbei kann die Membranhalterung 80 über einen Aktuator 180 derart beweglich gelagert sein, dass die Membranhalterung 80 in dieser Ausführungsform gleichzeitig als das Positionierelement 90 dienen kann, mit dem der vom Lichtstrahl 140 durchdrungenen Teilbereich 120 der Membran 100 axial bewegt werden kann. In einer alternativen Ausführung kann die Membranhalterung 80 am Objekttisch 51 befestigt werden.

In der Ausführungsform gemäß Figur 4b ist die Membranhalterung 80 am Objektivtisch 20 befestigt. Hierbei kann die Membranhalterung 80 über einen Aktuator 180 derart beweglich gelagert sein, dass die Membranhalterung 80 in dieser Ausführungsform gleichzeitig als das Positionierelement 90 dienen kann, um den vom Lichtstrahl 140 durchdrungenen Teilbereich 120 der Membran 100 axial bewegen zu können.

In der Ausführungsform gemäß Figur 4c) ist die Membranhalterung 80 an einem weiteren Teil der Lithographie-Einrichtung 16 befestigt. Hierbei kann die Membranhalterung 80 über einen Aktuator 180 derart beweglich gelagert sein, dass die Membranhalterung 80 in dieser Ausführungsform gleichzeitig als das Positionierelement 90 dienen kann, mit dem der vom Lichtstrahl 140 durchdrungenen Teilbereich 120 der Membran 100 axial bewegt werden kann. Der weitere Teil der Lithographie-Einrichtung 16 ist im Gegensatz zum Objektiv 40 nicht Bestandteil des optischen Strahlenganges und ist daher geringeren Anforderungen an Präzision und Dynamik der Positionierung unterworfen als beispielsweise das Objektiv, wobei der zur Befestigung verwendete weitere Teil der Lithographie-Einrichtung 16 zumindest einen Teil der auf die Membran 100 wirkenden Kräfte aufnehmen kann.

In der Ausführungsform gemäß Figur 4d) ist die Membranhalterung 80 am Objektivtisch 20 befestigt. Die Positionierelemente 90 sind ebenfalls am Objektivtisch 20 befestigt und erlauben somit, den vom Licht durchdrungenen Teilbereich 120 der Membran 100 synchron mit der Bewegung des Objektivtisches 20 axial zu bewegen. Die Membranhalterung 80 kann hierbei vorzugsweise mittels Aktuatoren 180 und/oder durch ein oder mehrere starre Befestigungselemente am Objektivtisch 20 befestigt werden.

In der Ausführungsform gemäß Figur 4e) ist die Membranhalterung 80 am Objektivtisch 20 mittels eines oder mehrerer Befestigungselemente 181 befestigt. Die Positionierelemente 90 sind mittels Aktuatoren 91 ebenfalls am Objektivtisch 20 befestigt, mit deren Hilfe der vom Licht durchdrungenen Teilbereich 120 der Membran 100 axial bewegt werden kann.

In der Ausführungsform gemäß Figur 4f) ist die Membranhalterung 80 am Objektivtisch 20 befestigt. Die Positionierelemente 90 sind am Objektiv 40 befestigt und erlauben synchron mit der Bewegung des Objektivs 40 den vom Licht durchdrungenen Teilbereich 120 der Membran 100 axial zu bewegen. Die Membranhalterung 80 kann hierbei vorzugsweise mittels Aktuatoren 180 und/oder durch ein oder mehrere starre Befestigungselemente am Objektivtisch 20 befestigt werden.

In der Ausführungsform gemäß Figur 4g) ist die Membranhalterung 80 am Objektivtisch 20 mittels eines oder mehrerer Befestigungselemente 181 befestigt. Die Positionierelemente 90 sind mittels zusätzlicher Aktuatoren 91 am Objektiv 40 befestigt und können über die Aktuatoren 91 den vom Licht durchdrungenen Teilbereich 120 der Membran 100 axial relativ zum Objektiv 40 bewegen.

In der Ausführungsform gemäß Figur 4h) ist die Membranhalterung 80 am Objektivtisch 20 mittels eines oder mehrerer Befestigungselemente 181 befestigt. Als Positionierelement 90 dient hierbei das Objektiv 40 oder ein Teil des Objektivs 40, welches den vom Licht durchdrungenen Teilbereich 120 der Membran 100 axial bewegen kann. Zweite Kontaktstellen 96 zwischen der Membran 100 und dem Objektiv 40 können durch die Berandung 47 der Endfläche 46 des Objektivs 40, durch die Gratlinie 500 der Endfläche 46 des Objektivs 40, oder durch weitere Bestandteile des Objektive 40 gebildet werden.

In der Ausführungsform gemäß Figur 4i) ist die Membranhalterung 80 am Objektivtisch 20 mittels eines oder mehrerer Befestigungselemente 181 befestigt. Als Positionierelement 90 zur axialen Bewegung des vom Licht durchdrungenen Teilbereich 120 der Membran 100 dient hierbei das Objektiv 40 oder ein Teil des Objektivs 40. Verfügt das Objektiv 40 über ein ebenes oder in Richtung des Objekts 60 konvex gewölbtes Austrittsfenster 48, so kann das Austrittsfenster 48, wie auch aus Figur 2d hervorgeht, einen geringeren Abstand zum Objekt 60 aufweisen als die Fassung 49 des Objektivs 40. Im Falle einer flexiblen Membran 100 kann sich diese hierbei an das Austrittsfenster 48 anschmiegen.

In der Ausführungsform gemäß Figur 4j) ist die Membranhalterung 80 am Objektträger 50 mittels eines oder mehrerer Befestigungselemente 181 befestigt. Die Positionierelemente 90 sind mittels eigener Aktuatoren 91 ebenfalls am Objektträger 50 befestigt und können über diese Aktuatoren 91 den vom Licht durchdrungenen Teilbereich 120 der Membran 100 axial bewegen.

In der Ausführungsform gemäß Figur 4k) ist die Membranhalterung 80 am Objektträger 50 mittels eines oder mehrerer Befestigungselemente 181 befestigt. Die Positionierelemente 90 sind am Objektivtisch 20 befestigt und erlauben synchron mit der Bewegung des Objektivtisches 20 den vom Licht durchdrungenen Teilbereich 120 der Membran 100 axial zu bewegen. Analog zu dieser Ausführungsform sind ähnlich zu der Ausführungsform gemäß Figur 4e) weitere Ausführungen denkbar, in welcher die Positionierelemente 90 mit eignen Aktuatoren 91 am Objektivtisch 20 befestigt sind.

In der Ausführungsform gemäß Figur 4l) ist die Membranhalterung 80 am Objektträger 50 mittels eines oder mehrerer Befestigungselemente 181 befestigt. Die Positionierelemente 90 sind am Objektiv 40 befestigt und erlauben synchron mit der Bewegung des Objektivs 40 den vom Licht durchdrungenen Teilbereich 120 der Membran 100 axial zu bewegen. Analog zu dieser Ausführungsform sind ähnlich zu der Ausführungsform gemäß Figur 4g) weitere Ausführungen denkbar, in welcher die Positionierelemente 90 mit dedizierten Aktuatoren 91 am Objektiv 40 befestigt sind.

In der Ausführungsform gemäß Figur 4m) ist die Membranhalterung 80 am Objektträger 50 mittels eines oder mehrerer Befestigungselemente 181 befestigt. Als Positionierelement 90 dient hierbei das Objektiv 40 oder ein Teil des Objektivs 40, welches den vom Licht durchdrungenen Teilbereich 120 der Membran 100 axial bewegen kann. Die Kontaktstellen 96 zwischen der Membran 100 und dem Objektiv 40 werden durch die Berandung 47 der Endfläche 46 des Objektivs 40, durch die Gratlinie 500 der Endfläche 46 des Objektivs 40, oder durch einen anderen Bestandteil des Objektivs 40 gebildet. Analog zu der Ausführungsform gemäß Figur 4i) kann das Austrittsfenster 48 einen geringeren Abstand zum Objekt 60 aufweisen als die Fassung 49 des Objektivs 40. Im Falle einer flexiblen Membran 100 kann sich diese auch hier an das Austrittsfenster 48 anschmiegen.

In der Ausführungsform gemäß Figur 4n) ist die Membranhalterung 80 am Objektträger 50 mittels eines oder mehrerer Befestigungselemente 181 befestigt. Die Positionierelemente 90 sind mittels Aktuatoren 91 an einem weiteren Teil der Lithographie-Einrichtung 16 befestigt und können mit den Aktuatoren 91 den von Licht durchdrungenen Teilbereich 120 der Membran 100 axial bewegen. Analog zu dieser Ausführungsform sind auch Ausführungen denkbar, in welchen die Membranhalterung 80 am Objektivtisch 20, am Objekttisch 51, oder an einem weiteren Teil der Lithographie-Einrichtung 16 befestigt sein kann.

In der Ausführungsform gemäß Figur 4o) ist die Membranhalterung 80 an einem weiteren Teil der Lithographie-Einrichtung 16 befestigt. Die Positionierelemente 90 sind am Objektivtisch 20 befestigt und erlauben, den vom Licht durchdrungenen Teilbereich 120 der Membran 100 synchron mit der Bewegung des Objektivtischs 20 axial zu bewegen. Die Membranhalterung 80 kann hierbei mittels Aktuatoren 180 und/oder durch ein oder mehrere starre Befestigungselemente befestigt werden.

In der Ausführungsform gemäß Figur 4p) ist die Membranhalterung 80 an einem weiteren Teil der Lithographie-Einrichtung 16 befestigt. Die Positionierelemente 90 verfügen über Aktuatoren 91, die am Objektivtisch 20 befestigt sind und die es ermöglichen, den vom Licht durchdrungenen Teilbereich 120 der Membran 100 axial relativ zum Objektiv 40 zu bewegen.

In der Ausführungsform gemäß Figur 4q) ist die Membranhalterung 80 an einem weiteren Teil der Lithographie-Einrichtung 16 befestigt. Die Positionierelemente 90 sind am Objektiv 40 befestigt und erlauben es, den vom Licht durchdrungenen Teilbereich 120 der Membran 100 synchron mit der Bewegung des Objektivs 40 axial zu bewegen. Die Membranhalterung 80 kann hierbei vorzugsweise mittels Aktuatoren 180 und/oder durch ein oder mehrere starre Befestigungselemente befestigt werden.

In der Ausführungsform gemäß Figur 4r) ist die Membranhalterung 80 an einem weiteren Teil der Lithographie-Einrichtung 16 befestigt. Die Positionierelemente 90 verfügen über Aktuatoren 91, die am Objektiv 40 befestigt sind und die ermöglichen, den vom Licht durchdrungenen Teilbereich 120 der Membran 100 relativ zum Objektiv 40 axial zu bewegen. In der Ausführungsform gemäß Figur 4s) ist die Membranhalterung 80 an einem weiteren Teil der Lithographie-Einrichtung 16 befestigt. Die Positionierelemente 90 verfügen über Aktuatoren 91, die am Objektträger 50 befestigt sind, und ermöglichen es, den vom Licht durchdrungenen Teilbereich 120 der Membran 100 axial zu bewegen.

In der Ausführungsform gemäß Figur 4t) ist die Membranhalterung 80 an einem weiteren Teil der Lithographie-Einrichtung 16 befestigt. Die Positionierelemente 90 verfügen über Aktuatoren 91, die am selben Teil der Lithographie-Einrichtung 16 oder einem weiteren Teil der Lithographie-Einrichtung 17 befestigt sind, und ermöglichen es, den vom Licht durchdrungenen Teilbereich 120 der Membran 100 axial zu bewegen.

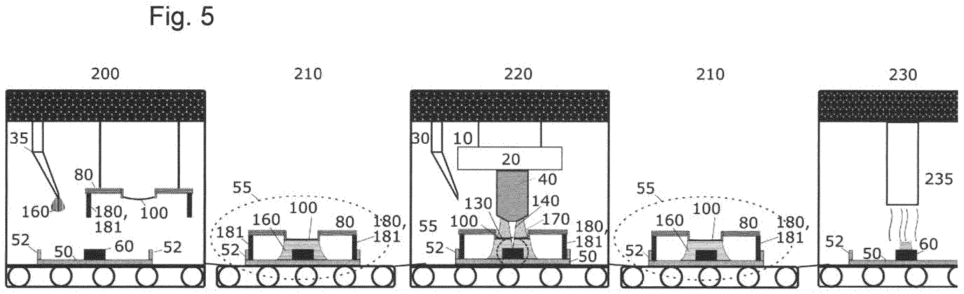

Figur 5 zeigt eine schematische Darstellung einer Einrichtung, welche mehrere Vorrichtungen 10 umfasst, welche jeweils eine ausgewählte Funktion ausführen können. In einer ersten als Handhabungseinheit für Immersionsmedien ausgeführten Einrichtung 200 kann das Immersionsmedium, in Form eines flüssigen Photoresists 160, mittels einer Dispenseinheit 35 auf das Objekt 60 aufgebracht werden. Die Handhabungseinheit 200 für Immersionsmedien kann ferner dazu eingerichtet sein, das mit der einer Immersionsflüssigkeit 160 versehene Objekt mit einer bevorzugt als geschlossener Container ausgeführten Objekttransporteinheit 55 zu umgeben, die beispielsweise eine Membranhalterung 80, eine Membran 100, einen Objektträger 50 und ein Befestigungselement 181 aufweisen, wobei alternativ oder zusätzlich ein bewegliches Element oder Aktuator 180 zur Befestigung des Membranhalters 80 am Objektträger 50 zum Einsatz kommen kann. Ein Transport des Objekts 60 bzw. der Objekttransporteinheit 55 von der Handhabungseinheit 200 zur Lithographie-Einheit 220 kann mittels eines Fördersystem 210 unter normalen Umgebungsbedingungen erfolgen. In der Lithographie-Einheit 220 kann optional mittels einer Dispenser-Einheit 30 eine weitere Indexflüssigkeit 170 zwischen der Membran 100 und dem Objektiv 40 aufgebracht werden, bevor eine Bearbeitung des Objekts 60 und/oder eine optische Charakterisierung des Objekts 60 durchgeführt werden. Im Falle einer lithographischen Bearbeitung kann das Objekt 60 bzw. die Objekttransporteinheit 55 in einem weiteren Schritt mit Hilfe eines weiteren Fördersystems 210 zu einer gesonderten Entwicklereinheit 230 transferiert werden. In der Entwicklereinheit 230 kann die Objekttransporteinheit 55 wieder geöffnet werden, um nicht polymerisierte Teile des Photoresists vom Objekt 60 mittels einer Spüleinheit 235 zu entfernen. Andere Ausführungen der mehrere Vorrichtungen 10 umfassenden Einrichtung und ihrer jeweiligen Funktion sind möglich.

Die in Figur 5 schematisch dargestellte Einrichtung skizziert einen Spezialfall einer Anwendung der erfindungsgemäßen Vorrichtung 10 und einer technischen Umsetzung des erfindungsgemäßen Verfahrens, wobei die der lithographischen Bearbeitung nachgelagerten Entwicklungsschritte nicht zwingend enthalten sein müssen. Da ein besonderer Vorteil der erfindungsgemäß verwendeten Membran 100 darin liegt, das Volumen der Immersionsflüssigkeit 160 zum Objektiv 40 hin abzuschließen, kann die Membran 100 gleichzeitig als Schutz für die Immersionsflüssigkeit 160 und das Objekt 60 dienen. Damit kann die Membran 100 die Funktion einer Abdeckung übernehmen, die das Objekt 60 und die mit ihm in Kontakt stehende Immersionsflüssigkeit vorzugsweise vor Verschmutzungen, vor Kontakt mit Sauerstoff oder mit Luftfeuchtigkeit oder vor einer unbeabsichtigten Belichtung durch kurzwelliges Umgebungslicht schützen kann. Insbesondere kann die Membran auch elektrisch leitfähig sein und die Komponenten vor elektrostatischer Entladung (engl. *electrostatic discharge,* ESD) schützen. Zum Schutz des Objekts 60 und der mit diesem in Kontakt stehenden Immersionsflüssigkeit 160 können diese in einer Objekttransporteinheit 55 platziert werden, welche durch Aufbringen der Membran 100 und/oder der Membranhalterung 80 zu einem möglichst dicht abgeschlossenen Container ausgeführt wird. Der in Figur 5 schematisch dargestellte beispielhafte Container umfasst hierbei den Objektträger 50, das in eine Seitenwand 52 des Objektträgers 50 integrierte oder diese bildende Befestigungselement 181, die Membranhalterung 80 und die Membran 100, wobei der Container zur Aufnahme des Objekts 60 und der Immersionsflüssigkeit 160 eingerichtet ist. Ein in dem Container verbleibender Freiraum kann optional durch ein Schutzgas gefüllt werden, um einen Kontakt der Immersionsflüssigkeit 160 mit in der Umgebungsatmosphäre vorhandenem Sauerstoff oder Feuchtigkeit zu vermeiden. Durch die Verwendung der Objekttransporteinheit 55 mit Schutzfunktion lassen sich die einzelnen Schritte zur optischen Charakterisierung oder Bearbeitung des Objekts 60 in räumlich voneinander getrennten Funktionseinheiten durchführen, wobei das Objekt 60 bevorzugt zusammen mit der Immersionsflüssigkeit 160 zwischen den Funktionseinheiten unter normalen Umgebungsbedingungen transferierbar ist, so dass, wie oben erwähnt, im durchquerten Raumbereich keine besondere Anforderungen im Hinblick auf Sauberkeit (z.B. Reinraumklassen), Belichtung (z.B. sog. Gelblichtumgebung), atmosphärischer Randbedingungen (z.B. regulierte Luftfeuchtigkeit) und/oder ESD-Schutz erforderlich sind. Der Transfer des durch die Membran 100 geschützten Objekts 60 zwischen den verschiedenen Funktionseinheiten ist insbesondere vorteilhaft im Hinblick auf die Auslegung industrieller Fertigungssysteme, da für jeden Schritt eine spezialisierte Einrichtung genutzt werden kann und da es insbesondere möglich wird, die optischen Lithographie-Prozesse von nasschemischen Prozessen zu trennen.

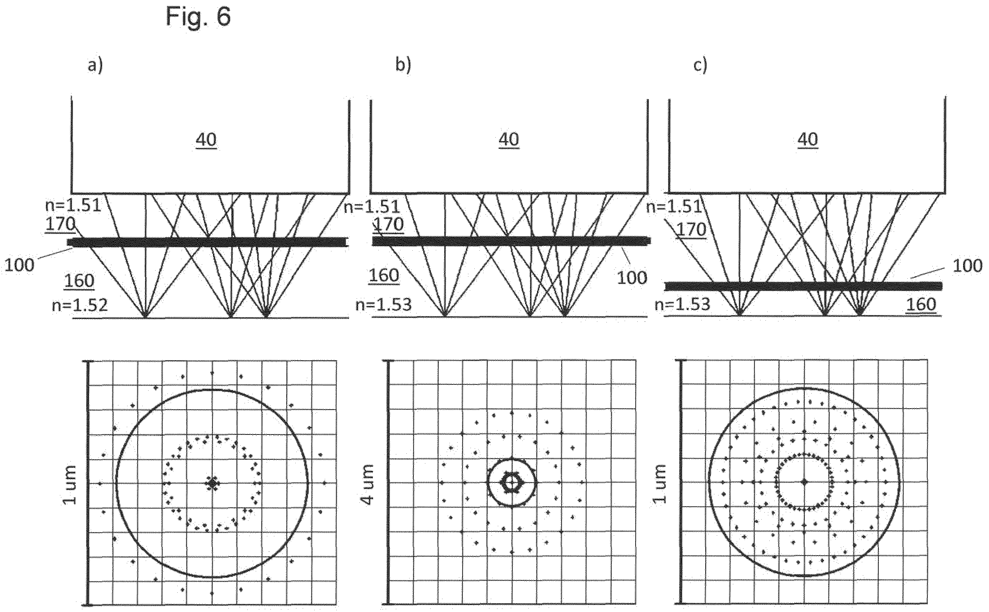

Figur 6 zeigt Ergebnisse einer Simulation der Abbildungsqualität der erfindungsgemäßen Vorrichtung 10. Die Vorrichtung 10 umfasst hierbei das Objektiv 40 und die Membran 100, welche zwei unterschiedliche Immersionsflüssigkeiten, den flüssigen Photoresist 160 und eine Immersionsflüssigkeit 170, voneinander trennt. Im Rahmen der Simulation wurde objektseitig eine Fokussierung des Lichts 140 strahlenoptisch simuliert und in einem sog. "Spot-Diagramm" dargestellt. Das Spotdiagram zeigt die Position verschiedener Strahlen eines Strahlbündels in der Brennebene des Objektivs 40. Der Bereich innerhalb des jeweils eingezeichneten durchgezogenen Kreises kennzeichnet die Beugungsbegrenzung. In der Simulation gemäß Figur 6a) ist der Brechungsindex 1,52 beider Immersionsflüssigkeiten 160, 170 gut auf das Objektiv 40 angepasst, so dass ein nahezu ein beugungsbegrenzter Fokus erreicht wird. In der Simulation gemäß Figur 6b) tritt eine beabsichtigte oder unbeabsichtigte Änderung im Brechungsindex der Immersionsflüssigkeit 160 auf 1,53 ein, beispielsweise durch Alterung oder durch die Verwendung einer anderen Substanz mit leicht abweichender Zusammensetzung. Bei derselben Position der Membran 100 ist der Fokus nun deutlich größer geworden und nicht mehr beugungsbegrenzt. Durch ein Verschieben der Membran 100 entsprechend der Simulation gemäß Figur 6c) kann jedoch wieder ein beugungsbegrenzter Fokus erreicht werden und die Änderung des Brechungsindex' auf 1,53 kann damit ausgeglichen werden. Eine optimale Einstellung der axialen Position der Membran 100 erlaubt es also, Aberrationen zu kompensieren, die sich in der Lithographie beispielsweise aus leichten Variationen des Brechungsindex des als Immersionsmedium verwendeten Photoresists ergeben.

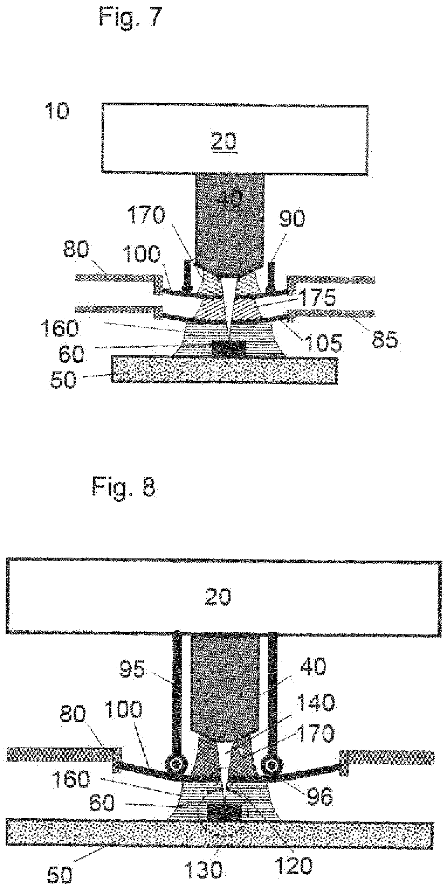

Figur 7 zeigt eine schematische Darstellung eines weiteren, bevorzugten Ausführungsbeispiels der erfindungsgemäßen Vorrichtung 10, welches eine zweite Membran 105 aufweist, die an einer zweiten Membranhalterung 85 befestigt ist. Zusätzlich zu der Immersionsflüssigkeit 170 oder der Kombination aus dem Photoresist 160 und der Immersionsflüssigkeit 170 wird hier eine weitere Immersionsflüssigkeit 175 verwendet. Die Immersionsflüssigkeiten 170, 175 und der Photoresist 160 können verschiedene Brechungsindizes, Dispersionscharakteristika und/oder Viskositäten aufweisen, wodurch zusätzliche Freiheitsgrade bei einer Kompensation von Aberrationen ermöglicht werden. Mindestens eine der Membranen 100, 105 lässt sich durch das mindestens eine Positionierelement 90 in axialer Richtung positionieren.

Figur 8 zeigt eine schematische Darstellung eines weiteren, bevorzugten Ausführungsbeispiels der erfindungsgemäßen Vorrichtung 10, in welche Kräfte zur Verformung und zur axialen Positionierung der Membran 100 oder des lichtdurchdrungenen Teilbereichs 120 der Membran 100 durch ein Positionierelement 95 eingebracht werden, das mit dem Objektivtisch 20 oder mit dem Objektiv 40 verbunden ist. Rollen oder Gleitflächen an dem Kontaktstellen 96 zwischen dem Positionierelement 95 und der Membran 100 können für eine geringe Reibung bei einer lateralen Bewegung der Membran 100 relative zu den Positionierelementen 95 sorgen.

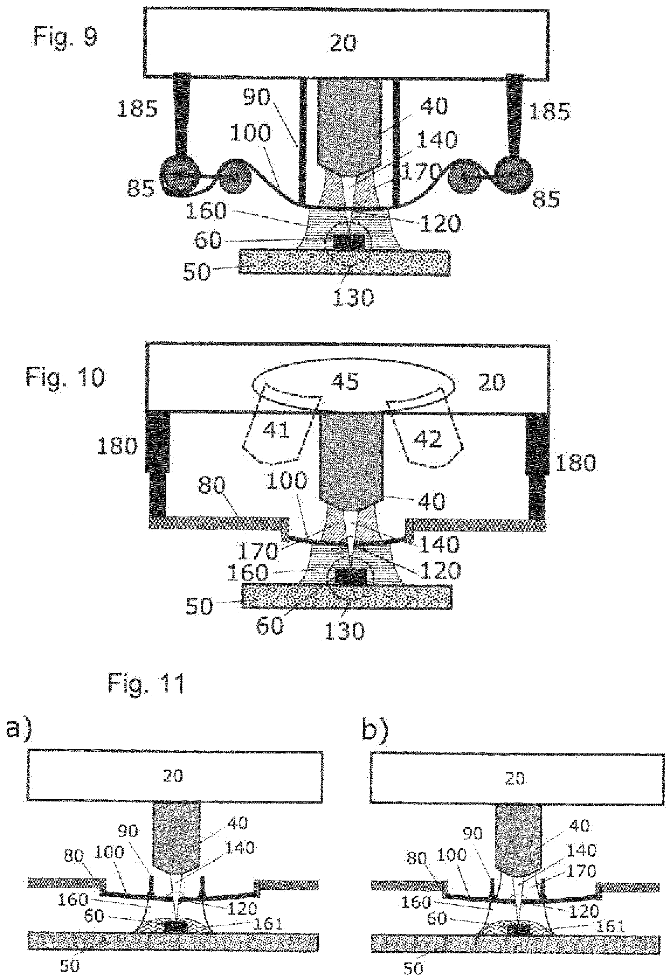

Figur 9 zeigt eine schematische Darstellung eines weiteren, bevorzugten Ausführungsbeispiels der erfindungsgemäßen Vorrichtung 10, in welcher die Membranhalterung 80 an dem Objektivtisch 20 befestigt ist. Die Membranhalterung 80 umfasst hierbei eine Anordnung aus Rollen und/oder Gleitflächen 85, welche durch Befestigungselemente 185 an dem Objektivtisch 20 angebracht sind und welche eine automatische Abführung und Zuführung weiterer Bereiche, insbesondere sauberer Bereiche, der Membran 110 ermöglicht. Die axiale Positionierung des lichtdurchdrungenen Teilbereichs 120 der Membran 100 kann hier über einen Mechanismus in der Membranhalterung 80, beispielsweise durch Spannen der Rollen 85, erfolgen. Alternativ oder zusätzlich können Positionierelemente 90 eingesetzt werden, um die axiale Position des lichtdurchdrungenen Teilbereichs 120 der Membran einzustellen.

Figur 10 zeigt eine schematische Darstellung eines weiteren, bevorzugten Ausführungsbeispiels der erfindungsgemäßen Vorrichtung 10, in welcher die Membranhalterung 80 ebenfalls am Objektivtisch 20 befestigt ist. Dies kann vorzugsweise eine Verwendung verschiedener Objektive 40, 41, 42 ermöglichen, welche beispielsweise mittels eines Revolvermechanismus' 45 auswechselbar sind, ohne dass hierdurch die Position der Membran 100 geändert wird. Die Positionierung des lichtdurchdrungenen Teilbereichs 120 der Membran 100 kann über bewegliche Elemente 180 oder Aktuatoren erfolgen. Eine optional zwischen der Membran 100 und dem jeweils im Einsatz befindlichen Objektiv 40, 41 oder 42 verwendete weitere Immersionsflüssigkeit 170 kann nach einem Wechsel des Objektivs 40, 41 oder 42 durch eine in die Lithographie-Einheit 220 integrierte Dispenser-Einheit (nicht dargestellt) zugeführt werden.

Figur 11 zeigt eine schematische Darstellung eines Ausführungsbeispiels, das nicht Teil der vorliegenden Erfindung ist, wobei die Vorrichtung 10 einen festen Photoresist 161 umfasst, der das Objekt 60 überdeckt. Aus Figur 11a) geht hervor, dass eine erste Indexflüssigkeit 160, die an den Brechungsindex des festen Photoresists angepasst ist, zusammen mit der Membran 100 eine definierte optische Grenzfläche darstellt, so dass das Licht 140 über ein Trockenobjektiv eingekoppelt werden kann. Gemäß Figur 11b) kann eine weitere Immersionsflüssigkeit 170 zwischen der Membran und dem Objektiv 40 verwendet werden, um eine hohe NA zu erreichen und/oder um Aberrationen durch Fehlanpassung des Brechungsindex zu kompensieren. Alternativ oder zusätzlich kann die weitere Immersionsflüssigkeit 170 auch eine sich von der ersten Indexflüssigkeit 160 unterscheidende Viskosität aufweisen.

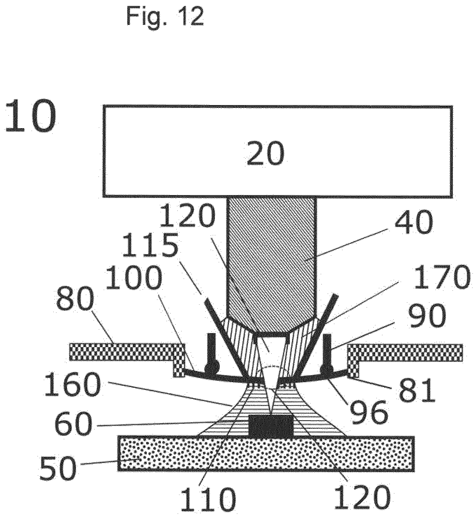

Figur 12 zeigt eine schematische Darstellung eines weiteren, bevorzugten Ausführungsbeispiels der erfindungsgemäßen Vorrichtung 10, in welche die Membran 100 eine laterale Strukturierung 110 aufweist. Die lateralen Strukturierungen 110 der Membran 100 können dazu verwendet werden, um Benetzungseigenschaften der Membran 100 hinsichtlich einer oder mehrerer Immersionsflüssigkeiten 160, 170 zu optimieren. In einer weiteren Ausführungsform können ein oder mehrere Führungselemente 115 dazu eingesetzt werden, um eine laterale Ausbreitung der Immersionsflüssigkeit 170 einzuschränken.

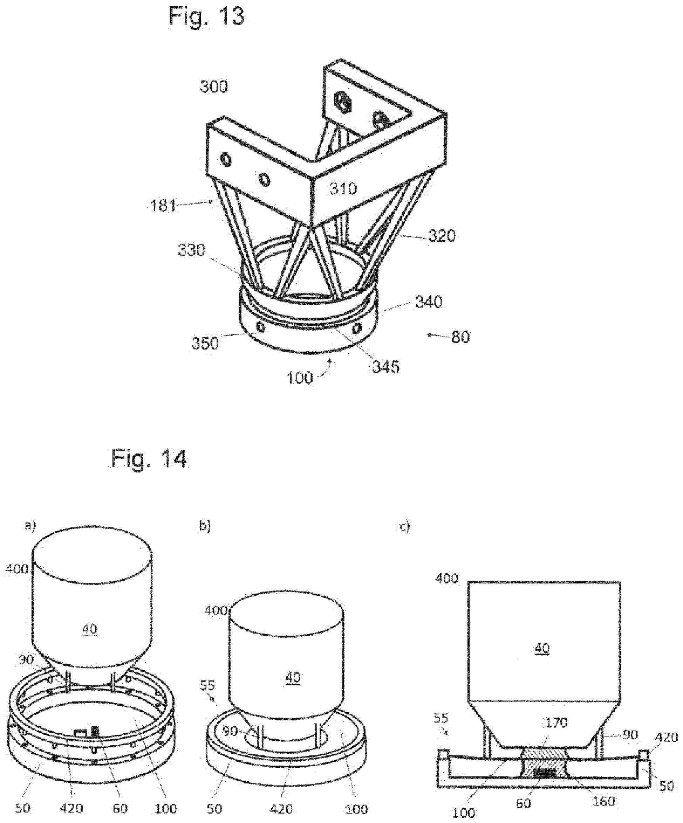

Figur 13 zeigt eine schematische Darstellung eines bevorzugten Ausführungsbeispiels einer Anordnung für eine bevorzugte Membranhalterung 300 und ihre Positionierung. Das Ausführungsbeispiel gemäß Figur 3 beruht auf dem Ausführungsbeispiel gemäß Figur 4b, wobei hier anstelle der Aktuatoren 180 starre Befestigungselemente 181 verwendet werden. Eine Membran 100, welche vorzugsweise in Form einer dünnen Folie bereitgestellt wird (hier nicht dargestellt), wird über einen inneren Ring 330 gelegt. Ein äußerer Ring 340 wird hier zur Fixierung der Membran 100 über den inneren Ring 330 geschoben. Die konischen Flächen 345 im inneren Ring 330 und am äußeren Ring 340 erlauben es, Folien mit unterschiedlichen Dicken zu spannen. Die Fixierung des äußeren Rings 340 am inneren Ring 330 erfolgt hier beispielhaft mittels Klemmung oder durch Schrauben in entsprechenden Gewindelöchern 350. Eine weitere Klemmvorrichtung 310 kann dazu dienen, die Membranhalterung 300 am Objektivtisch 20 zu befestigen. Feste Streben 320 können die Klemmvorrichtung 310 mit dem inneren Ring 330 der Membranhalterung 300 verbinden. Die auf einer Seite offene Klemmvorrichtung 310 erlaubt einen Wechsel der Halterung 300 und der Membran 100, ohne dass das Objektiv 40 ausgebaut werden muss. Die Membranhalterung 300 kann einfach über den Objektivtisch 20 geschoben werden, um so die Membran 100 unter dem Objektiv 40 zu positionieren. Die Membranhalterung 300 wird durch die Ringe 330, 340 ausgebildet, während die Streben 320 die starren Befestigungselemente 181 darstellen. Die axiale Positionierung des lichtdurchdrungenen Teilbereichs 120 der Membran 100 erfolgt hier entweder allein durch die Membranhalterung 300 oder durch die Berandung 47 oder die Gratlinien 500 des Objektivs 40.

Das Ausführungsbeispiel gemäß Figur 13 kann dahingehend erweitert werden, dass eines der Befestigungselemente 181 oder der Objektivtisch 20 mit einem Sensor (nicht dargestellt) versehen wird, mit dem etwaige Kollisionen der Membranhalterung 300 oder der Membran 100 mit dem Objekt 60 oder dem Objektträger 50 erfasst werden können, bevor das wesentlich empfindlichere Objektiv 40 berührt oder beschädigt wird. Eine unerwünschte Berührung oder Kollision von zwei Komponenten kann beispielsweise durch einen mechanischen Sensor detektiert werden oder durch einen elektrischen Sensor, der vorzugsweise einen elektrischen Widerstand zwischen den beiden Komponenten erfassen und eine Berührung oder Kollision an einer Verringerung des elektrischen Widerstandes erkennen kann. Hierzu kann es sich anbieten, eine Membran 100 mit einer hinreichenden elektrischen Leitfähigkeit zu verwenden, die eine Detektion einer Berührung oder Kollision der Membran mit einer anderen Teilkomponente der Vorrichtung 10 ermöglicht.

Figur 14 zeigt eine schematische Darstellung eines weiteren Ausführungsbeispiels, das nicht Teil der vorliegenden Erfindung ist. Hierbei befindet sich das Objekt 60 auf einem Objektträger 50, welcher mit einer Membran 100, die in einem Ringhalter 420 gespannt ist, abgedeckt werden kann. Die Aufsicht gemäß Figur 14a) zeigt diese Ausführung vor dem Zusammenbau. In der Aufsicht gemäß Figur 14b) bildet die Membran 100 zusammen mit dem Objektträger 50 eine als geschlossener Container ausgeführte Objekttransporteinheit 55, welche das Objekt 60 sowie die zuvor auf das Objekt 60 aufgebrachte Immersionsflüssigkeit 160 vor Umgebungseinflüssen schützen kann. Figur 14c) zeigt einen Querschnitt durch die erfindungsgemäße Vorrichtung 10, in welcher das mindestens eine Positionierelement 90 durch eine elastische Verformung der Membran 100 einen optimalen Arbeitsabstand zwischen dem Objekt 60, dem Objektiv 40 und der 100 Membran einstellen kann. In einer alternativen Ausführung (nicht dargestellt) kann die axiale Positionierung des lichtdurchdrungenen Teilbereichs 120 der Membran 100 auch durch die Berandung 47 oder die Gratlinien 500 des Objektivs 40 erreicht werden, so dass auf zusätzliche am Objektiv 40 angebrachte Positionierelemente 90 verzichtet werden kann.

Basierend auf der Darstellung in Figur 14 kann ein Ausführungsbeispiel für eine Verwendung des erfindungsgemäßen Verfahrens in der 3D-Lithographie skizziert werden. Das Objekt 60 wird gemäß Schritt a) auf dem Objektträger 50 befestigt. Gemäß Schritt b) wird in einer ersten Funktionseinheit ein Photoresist als das Immersionsmedium 160 für Zweiphotonen-Polymerisation auf das Objekt 60 aufgebracht. Dies erfolgt händisch oder mittels eines separaten Dispensers 35, welcher zusätzlich eine Inertgas-Atmosphäre bereitstellen kann. Nach dem Aufbringen der Immersionsflüssigkeit wird in der ersten Funktionseinheit die Membran 100, welche an einem Ringhalter 420 befestigt ist, gemäß Schritt c) derart auf den Objektträger 50 aufgebracht, dass dieser vorzugsweise luftdicht abgeschlossen wird. Dadurch wird analog zum Ausführungsbeispiel gemäß Figur 5 eine Objekttransporteinheit 55 bereitgestellt, die das Objekt 60 vor der Umgebungsatmosphäre schützen kann. Bei der Verwendung einer Membran 100, welche im UV-Bereich nicht transparent ist, kann das Objekt 60 auch durch Bereiche transportiert werden, in welchen keine reine Gelblichtbeleuchtung bereitgestellt wird. Bei der Verwendung einer Membran 100, welche elektrisch leitfähig ist, kann das Objekt 60 auch durch Bereiche transportiert werden, die nicht ESD-geschützt sind; hierfür sollte die Objekttransporteinheit 55 entsprechend ausgelegt sein. Hieran anschließend wird der Objektträger 50 mit der Membran 100 in eine weitere als Lithographie-Einheit 220 ausgebildete Funktionseinheit transferiert, in der die lithographische Bearbeitung und/oder die optische Charakterisierung stattfindet. Die Objekttransporteinheit 55 bleibt in dieser Funktionseinheit weiterhin verschlossen, und es wird optional eine zweite Immersionsflüssigkeit 170 zwischen der Membran 100 und dem Objektiv 40 aufgebracht. Danach wird das Objektiv 40 gemäß Schritt d) an die Membran 100 angenähert. Da die Ringhalterung 420 einen größeren Durchmesser als das Objektiv 40 aufweist, kann durch die Positionierelemente 90, welche hier an dem Objektiv 40 befestigt sind, der lichtdurchdrungene Teilbereich 120 der Membran 100 synchron mit der axialen Bewegung des Objektivs 40 in eine günstige Position zwischen dem Objekt 60 und dem Objektiv 40 gebracht werden. Ist die gewünschte axiale Position zwischen dem Objektiv 40 und dem Objekt 60 gemäß Schritt e) erreicht, kann nun die Bearbeitung und/oder Charakterisierung des Objekts 60 gemäß Schritt f) erfolgen, wobei die Bearbeitung insbesondere eine 3D-Strukturierung mittels 3D-Lithographie umfassen kann. Die Teilschritte e) und f), welche die Positionierung der Membran 100 und die Strukturierung des Objekts 60 umfasst, kann einfach oder mehrfach, beispielsweise an verschiedenen Stellen des Objekts 60 und damit der Membran 100, ausgeführt werden. Nach erfolgter 3D-Lithographie gemäß Schritt f) bleibt die Objekttransporteinheit 55 verschlossen und wird in eine weitere als Entwickler-Einheit 230 ausgeführte Funktionseinheit transferiert. In dieser Funktionseinheit können die Membran 100 mit der Ringhalterung 420 abgenommen und der nicht-polymerisierte Photoresist in einem Entwicklungsprozess entfernt werden.

### Bezugszeichenliste

- 10: Vorrichtung
- 15: optische Charakterisierungs- oder Bearbeitungs-Einheit (Lithographie-Einheit)
- 16, 17: weiterer Teil der Lithographie-Einheit
- 20: Objektivtisch
- 30: Dispenser-Einheit
- 40, 41, 42: Objektiv
- 45: Revolvermechanismus
- 46: Endfläche
- 47: Berandung
- 48: Austrittsfenster
- 49: Fassung
- 50: Objektträger
- 51: Objekttisch
- 52: Seitenwand des Objektträgers
- 55: Objekttransporteinheit
- 60: Objekt
- 61: Multi-Chip-Modul
- 65, 66, 67: Teilobjekt
- 68: Trägerplatte
- 69: Oberfläche des Objekts
- 80, 85: Membranhalterung
- 81: erste Kontaktstelle
- 85: Rollen und/oder Gleitflächen
- 90, 95: Positionierelement
- 91: Aktuator
- 96: zweite Kontaktstelle
- 100, 105: Membran
- 110: laterale Strukturierungen
- 115: Führungselement
- 120: lichtdurchdrungener Teilbereich
- 130: Teil des Objekts
- 140: (Laser-)Licht
- 160, 170, 175: Immersionsmedium (Immersionsflüssigkeit, Photoresist)
- 161: Fester Photoresist
- 180: bewegliches Element (Aktuator)
- 181, 185: Befestigungselement
- 200: Dispenser
- 210: Fördersystem
- 220: Lithographie-Einheit
- 230: Entwicklereinheit
- 235: Spüleinheit
- 300: Membranhalterung
- 310: Klemmvorrichtung
- 320: Strebe
- 330: innerer Ring
- 340: äußerer Ring
- 345: konische Flächen
- 350: Gewindeloch
- 400: weiteres bevorzugtes Ausführungsbeispiel
- 420: Ringhalterung
- 500: Gratlinie
- 501: Gratpunkt
- 502: optische Achse
- 503: Halbebene
- 504: Kontur
- 510: Mantelfläche

## Patentansprüche

1. Vorrichtung (10) zur optischen Bearbeitung eines Objekts (60), umfassend
- einen Objektträger (50) zur Aufnahme eines Objekts (60);
- eine optische Bearbeitungs-Einheit (15), umfassend zumindest eine Einrichtung zur Erzeugung oder zum Empfang von Licht (140) und ein Objektiv (40) zur Belichtung des Objekts (60) mittels des Lichts (140) oder zur Erfassung des Lichts (140) von dem Objekt (60), wobei das Objektiv (40) eine dem Objektträger (50) zugewandte Endfläche (46) aufweist, wobei die Endfläche (46) über eine Berandung (47) verfügt, wobei das Objektiv (40) ferner eine optische Achse (502) festlegt;
- mindestens eine zwischen dem Objektiv (40) und dem Objektträger (50) eingebrachte Membran (100), wobei die Membran (100) einen zur Durchdringung durch das Licht (140) eingerichteten Teilbereich (120) aufweist, wobei zumindest der Teilbereich (120) der Membran (100) beweglich in axialer Richtung in Bezug auf die optische Achse (502) ist,
- mindestens eine Membranhalterung (80) zur Halterung der mindestens einen Membran (100), und
- mindestens ein Immersionsmedium (160), welches zumindest zwischen der Membran (100) und dem Objektträger (50) eingebracht ist,
wobei die Membran (100) und die Membranhalterung (80) an einer Stelle außerhalb des Objektivs befestigt sind, und die Membran (100) derart an der Membranhalterung (80) angeordnet ist, dass erste Kontaktstellen (81) zwischen der Membran (100) und der Membranhalterung (80) auf oder außerhalb einer Mantelfläche (510) liegen, welche durch eine geometrische Extrusion der Berandung (47) des Objektivs (40) parallel zur optischen Achse (502) ausgebildet ist,
**dadurch gekennzeichnet,**
**dass** das Immersionsmedium (160) in Form eines flüssigen Photoresists vorliegt.

2. Vorrichtung (10) nach dem vorangehenden Anspruch, wobei die Membranhalterung (80) verbunden ist mit einem zur Aufnahme des Objektivs (40) ausgebildeten Objektivtisch (20) oder mit einem zur Aufnahme des Objektträgers (50) ausgebildeten Objekttisch (51) oder mit dem Objektträger (50) oder mit einem weiteren Teil (16, 17) der optischen Bearbeitungs-Einheit (15).

3. Vorrichtung (10) nach einem der vorangehenden Ansprüche, wobei das Objektiv (40) derart austauschbar eingerichtet ist, dass ein Austausch des Objektivs (40) durchführbar ist, während die Membranhalterung (80) und die Membran (100) an der Vorrichtung (10) verbleiben.

4. Vorrichtung (10) nach einem der vorangehenden Ansprüche, ferner umfassend mindestens ein Positionierelement (90, 91), wobei das Positionierelement (90, 91) zur Bewegung der Membran (100) in axialer Richtung in Bezug auf die optische Achse (502) eingerichtet ist, wobei das Positionierelement (90, 91) bevorzugt derart angeordnet ist, dass zweite Kontaktstellen (96) zwischen der Membran (100) und dem Positionierelement (90, 91) auf oder außerhalb der Mantelfläche (510) liegen, welche durch die geometrische Extrusion der Berandung (47) des Objektivs (40) ausgebildet ist.

5. Vorrichtung (10) nach dem vorangehenden Anspruch, wobei die Membranhalterung (80) oder ein Teil des Objektivs (40) gleichzeitig als das Positionierelement (90, 91) ausgebildet ist.

6. Vorrichtung (10) nach einem der beiden vorangehenden Ansprüche, wobei das Positionierelement (90, 91) verbunden ist mit dem Objektivtisch (20) oder mit dem Objekttisch (51) oder mit dem Objektträger (50) oder mit dem weiteren Teil (16, 17) der optischen Bearbeitungs-Einheit (15).

7. Vorrichtung (10) nach einem der drei vorangehenden Ansprüche, wobei die Membranhalterung (80) und/oder das Positionierelement (90, 91) Befestigungselemente (185) umfasst, welche dazu eingerichtet ist, die Membran (100) in lateraler Richtung über Rollen und/oder Gleitflächen (85) zwischen dem Objektiv (40) und dem Objekt (60) zu bewegen.

8. Vorrichtung (10) nach einem der vorangehenden Ansprüche, wobei die Membran (100) oder die Membranhalterung (105) derart elastisch oder plastisch deformierbar ist, dass dadurch der Teilbereich (120) der Membran (100) beweglich in axialer Richtung ist.

9. Vorrichtung (10) nach einem der vorangehenden Ansprüche, wobei ein Arbeitsabstand *d* zwischen der Endfläche (46) des Objektivs (40) und einer Oberfläche des Objekts (60) von höchstens 5 mm eingerichtet ist.

10. Vorrichtung (10) nach einem der vorangehenden Ansprüche, wobei die Membran (100) das Immersionsmedium (160) und ein weiteres Immersionsmedium (170) voneinander trennt, wobei das weitere Immersionsmedium (170) bevorzugt zwischen der Membran (100) und dem Objektiv (40) eingebracht ist.

11. Vorrichtung (10) nach dem vorangehenden Anspruch, wobei sich ein Brechungsindex des weiteren Immersionsmediums (170) von dem Brechungsindex des Immersionsmediums (160) unterscheidet und/oder wobei sich eine Viskosität des weiteren Immersionsmediums (170) von der Viskosität des Immersionsmediums (160) unterscheidet.

12. Vorrichtung (10) nach einem der beiden vorangehenden Ansprüche, wobei das weitere Immersionsmedium (170) ein flüssiger Photoresist ist.

13. Vorrichtung (10) nach einem der vorangehenden Ansprüche, ferner umfassend mindestens einen Sensor zur Detektion einer Berührung oder einer Kollision von zwei Teilkomponenten der Vorrichtung (10).

14. Verfahren zur optischen Bearbeitung eines Objekts (60) mittels einer Vorrichtung (10) zur optischen Bearbeitung eines Objekts (60), umfassend die folgenden Schritte:
a) Positionieren mindestens eines Objekts (60) auf einem Objektträger (50);
b) Aufbringen eines Immersionsmediums (160) auf zumindest einen Teil des Objekts (60);
c) Annähern einer Membran (100) auf den mit dem Immersionsmedium (160) bedeckten Teil des Objekts (60), wobei die Membran (100) einen zur Durchdringung mit Licht (140) vorgesehenen transparenten Teilbereich (120) aufweist;
d) Positionieren eines Objektivs (40), welche eine optische Achse (502) festlegt, relativ zum mit dem Immersionsmedium (160) bedeckten Teil des Objekts (60);
e) Einstellen einer in Bezug auf die optische Achse (502) axialen Position für den Teilbereich (120) der Membran (100); und
f) Optische Bearbeitung des Objekts (60) mittels des Lichts (140)
**dadurch gekennzeichnet,**
**dass** das Immersionsmedium (160) in Form eines flüssigen Photoresists vorliegt.

15. Verfahren nach dem vorangehenden Anspruch, wobei eine axiale Positionierung des vom Licht (140) durchdrungenen Teilbereiches (120) der Membran (100) gemeinsam mit der Positionierung des Objektivs (40) in einer synchronisierten Bewegung erfolgt.

16. Verfahren nach einem der vorangehenden Verfahrensansprüche, wobei Lumineszenz-Strahlung erfasst wird, welche von dem Licht (140) in dem Immersionsmedium (160) angeregt wird, um eine axiale Position der Membran (100) einzustellen.

## Claims

1. Apparatus (10) for optically processing an object (60), comprising
- an object carrier (50) for receiving an object (60);
- an optical processing unit (15), comprising at least one device for producing or receiving light (140) and an objective (40) for exposing the object (60) by using the light (140) or for capturing the light (140) from the object (60), wherein the objective (40) has an end face (46) facing the object carrier (50), wherein the end face (46) has an edge (47), wherein the objective (40) further defines an optical axis (502);
- at least one membrane (100) introduced between the objective (40) and the object carrier (50), wherein the membrane (100) has a portion (120) configured for penetration by the light (140), wherein at least the portion (120) of the membrane (100) is movable in the axial direction with respect to the optical axis (502),
- at least one membrane holder (80) for holding the at least one membrane (100), and
- at least one immersion medium (160) which is at least introduced between the membrane (100) and the object carrier (50),
wherein the membrane (100) and the membrane holder (80) are fastened at a point outside of the objective, and the membrane (100) is arranged at the membrane holder (80) in such a manner that first contact points (81) between the membrane (100) and the membrane holder (80) are located on or outside a lateral surface (510) which is formed by a geometric extrusion of the edge (47) of the objective (40) parallel to the optical axis (502),
**characterized in**
**that** the immersion medium (160) is present in the form of a liquid photoresist.

2. Apparatus (10) according to the preceding claim, wherein the membrane holder (80) is connected to an objective stage (20) that is formed to receive the objective (40), or to an object stage (51) that is formed to receive the object carrier (50), or to the object carrier (50), or to a further part (16, 17) of the optical processing unit (15).

3. Apparatus (10) according to either one of the preceding claims, wherein the objective (40) is configured in an exchangeable manner such that the objective (40) is able to be exchanged while the membrane holder (80) and the membrane (100) remain at the apparatus (10).

4. Apparatus (10) according to any one of the preceding claims, further comprising at least one positioning element (90, 91), wherein the positioning element (90, 91) is configured to move the membrane (100) in the axial direction with respect to the optical axis (502), wherein the positioning element (90, 91) is preferably arranged in such a manner that second contact points (96) between the membrane (100) and the positioning element (90, 91) are located on or outside of the lateral surface (510) which is formed by the geometric extrusion of the edge (47) of the objective (40).

5. Apparatus (10) according to the preceding claim, wherein the membrane holder (80) or a part of the objective (40) is simultaneously embodied as the positioning element (90, 91).

6. Apparatus (10) according to either of the two preceding claims, wherein the positioning element (90, 91) is connected to the objective stage (20) or to the object stage (51) or to the object carrier (50) or to the further part (16, 17) of the optical processing unit (15).

7. Apparatus (10) according to any one of the three preceding claims, wherein the membrane holder (80) and/or the positioning element (90, 91) comprise(s) fastening elements (185) which are configured to move the membrane (100) in the lateral direction between the objective (40) and the object (60) by manner of rollers and/or sliding surfaces (85).

8. Apparatus (10) according to any one of the preceding claims, wherein the membrane (100) or the membrane holder (105) is elastically or plastically deformable in such a manner that, as a result, the portion (120) of the membrane (100) is movable in the axial direction.

9. Apparatus (10) according to any one of the preceding claims, wherein a working distance d of no more than 5 mm has been configured between the end face (46) of the objective (40) and a surface of the object (60).

10. Apparatus (10) according to any one of the preceding claims, wherein the membrane (100) separates the immersion medium (160) and a further immersion medium (170) from one another, wherein the further immersion medium (170) has preferably been introduced between the membrane (100) and the objective (40).

11. Apparatus (10) according to the preceding claim, wherein a refractive index of the further immersion medium (170) differs from the refractive index of the immersion medium (160) and/or wherein a viscosity of the further immersion medium (170) differs from the viscosity of the immersion medium (160).

12. Apparatus (10) according to either of the two preceding claims, wherein the further immersion medium (170) is a liquid photoresist.

13. Apparatus (10) according to any one of the preceding claims, further comprising at least one sensor for detecting contact or a collision between two subcomponents of the apparatus (10).

14. Method for optical processing of an object (60) by using an apparatus (10) for optically processing an object (60), comprising the following steps:
a) positioning at least one object (60) on an object carrier (50);
b) applying an immersion medium (160) to at least part of the object (60);
c) approaching a membrane (100) towards the part of the object (60) covered with the immersion medium (160), wherein the membrane (100) has a transparent portion (120) provided for light (140) to penetrate;
d) positioning an objective (40), which defines an optical axis (502), relative to the part of the object (60) covered by the immersion medium (160);
e) setting an axial position for the portion (120) of the membrane (100) with respect to the optical axis (502); and
f) optically processing the object (60) by using the light (140),
**characterized in**
**that** the immersion medium (160) is present in the form of a liquid photoresist.

15. Method according to the preceding claim, wherein axial positioning of the portion (120) of the membrane (100) penetrated by the light (140) is implemented together with the positioning of the objective (40) in a synchronized movement.

16. Method according to either of the preceding method claims, wherein luminescence radiation excited by the light (140) in the immersion medium (160) is captured in order to set an axial position of the membrane (100).

## Revendications

1. Arrangement (10) de traitement optique d'un objet (60), comprenant
- un porte-objet (50) destiné à accueillir un objet (60) ;
- une unité de traitement optique (15), comprenant au moins un dispositif servant à générer ou à recevoir de la lumière (140) et un objectif (40) destiné à exposer l'objet (60) au moyen de la lumière (140) ou à détecter la lumière (140) en provenance de l'objet (60), l'objectif (40) possédant une surface d'extrémité (46) qui fait face au porte-objet (50), la surface d'extrémité (46) disposant d'une bordure (47) et l'objectif (40) spécifiant en outre un axe optique (502) ;
- au moins une membrane (100) insérée entre l'objectif (40) et le porte-objet (50), la membrane (100) possédant une zone partielle (120) conçue pour être traversée par la lumière (140), au moins la zone partielle (120) de la membrane (100) étant mobile dans la direction axiale par rapport à l'axe optique (502),
- au moins une attache de membrane (80) destinée à maintenir ladite au moins une membrane (100), et
- au moins un milieu d'immersion (160), qui est introduit au moins entre la membrane (100) et le porte-objet (50),
dans lequel la membrane (100) et l'attache de membrane (80) sont fixées à un endroit situé à l'extérieur de l'objectif, et la membrane (100) est disposée sur l'attache de membrane (80) de telle sorte que des premiers points de contact (81) entre la membrane (100) et l'attache de membrane (80) se trouvent sur ou à l'extérieur d'une enveloppe (510) qui est formée par une extrusion géométrique de la bordure (47) de l'objectif (40) parallèlement à l'axe optique (502),
**caractérisé en ce que**
le milieu d'immersion (160) se présente sous la forme d'un photorésist liquide.

2. Arrangement (10) selon la revendication précédente, dans lequel l'attache de membrane (80) est reliée à une table d'objectif (20) conçue pour accueillir l'objectif (40) ou à une table d'objet (51) conçue pour accueillir le porte-objet (50) ou au porte-objet (50) ou à une autre partie (16, 17) de l'unité de traitement optique (15).

3. Arrangement (10) selon l'une des revendications précédentes, dans lequel l'objectif (40) est conçu de manière interchangeable de telle sorte qu'un remplacement de l'objectif (40) peut être réalisé, tandis que l'attache de membrane (80) et la membrane (100) restent sur l'arrangement (10).

4. Arrangement (10) selon l'une des revendications précédentes, comprenant en outre au moins un élément de positionnement (90, 91), l'élément de positionnement (90, 91) étant conçu pour déplacer la membrane (100) dans la direction axiale par rapport à l'axe optique (502), l'élément de positionnement (90, 91) étant de préférence disposé de telle sorte que des deuxièmes points de contact (96) entre la membrane (100) et l'élément de positionnement (90, 91) se trouvent sur ou à l'extérieur de l'enveloppe (510) qui est formée par l'extrusion géométrique de la bordure (47) de l'objectif (40).

5. Arrangement (10) selon la revendication précédente, dans lequel l'attache de membrane (80) ou une partie de l'objectif (40) est conçue simultanément comme étant l'élément de positionnement (90, 91).

6. Arrangement (10) selon l'une des deux revendications précédentes, dans lequel l'élément de positionnement (90, 91) est relié à la table d'objectif (20) ou à la table d'objet (51) ou au porte-objet (50) ou à l'autre partie (16, 17) de l'unité de traitement optique (15).

7. Arrangement (10) selon l'une des trois revendications précédentes, dans lequel l'attache de membrane (80) et/ou l'élément de positionnement (90, 91) comprennent des éléments de fixation (185) qui sont conçus pour déplacer la membrane (100) dans une direction latérale par l'intermédiaire de rouleaux et/ou de surfaces de coulissement (85) entre l'objectif (40) et l'objet (60).

8. Arrangement (10) selon l'une des revendications précédentes, dans lequel la membrane (100) ou l'attache de membrane (105) est déformable de manière élastique ou plastique de telle sorte que la zone partielle (120) de la membrane (100) est ainsi mobile dans la direction axiale.

9. Arrangement (10) selon l'une des revendications précédentes, dans lequel une distance de travail d entre la surface d'extrémité (46) de l'objectif (40) et une surface de l'objet (60) est conçue pour être d'au plus 5 mm.

10. Arrangement (10) selon l'une des revendications précédentes, dans lequel la membrane (100) sépare le milieu d'immersion (160) d'un autre milieu d'immersion (170), l'autre milieu d'immersion (170) étant de préférence introduit entre la membrane (100) et l'objectif (40).

11. Arrangement (10) selon la revendication précédente, dans lequel un indice de réfraction de l'autre milieu d'immersion (170) est différent de l'indice de réfraction du milieu d'immersion (160) et/ou une viscosité de l'autre milieu d'immersion (170) est différente de la viscosité du milieu d'immersion (160).

12. Arrangement (10) selon l'une des deux revendications précédentes, dans lequel l'autre milieu d'immersion (170) est un photorésist liquide.

13. Arrangement (10) selon l'une des revendications précédentes, comprenant en outre au moins un capteur pour la détection d'un contact ou d'une collision entre deux sous-composants de l'arrangement (10).

14. Procédé de traitement optique d'un objet (60) au moyen d'un arrangement (10) de traitement optique d'un objet (60), comprenant les étapes suivantes :
a) le positionnement d'au moins un objet (60) sur un porte-objet (50) ;
b) l'application d'un milieu d'immersion (160) sur au moins une partie de l'objet (60) ;
c) le rapprochement d'une membrane (100) de la partie de l'objet (60) recouverte du milieu d'immersion (160), la membrane (100) possédant une zone partielle transparente (120) prévue pour être traversée par de la lumière (140) ;
d) le positionnement d'un objectif (40) qui spécifie un axe optique (502) par rapport à la partie de l'objet (60) recouverte du milieu d'immersion (160) ;
e) le réglage d'une position axiale de la zone partielle (120) de la membrane (100) par rapport à l'axe optique (502) ; et
f) le traitement optique de l'objet (60) au moyen de la lumière (140)
**caractérisé en ce que**
le milieu d'immersion (160) se présente sous la forme d'un photorésist liquide.

15. Procédé selon la revendication précédente, dans lequel un positionnement axial de la zone partielle (120) de la membrane (100) traversée par la lumière (140) est effectué conjointement avec le positionnement de l'objectif (40) dans un mouvement synchronisé.

16. Procédé selon l'une des revendications de procédé précédentes, dans lequel un rayonnement de luminescence qui est excité par la lumière (140) dans le milieu d'immersion (160) est détecté pour régler une position axiale de la membrane (100).
